# EUROPEAN PATENT APPLICATION

(11) **EP 4 535 974 A1**
(43) Date of publication of application: **09.04.2025**
(21) Application number: 23812170.1
(22) Date of filing: 25.05.2023
(51) Int. Cl.: H10K 85/60, H10K 50/12

(54) **COMPOSITION FOR ORGANIC ELECTROLUMINESCENT ELEMENT AND ORGANIC ELECTROLUMINESCENT ELEMENT COMPRISING SAME**

(30) Priority: 27.05.2022 KR 20220065558
(71) Applicant: Solus Advanced Materials Co., Ltd., Iksan-si, Jeollabuk-do 54584 (KR)
(72) Inventor: JO, Hyunjong, Yongin-si, Gyeonggi-do 16858 (KR); PARK, Hocheol, Yongin-si, Gyeonggi-do 16858 (KR); KIM, Youngbae, Yongin-si, Gyeonggi-do 16858 (KR); JUNG, Hwasoon, Yongin-si, Gyeonggi-do 16858 (KR); SONG, Hyobum, Yongin-si, Gyeonggi-do 16858 (KR); KIM, Geunhyeong, Yongin-si, Gyeonggi-do 16858 (KR)
(74) Representative: Office Freylinger
(86) International application number: PCT/KR2023/007176
(87) International publication number: WO 2023/229396

(57) **Abstract**

The present invention relates to a composition for an organic electroluminescent element and an organic electroluminescent element comprising the same. The composition for an organic electroluminescent element comprises: a first host represented by chemical formula 1; and a second host represented by chemical formula 2, and the details of chemical formulae 1 and 2 are as defined in the specification.

## Description

### Technical Field

The present invention relates to a composition for an organic electroluminescent element and an organic electroluminescent element containing the same.

### Background Art

In an organic electroluminescent element (hereinafter, referred to as "organic EL element"), upon the application of voltage between two electrodes, holes from the anode and electrons from the cathode are injected into the organic material layer. The injected holes and electrons combine with each other to form excitons, and the excitons fall down to the ground state to emit light. Particularly, materials used for the organic layer may be classified into light emission materials, hole injection materials, hole transport materials, electron transport materials, electron injection materials, and the like according to the function thereof.

Materials for forming an emissive layer of the organic EL element may be classified into blue, green and red light emission materials according to the color of light emission. Besides, yellow and orange light emission materials may be used as light emission materials for displaying better natural colors. Additionally, host/dopant-based light emission materials may be used as light emission materials to increase color purity and improve light emission efficiency through energy transfer. Dopant materials may be classified into fluorescent dopants using organic materials and phosphorescent dopants using metal complex compounds containing heavy atoms, such as Ir and Pt. These phosphorescent materials can theoretically improve the light emission efficiency up to four times compared to fluorescent materials, so attention is focused on phosphorescent host materials as well as phosphorescent dopants.

To date, NPB, BCP, Alq₃, and the like have been widely known for use in a hole injection layer, a hole transport layer, an electron transport layer, and an electron injection layer, and as for light emission materials, anthracene derivatives have been reported as fluorescent dopant/host materials. Particularly, as for phosphorescent materials having a large advantage in terms of efficiency improvement among light emission materials, metal complex compounds containing Ir, such as Firpic, Ir(ppy)₃, and (acac)Ir(btp)₂, are used as blue, green, and red dopant materials. Until today, CBP shows excellent properties as a phosphorescent host material.

However, conventional organic layer materials have advantages in terms of light emission characteristics, but are not satisfactory in terms of lifespan of organic EL elements due to low glass transition temperatures and very poor thermal stability. Accordingly, there is a need to develop organic layer materials with excellent performance.

### Disclosure of Invention

### Technical Problem

An aspect of the present invention is to provide a composition capable of implementing an organic EL element with high efficiency and long lifespan.

Another aspect of the present invention is to provide an organic EL element that has a low driving voltage, a high luminous efficiency, and an improved lifespan by containing the above-described composition as an organic layer material (e.g., an emissive layer material).

### Solution to Problem

In accordance with an aspect of the present disclosure, there is provided a composition for an organic electroluminescent element, the composition containing a first host represented by Chemical Formula 1 below and a second host represented by Chemical Formula 2 below: 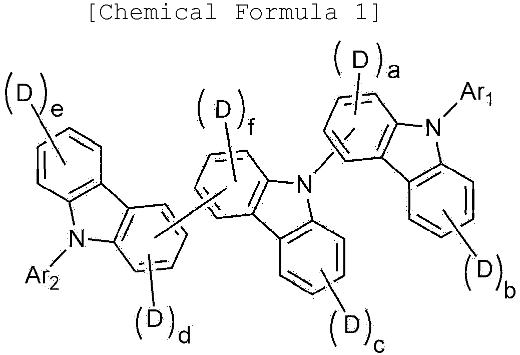 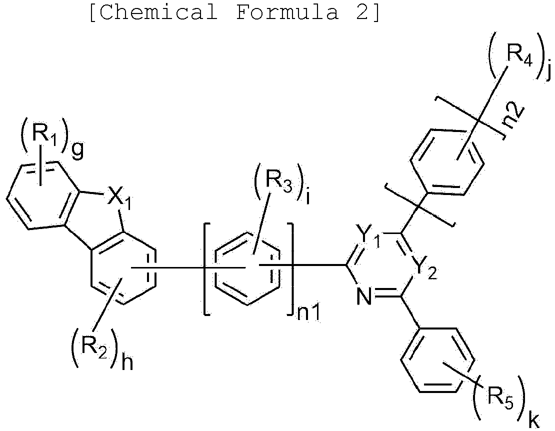 (where, in Chemical Formulas 1 and 2,
D is deuterium;
a, d, f, and h are each an integer of 0 to 3;
b, c, e, g, and i are each an integer of 0 to 4;
j and k are each an integer of 0 to 5;
n1 is an integer of 1 to 5;
n2 is an integer of 0 or 1;
X₁ is selected from the group consisting of O, S, Se, N(Ar₃), C(Ar₄)(Ar₅), and Si(Ar₆)(Ar₇);
Y₁ and Y₂ are the same or different from each other and are each independently N or C(Ar₈), provided that at least one of Y₁ and Y₂ is N;
Ar₁ to Ar₈ and R₁ to R₅ are the same or different from each other and are each independently selected from the group consisting of hydrogen, deuterium (D), a halogen group, a cyano group, a nitro group, an amino group, a C₁ to C₄₀ alkyl group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a phosphine oxide group, a C₁ to C₄₀ alkylphosphine oxide group, a C₆ to C₆₀ arylphosphine group, a C₆ to C₆₀ arylphosphine oxide group, and a C₆ to C₆₀ arylamine group, or these groups may form a condensed ring together with an adjacent group; and
the alkyl group, alkenyl group, alkynyl group, cycloalkyl group, heterocycloalkyl group, aryl group, heteroaryl group, alkyloxy group, aryloxy group, alkylsilyl group, arylsilyl group, alkylboron group, arylboron group, alkylphosphine oxide group, arylphosphine group, arylphosphine oxide group, arylamine group, and condensed ring of Ar₁ to Ar₈ and R₁ to R₅ are each independently substituted or unsubstituted with at least one substituent selected from the group consisting of deuterium, a halogen, a cyano group, a nitro group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₁ to C₄₀ alkyl group, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a C₆ to C₆₀ arylphosphine group, a C₆ to C₆₀ arylphosphine oxide group, and a C₆ to C₆₀ arylamine group, and when there are multiple substituents, the substituents are the same or different from each other).

In accordance with another aspect of the present disclosure, there is provided an organic electroluminescent element, including: an anode; a cathode; and one or more organic layers interposed between the anode and the cathode, wherein the one or more organic layers contains the above-described composition.

### Advantageous Effects of Invention

According to an embodiment of the present invention, an organic electroluminescent element capable of exhibiting excellent phosphorescent emissive properties as well as having low driving voltage, high efficiency, and long lifespan characteristics by using a compound having strong hole properties and a compound having strong electron properties in combination.

The advantageous effects according to the present invention are not limited by the contents exemplified above, and more various advantageous effects are included herein.

### Brief Description of Drawings

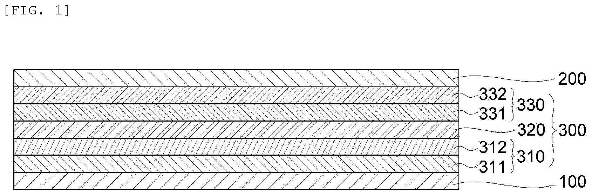

FIG. 1 is a cross-sectional view showing the structure of an organic EL element according to an embodiment of the present invention.

### <Explanation of reference numerals>

100: anode 200: cathode
300: organic layer 310: hole transport region
311: hole injection layer 312: hole transport layer
320: emissive layer 330: electron transport region
331: electron transport layer 332: electron injection layer

### Mode for Carrying out the Invention

The advantages and features of the present invention and methods of achieving the same will be apparent by referring to aspects of the present invention as described below in detail in conjunction with the accompanying drawings. However, the present invention is not limited to the embodiments described below, but may be implemented in various different forms. The following embodiments are provided to complete the present disclosure and to fully inform a person skilled in the art the scope of the present invention, and the present invention is defined by the category of the appended claims. Therefore, in some embodiments, well-known process steps, well-known element structures, and well-known techniques are not specifically described to avoid ambiguous interpretation of the present invention. Throughout the specification, the same or like reference numerals designate the same or like components.

Unless otherwise defined, all terms (including technical and scientific terms) used herein have the same meaning as commonly understood by one of ordinary skill in the art to which this inventive concept belongs. In addition, terms defined in a commonly used dictionary are not to be interpreted ideally or excessively unless clearly defined in particular.

Throughout this specification, when a part is said to "comprise", "include", or "contain" a certain component, it means that other components may be further included, rather than excluding other components, unless otherwise stated.

Throughout the specification, "on" or "above" means not only when it is located on or beneath a target part, but also includes the case where there is another part therebetween, and does not mean that it is located upwardly with respect to the direction of gravity.

In the present specification, terms such as "first" and "second" do not indicate any order or importance but are used to distinguish components from each other.

### <Composition for organic electroluminescent element>

A composition for an organic electroluminescent element according to an embodiment is a composition that forms an organic layer (e.g., an emissive layer) of the organic electroluminescent element and contains a first host represented by Chemical Formula 1 above and a second host represented by Chemical Formula 2 above. The first host is a compound having a structure where three carbazole moieties are directly linked without linkers, and the first host is a P-type host with relatively strong hole properties. The second host is a compound having a structure where a dibenzo moiety is linked to one phenyl portion of a 2,4,6-triphenyl-N-containing heterocyclic moiety, and the second host is an N-type host with relatively strong electron properties. The composition of the present invention can implement a high-efficiency, long-lifespan organic electroluminescent element by using the first host and the second host in combination.

In the first host represented by Chemical Formula 1, a, d, and f are each an integer of 0 to 3, and b, c, and e are each an integer of 0 to 4. Particularly, when a, b, c, d, e, and f are each 0, it means that hydrogen is not substituted with deuterium (D). Meanwhile, when a, d, and f are each an integer of 1 to 3 and when b, c, and e are each an integer of 1 to 4, it means that one or multiple hydrogens are substituted with deuterium (D). Particularly, 13≤a+b+c+d+e+f≤21 may be satisfied. According to one example, the number of deuterium (D) atoms included in the first host may be at least 13, specifically, at least 21. This first host can increase the stability of the chemical structure through deuterium (D) substitution, thereby achieving the characteristics of the organic electroluminescent element, for example, low voltage, high efficiency, and long lifespan characteristics of the element.

This deuterium may also be substituted with other substituents (R). Particularly, when there are multiple other substituents (R), the substituents are the same or different from each other. The other substituents (R) may be selected from the group consisting of a halogen group, a cyano group, a nitro group, an amino group, a C₁ to C₄₀ alkyl group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a phosphine oxide group, a C₁ to C₄₀ alkylphosphine oxide group, a C₆ to C₆₀ arylphosphine group, a C₆ to C₆₀ arylphosphine oxide group, and a C₆ to C₆₀ arylamine group.

In the first host represented by Chemical Formula 1, Ar₁ and Ar₂ may be the same or different from each other and may be each independently selected from the group consisting of hydrogen, deuterium (D), a halogen group, a cyano group, a nitro group, an amino group, a C₁ to C₄₀ alkyl group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a phosphine oxide group, a C₁ to C₄₀ alkylphosphine oxide group, a C₆ to C₆₀ arylphosphine group, a C₆ to C₆₀ arylphosphine oxide group, and a C₆ to C₆₀ arylamine group, or these groups may form a condensed ring together with an adjacent group. Specifically, Ar₁ and Ar₂ may be the same or different from each other and may be each independently selected from the group consisting of a C₆ to C₆₀ aryl group and a heteroaryl group having 5 to 60 nuclear atoms.

According to an example, Ar₁ and Ar₂ may be the same or different from each other and may be each independently selected from the group consisting of substituents S1 to S4.

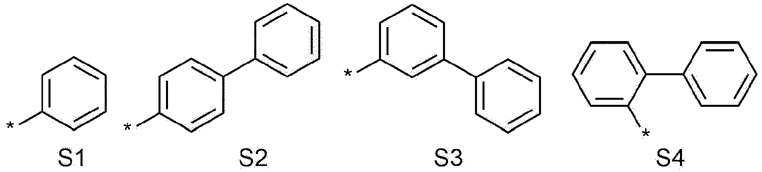

In Substituents S1 to S4, the mark * is a site linked to Chemical Formula 1.

According to such Ar₁ and Ar₂, the first host represented by Chemical Formula 1 may be a compound represented by Chemical Formula 3, but is not limited thereto. 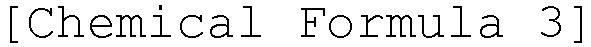 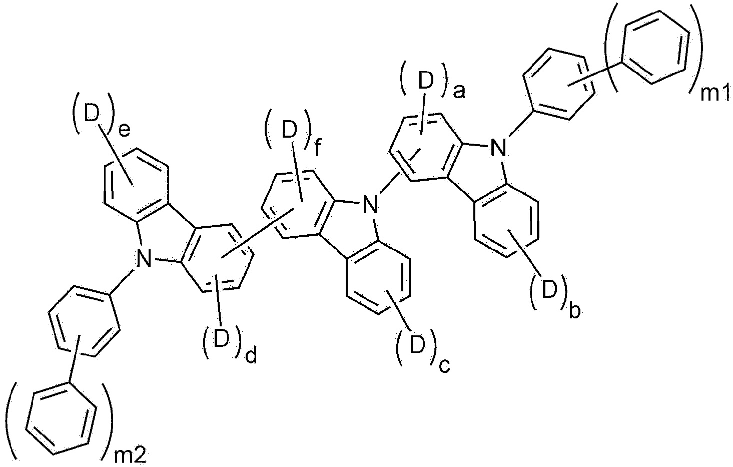 wherein, in chemical formula 3,
a, b, c, d, e, and f are each as defined in Chemical Formula 1; and
m1 and m2 are each 0 or 1.

Alternatively, the first host represented by Chemical Formula 1 may have various structures depending on the linkage site between each carbazole moiety. According to an example, the first host represented by Chemical Formula 1 may be a compound represented by Chemical Formula 4. 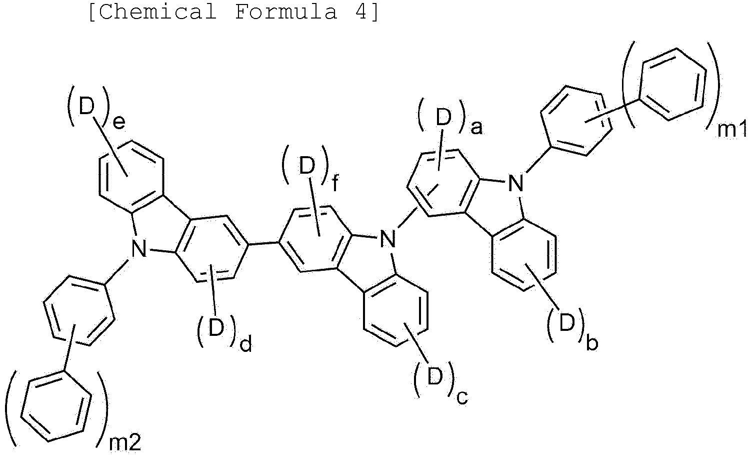 wherein, in chemical formula 4,
a, b, c, d, e, and f are each as defined in Chemical Formula 1; and
m1 and m2 are each 0 or 1.

Specifically, the first host represented by Chemical Formula 1 may be a compound represented by Chemical Formula 5. 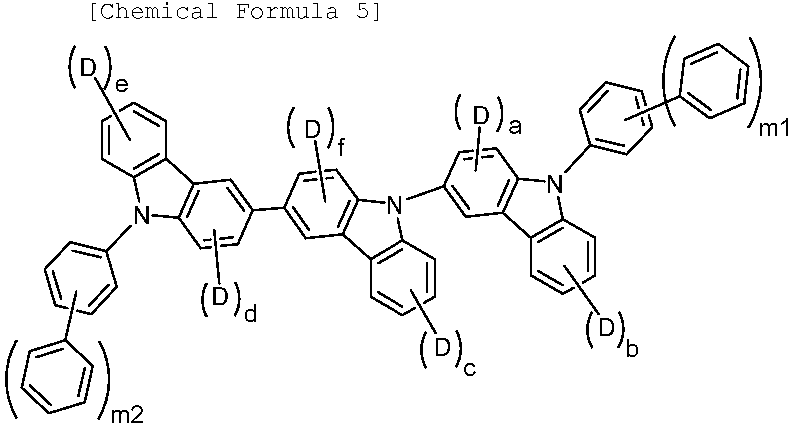 wherein, in chemical formula 5,
a, b, c, d, e, and f are each as defined in Chemical Formula 1; and
m1 and m2 are each 0 or 1.

The first host represented by Chemical Formula 1 according to the present invention described above may be further specified as the exemplary compounds below, for example, Compounds A-1 to D-4, but is not limited thereto.

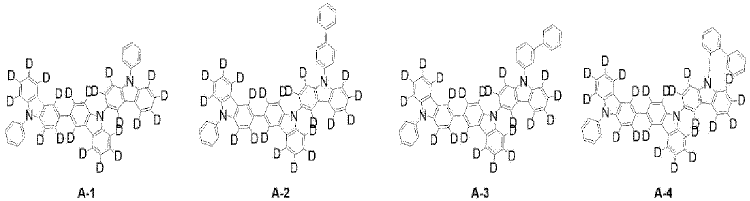

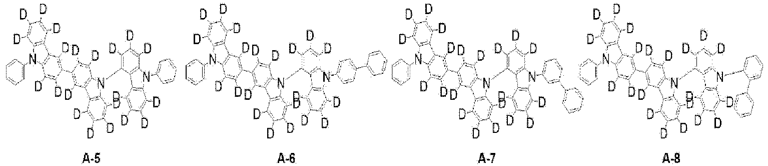

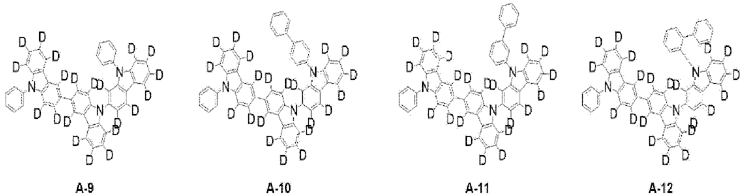

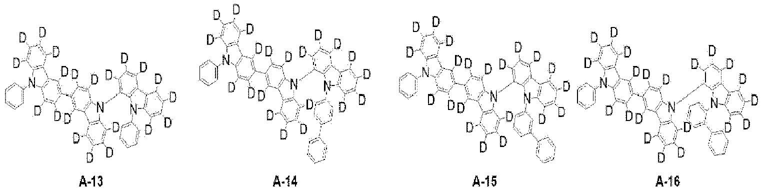

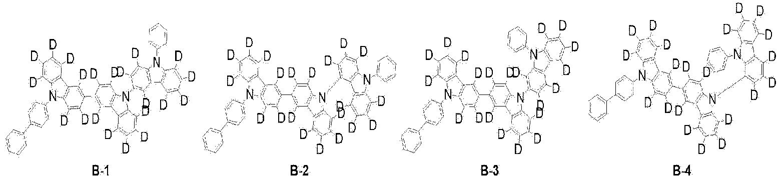

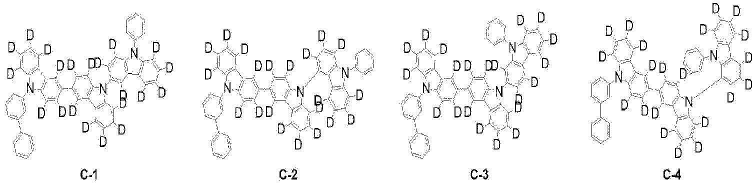

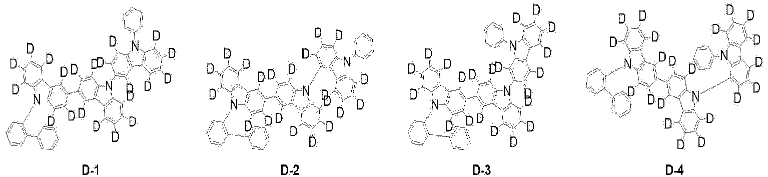

In the second host represented by Chemical Formula 2, Y₁ and Y₂ are the same or different from each other and are each independently N or C(Ar₈), provided that at least one of Y₁ and Y₂ is N.

According to such Y₁ and Y₂, in the second host represented by Chemical Formula 2, the 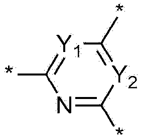 moiety may be selected from the group consisting of Moieties Mo-1 to Mo-3 below: 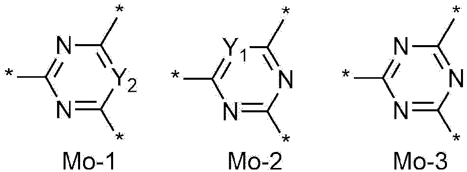 wherein, in Moieties Mo-1 to Mo-3;
the mark * is a site linked to Chemical Formula 2;
Y₁ and Y₂ are each independently C(Ar₈); and
Ar₈ is as defined in Chemical Formula 2 above.

In the second host represented by Chemical Formula 2, n1 is an integer of 1 to 5, and n2 is 0 or 1. According to an example, n1 may be 1 or 2, and n2 may be 0 or 1. However, in Chemical Formula 2, j is 1 when n2 is 0.

In the second host represented by Chemical Formula 2, X₁ is selected from the group consisting of O, S, Se, N(Ar₃), C(Ar₄)(Ar₅), and Si(Ar₆)(Ar₇). According to such X₁, the dibenzo moiety may be a monovalent dibenzofuran group, a monovalent dibenzothiophene group, a monovalent fluorene group, or the like.

Ar₃ and Ar₈ may be the same or different from each other and may be each independently selected from the group consisting of hydrogen, deuterium (D), a halogen group, a cyano group, a nitro group, an amino group, a C₁ to C₄₀ alkyl group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a phosphine oxide group, a C₁ to C₄₀ alkylphosphine oxide group, a C₆ to C₆₀ arylphosphine group, a C₆ to C₆₀ arylphosphine oxide group, and a C₆ to C₆₀ arylamine group, or these groups may form a condensed ring together with an adjacent group (e.g., Ar₃-R₁, Ar₃-R₂, Ar₄-Ar₅, Ar₆-Ar₇, Ar₄-R₁, Ar₄-R₂, Ar₆-R₁, Ar₆-R₂, and the like). Specifically, Ar₃ to Ar₈ may be the same or different from each other and may be each independently selected from the group consisting of a C₁ to C₄₀ alkyl group, a C₆ to C₆₀ aryl group, and a heteroaryl group having 5 to 60 nuclear atoms, or these groups may form a condensed ring together with an adjacent group (e.g., Ar₃-R₁, Ar₃-R₂, Ar₄-Ar₅, Ar₆-Ar₇, Ar₄-R₁, Ar₄-R₂, Ar₆-R₁, Ar₆-R₂, and the like). Particularly, the condensed ring may be at least one selected from the group consisting of a C₃ to C₆₀ condensed aliphatic ring (specifically, a C₃ to C₃₀ condensed aliphatic ring), a C₆ to C₆₀ condensed aromatic ring (specifically, a C₆ to C₃₀ condensed aromatic ring), a 5- to 60-membered condensed heteroaromatic ring (specifically, a 5- to 30-membered condensed heteroaromatic ring), and a C₃ to C₆₀ spiro ring, and a combination thereof.

According to an example, in Chemical Formula 2, the 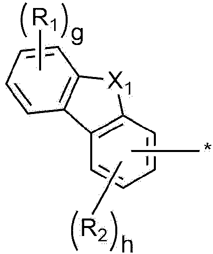 moiety may be selected from the group consisting of Moieties Dz-1 to Dz-32 below, but is not limited thereto.

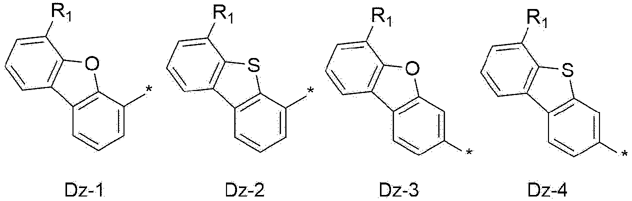

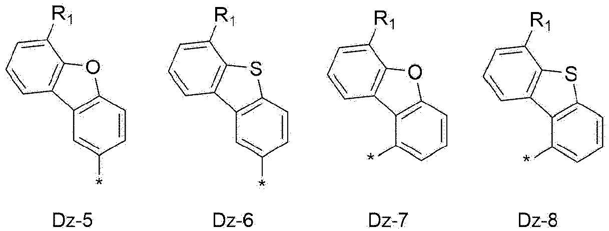

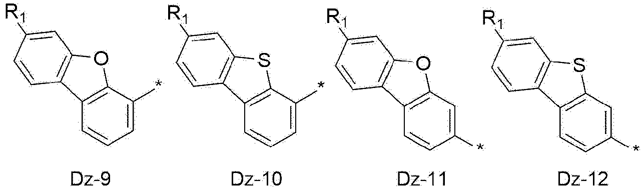

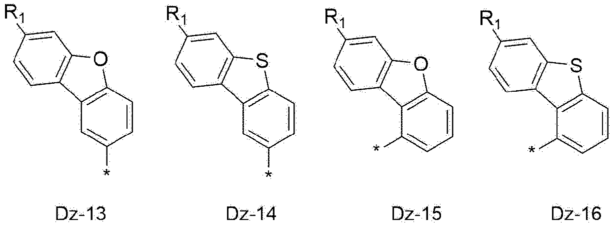

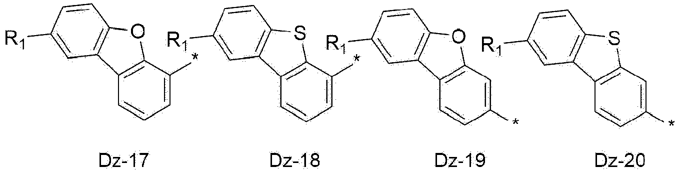

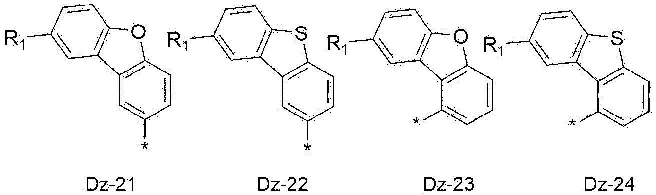

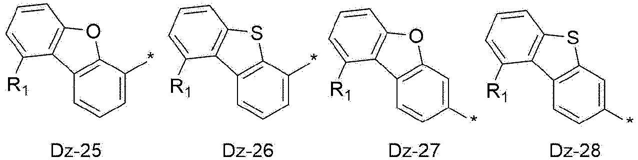

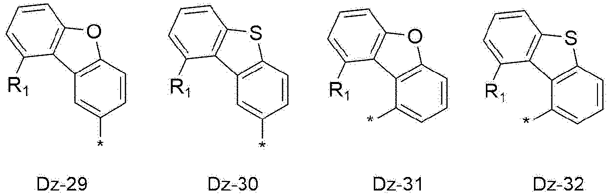

In Moieties Dz-1 to Dz-32,
the mark * is a site linked to Chemical Formula 2; and
R₁ may be a C₆ to C₆₀ aryl group, specifically a phenyl group.

In the second host represented by Chemical Formula 2, h is an integer of 0 to 3, g and i are each an integer of 0 to 4, and j and k are each an integer of 0 to 5. Particularly, when g, h, i, j, and k are each 0, it means that hydrogen is not substituted with substituents R₁ to R₅. Meanwhile, when h is an integer of 1 to 3, g and i are each an integer of 1 to 4, and j and k are each an integer of 1 to 5, one or more instances of R₁ to R₅ may be the same or different from each other and may be each independently selected from the group consisting of hydrogen, deuterium (D), a halogen group, a cyano group, a nitro group, an amino group, a C₁ to C₄₀ alkyl group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a phosphine oxide group, a C₁ to C₄₀ alkylphosphine oxide group, a C₆ to C₆₀ arylphosphine group, a C₆ to C₆₀ arylphosphine oxide group, and a C₆ to C₆₀ arylamine group, or these groups may form a condensed ring together with an adjacent group. Specifically, one or more instances of R₁ to R₅ may be the same or different from each other, and may be each independently selected from the group consisting of hydrogen, a halogen group, a cyano group, a nitro group, an amino group, a C₁ to C₄₀ alkyl group, a C₆ to C₆₀ aryl group, and a heteroaryl group having 5 to 60 nuclear atoms.

The above-described alkyl group, alkenyl group, alkynyl group, cycloalkyl group, heterocycloalkyl group, aryl group, heteroaryl group, alkyloxy group, aryloxy group, alkylsilyl group, arylsilyl group, alkylboron group, arylboron group, arylphosphine oxide group, arylphosphine group, arylphosphine oxide group, arylamine group, and condensed ring of Ar₃ to Ar₈ and R₁ to R₅ are each independently substituted or unsubstituted with at least one substituent selected from the group consisting of deuterium, a halogen, a cyano group, a nitro group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₁ to C₄₀ alkyl group, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a C₆ to C₆₀ arylphosphine group, a C₆ to C₆₀ arylphosphine oxide group, and a C₆ to C₆₀ arylamine group. Particularly, when there are multiple substituents, the substituents are the same or different from each other.

The second host represented by Chemical Formula 2 may be a compound represented by Chemical Formula 6, but is not limited thereto. 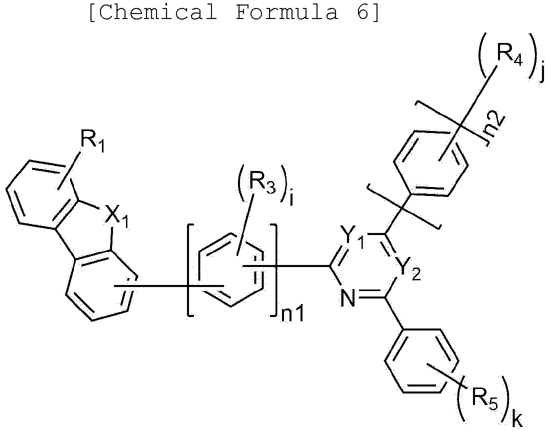 wherein, in chemical formula 6,
i, j, k, R₁, R₃ to R₅, n₁, n₂, X₁, Y₁, and Y₂ are each as defined in Chemical Formula 2 above.

Specifically, the second host represented by Chemical Formula 2 may be a compound represented by Chemical Formula 7 or 8, but is not limited thereto. 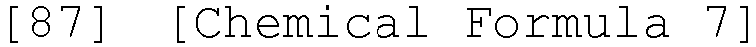 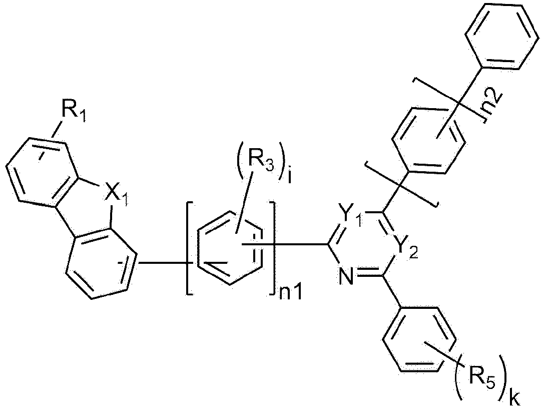 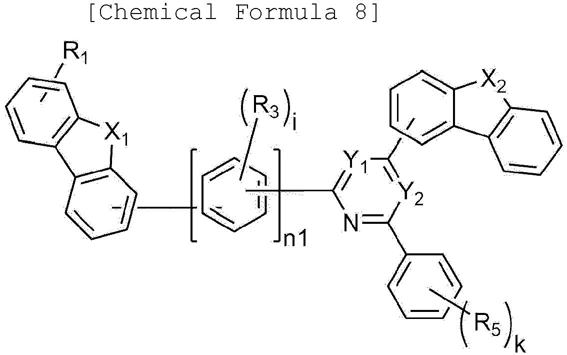 where, in Chemical Formulas 7 and 8,
i, k, R₁, R₃, R₅, n1, n2, Y₁, and Y₂ are each independently as defined in Chemical Formula 2 above, and
X₁ and X₂ are each O or S, and specifically O.

More specifically, the second host represented by Chemical Formula 2 may be a compound represented by Chemical Formula 9 or 10, but is not limited thereto. 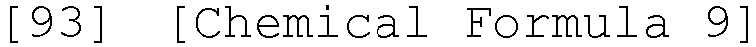 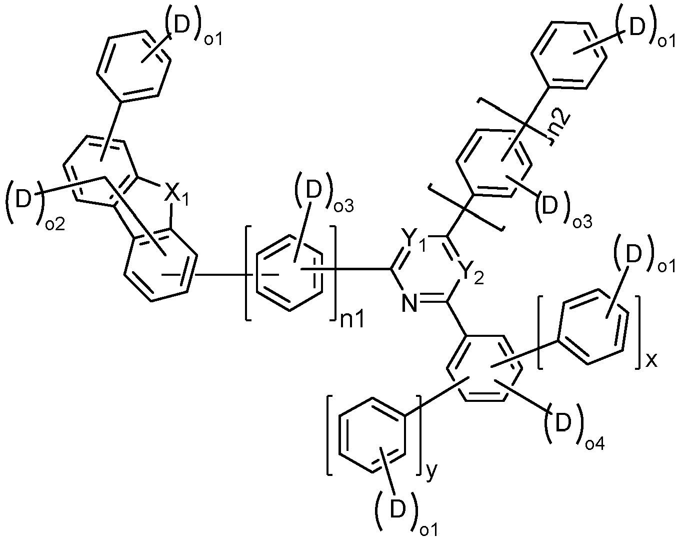 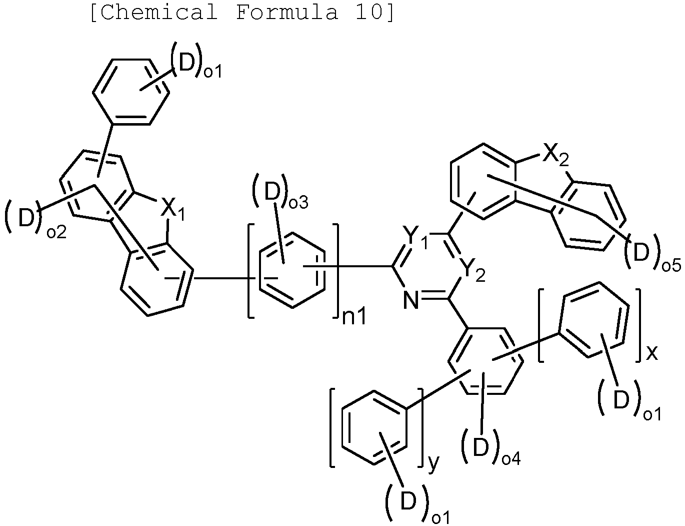 where, in Chemical Formulas 9 and 10,
n1, n2, Y₁, and Y₂ are each as defined in Chemical Formula 2, and specifically, n1 may be 1 or 2, n2 may be 0 or 1, and both Y₁ and Y₂ may be N;
x and y are each 0 or 1;
X₁ and X₂ are each O or S, and specifically O;
D is deuterium;
o1 is an integer of 0 to 5;
o2 is an integer of 0 to 6;
o3 is an integer of 0 to 4;
o4 is an integer of 0 to 3; and
o5 is an integer of 0 to 7.

The second host represented by Chemical Formula 2 according to the present invention described above may be further specified as the exemplary compounds below, for example, Compounds E-1 to E-13, but is not limited thereto.

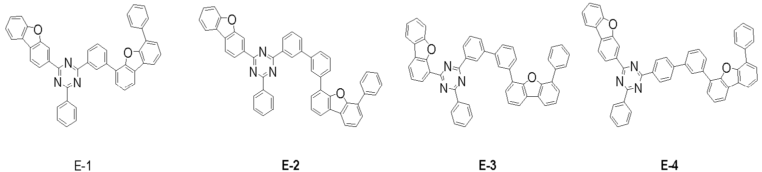

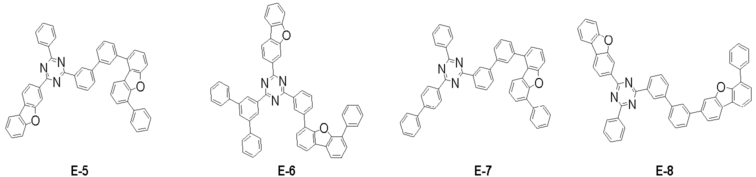

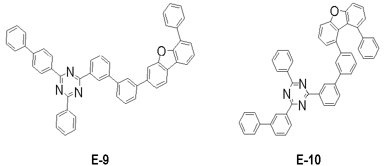

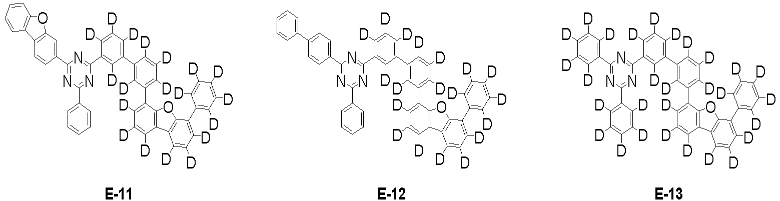

As used herein, the term "alkyl" refers to a monovalent substituent derived from a linear or branched, saturated hydrocarbon having 1 to 40 carbon atoms. Examples thereof may include methyl, ethyl, propyl, isobutyl, sec-butyl, pentyl, iso-amyl, hexyl, and the like, but are not limited thereto.

As used herein, the term "alkenyl" refers to a monovalent substituent derived from a linear or branched, unsaturated hydrocarbon having 2 to 40 carbon atoms having one or more carbon-carbon double bonds. Examples thereof may include vinyl, allyl, isopropenyl, 2-butenyl, and the like, but are not limited thereto.

As used herein, the term "alkynyl" refers to a monovalent substituent derived from a linear or branched, unsaturated hydrocarbon having 2 to 40 carbon atoms with one or more carbon-carbon triple bonds. Examples thereof may include ethynyl, 2-propynyl, and the like, but are not limited thereto.

As used herein, the term "cycloalkyl" refers to a monovalent substituent derived from a monocyclic or polycyclic non-aromatic hydrocarbon having 3 to 40 carbon atoms. Examples of the cycloalkyl may include cyclopropyl, cyclopentyl, cyclohexyl, norbornyl, adamantine, and the like, but are not limited thereto.

As used herein, the term "heterocycloalkyl" refers to a monovalent substituent derived from a non-aromatic hydrocarbon having 3 to 40 nuclear atoms, of which one or more carbon atoms on the ring, preferably 1 to 3 carbon atoms, are substituted with a heteroatom, such as N, O, S, or Se. Examples of the heterocycloalkyl may include morpholine, piperazine, and the like, but are not limited thereto.

As used herein, the term "aryl" refers to a monovalent substituent derived from an aromatic hydrocarbon having 6 to 60 carbon atoms, in which a single ring or two or more rings are combined. Additionally, the aryl may also include a form in which two or more rings are simply pendant to each other or fused to each other. Examples of the aryl may include phenyl, naphthyl, phenanthryl, anthryl, and the like, but are not limited thereto.

As used herein, the term "heteroaryl" refers to a monovalent substituent derived from a monoheterocyclic or polyheterocyclic aromatic hydrocarbon having 5 to 60 nuclear atoms. Particularly, at least one carbon, preferably one to three carbon atoms on the ring are substituted with a heteroatom, such as N, O, S, or Se. In addition, the heteroaryl may include a form in which two or more rings may be simply pendant to each other or condensed to each other, and may furthermore include a form of being condensed with an aryl group. Examples of the heteroaryl may include: a 6-membered monocyclic ring, such as pyridyl, pyrazinyl, pyrimidinyl, pyridazinyl, and triazinyl; a polycyclic ring, such as phenoxathienyl, indolizinyl, indolyl, purinyl, quinolyl, benzothiazole, and carbazolyl; and 2-furanyl, N-imidazolyl, 2-isoxazolyl, 2-pyridinyl, 2-pyrimidinyl, and the like, but are not limited thereto.

As used herein, the "alkyloxy" refers to a monovalent substituent represented by R'O-, wherein R' means alkyl having 1 to 40 carbon atoms, and may include a linear, branched, or cyclic structure. Examples of the alkyloxy may include methoxy, ethoxy, n-propoxy, 1-propoxy, t-butoxy, n-butoxy, pentoxy, and the like, but are not limited thereto.

As used herein, the term "aryloxy" refers to a monovalent substituent represented by RO-, wherein R is aryl having 5 to 40 carbon atoms. Examples of the aryloxy may include phenyloxy, naphthyloxy, diphenyloxy, and the like, but are not limited thereto.

As used herein, the term "alkylsilyl" refers to a silyl substituted with alkyl having 1 to 40 carbon atoms, and examples thereof may include mono-, di-, and trialkylsilyl. As used herein, the term "arylsilyl" refers to a silyl substituted with aryl having 5 to 60 carbon atoms, and examples thereof may include mono-arylsilyl and polyarylsilyl, such as di- and tri-arylsilyl.

As used herein, the term "alkylboron group" refers to a boron group substituted with alkyl having 1 to 40 carbon atoms, and the term "arylboron group" refers to a boron group substituted with aryl having 6 to 60 carbon atoms.

As used herein, the term "alkylphosphinyl group" refers to a phosphine group substituted with alkyl having 1 to 40 carbon atoms, and examples thereof may include mono- and di-alkylphosphinyl. As used herein, the term "arylphosphinyl group" refers to a phosphine group substituted with monoaryl or diaryl having 6 to 60 carbon atoms, and examples thereof may include mono- and di-arylphosphinyl group.

As used herein, the term "arylamine" refers to an amine substituted with aryl having 6 to 60 carbon atoms, and examples thereof may include mono-and di-arylamine.

As used herein, the term "heteroarylamine" refers to an amine substituted with heteroaryl having 5 to 60 nuclear atoms, and examples thereof may include mono-and di-heteroarylamine.

As used herein, the (aryl) (heteroaryl)amine refers to an amine substituted with aryl having 6 to 60 carbon atoms or heteroaryl having 5 to 60 nuclear atoms.

As used herein, the term "condensed ring" refers to a condensed aliphatic ring having 3 to 40 carbon atoms, a condensed aromatic ring having 6 to 60 carbon atoms, a condensed heteroaliphatic ring having 3 to 60 nuclear atoms, a condensed heteroaromatic ring having 5 to 60 nuclear atoms, a spiro ring having 3 to 60 carbon atoms, or a combination thereof.

The above-described first host and second host may be contained at a weight ratio of 99:1 to 1:99. In such a case, the bipolar characteristics can be more effectively implemented to improve both the efficiency and lifespan.

The composition of the present invention may further contain a phosphorescent emissive dopant. The phosphorescent emissive dopant is a substance that is mixed at a trace amount into the first and second hosts to induce light emission, and is not particularly limited as long as it is well-known in the art. Non-limiting examples thereof include a metal complex compound containing iridium (Ir) or platinum (Pt). Such a dopant may induce light emission by multiple excitation into a triplet or more.

The dopants may be classified into red, green, and blue dopants, and red, green, and blue dopants commonly known in the art may be used without particular limitation.

Specifically, non-limiting examples of the red dopant may include Pt(II) octaethylporphine (PtOEP), tris(2-phenylisoquinoline)iridium (Ir(piq)3), bis(2-(2'-benzothienyl)-pyridinato-N,C3')iridium(acetylacetonate) (Btp2Ir(acac), or a mixture of two or more thereof.

Non-limiting examples of the green dopant may include tris(2-phenylpyridine) iridium (Ir(ppy)₃), bis(2-phenylpyridine) (acetylacetonato)iridium(III) (Ir(ppy)₂(acac)), tris(2-(4-tolyl)phenylpyridine)iridium (Ir(mppy)₃), or a mixture of two or more thereof.

Non-limiting examples of the blue dopant may include bis[3,5-difluoro-2-(2-pyridyl)phenyl] (picolinato)iridium(III) (F2Irpic), (F₂ppy)₂Ir(tmd), Ir(dfppz)₃, or a mixture of two or more thereof.

The contents of the above-described dopants are not particularly limited, and may be, for example, about 0 to 10 wt%, specifically, about 0.1 to 10 wt%, and more specifically, about 1 to 30 wt%, relative to the total amount of the above-described composition.

### <organic electroluminescent element>

An organic electroluminescent element according to an embodiment of the present invention includes an anode, a cathode, and one or more organic layers interposed between the anode and the cathode, wherein the one or more organic layers contain the above-described composition. According to an example, the one or more organic layers include an emissive layer, and the composition may be contained as a host of the emissive layer. Therefore, the organic electroluminescent element of the present invention can exhibit excellent phosphorescent emissive properties while having low driving voltage, high efficiency, and long lifespan characteristics.

Hereinafter, preferable embodiments of the organic electroluminescent element according to the present invention are described with reference to the accompanying drawings. However, the embodiments of the present invention may be modified in many different forms, and the scope of the present invention is not limited to the embodiments described below. To avoid overlapping description, the description of the components in the above-described composition for an organic electroluminescent element is omitted.

FIG. 1 is a cross-sectional view schematically showing the structure of an organic electroluminescent element according to an embodiment of the present invention.

Referring to FIG. 1, an organic electroluminescent element according to an embodiment of the present invention may include: an anode 100 disposed on a substrate (not shown); a cathode 200 disposed to face the anode; one or more organic layers 300 between the anode 100 and the cathode 200, wherein the one or more organic layers 300 may include a hole transport region 310, an emissive layer 320, and an electron transport region 330. The emissive layer 320 may contain the above-described composition as a host. Optionally, the organic electroluminescent element of the present invention may further include a capping layer (not shown) disposed on the cathode 200.

Hereinafter, each of the components of the organic electroluminescent element according to the present invention will be described in detail.

### (1) Anode

In the organic electroluminescent element of the present invention, the anode 100 may be mainly disposed on the substrate, and electrically connected to a driving thin film transistor to receive a driving current from the driving thin film transistor. Since the anode 100 is formed of a material having a relatively high work function, holes are injected into an organic layer 300, that is, the hole transport region 310 (e.g., a hole injection layer 311).

A material for forming the anode is not particularly limited, and a commonly used material known in the art may be used. Examples of the anode material include: a metal, such as vanadium, chromium, copper, zinc, or gold; an alloy thereof; a metal oxide, such as zinc oxide, indium oxide, indium tin oxide (ITO), or indium zinc oxide (IZO); a combination of a metal and an oxide, such as ZnO:Al or SnO₂:Sb; a conductive polymer, such as polythiophene, poly(3-methylthiophene), poly[3,4-(ethylene-1,2-dioxy)thiophene] (PEDT), polypyrrole, or polyaniline; and carbon black, but are not limited thereto.

A method of forming the anode is not particularly limited, and may be formed through a commonly used method known in the art. For example, the anode may be formed by coating the anode material on the substrate through a known thin film forming method, such as sputtering, ion plating, vacuum deposition, or spin coating.

The substrate may be a plate-shaped member for supporting the organic electroluminescent element, and examples thereof may include a silicon wafer, quartz, a glass plate, a metal plate, a plastic film, a sheet, and the like, but embodiments are not limited thereto.

### (2) Cathode

In the organic electroluminescent element of the present invention, the cathode 200 is disposed to face the anode and, specifically, disposed on the electron transport region 330. Since the cathode 200 is formed of a material having a relatively low work function, electrons are injected to an adjacent organic layer, that is, the electron transport region 330 (e.g., an electron injection layer 332).

A material for forming the cathode is not particularly limited, and a commonly used one known in the art may be used. Examples of the cathode material may include a metal, such as magnesium, calcium, sodium, potassium, titanium, indium, yttrium, lithium, gadolinium, aluminum, silver (Ag), tin, or lead; an alloy thereof; and a multilayer structure material, such as LiF/Al or LiO₂/Al, but are not limited thereto.

A method of forming the cathode is not particularly limited, and similar to the anode, the cathode may be formed through a commonly used method known in the art. For example, the cathode may be formed by coating the cathode material on the one or more organic layers 300, specifically, the electron transport region, for example, the electron injection layer 332, through the above-described thin film forming method.

### (3) organic layers

In the organic electroluminescent element of the present invention, the one or more organic layers 300 are disposed between the anode 100 and the cathode 200, and include the hole transport region 310, the emissive layer 320, and the electron transport region 330.

According to an example, as shown in FIG. 1, the one or more organic layers 300 may include the hole injection layer 311, the hole transport layer 312, the emissive layer 320, the electron transport layer 331, and the electron injection layer 332, which are sequentially disposed on the anode 100.

Hereinafter, each of the organic layers will be described in detail.

### 1) Hole transport region

In the organic electroluminescent element 100 of the present invention, the hole transport region 310 is a portion of the organic layers 300 disposed on the anode 100 and serves to transport the holes, injected from the anode 100, to the adjacent emissive layer 320.

The hole transport region 310 may include at least one selected from the group consisting of the hole injection layer 311 and the hole transport layer 312. Particularly, considering the characteristics of the organic electroluminescent element, both the hole injection layer (311) and the hole transport layer (312) described above are preferably included. For example, as shown in FIG. 1, the hole transport region 310 may include the hole injection layer 311 and the hole transport layer 312 sequentially stacked on the anode 100.

A material for forming the hole injection layer 311 and the hole transport layer 312 of the present invention is not particularly limited as long as it has a low hole injection barrier and a high hole mobility, and the materials for the hole injection/transport layers used in the art may be used without limitation. In such a case, the respective materials for forming the hole injection layer 311 and the hole transport layer 312 may be the same or different from each other.

Specifically, the hole injection layer 311 may contain a hole injection material known in the art. Non-limiting examples of the hole injection material may include a phthalocyanine compound, such as copper phthalocyanine, N,N'-diphenyl-N,N'-bis-[4-(phenyl-m-tolyl-amino)-phenyl]-biphenyl-4,4'-diamine (DNTPD), 4,4',4"-tris(3-methylphenylphenylamino)triphenylamine (m-MTDATA), 4,4'4"-Tris(N,N-diphenylamino)triphenylamine (TDATA), 4,4',4"-tris{N-(2-naphthyl)-N-phenylamino}-triphenylamine (2TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), and the like, which may be used alone or in combination of two or more thereof.

The hole transport layer 312 contains a hole transport material known in the art. Non-limiting examples of the hole transport material may include carbazole-based derivatives, such as N-phenylcarbazole and polyvinylcarbazole; fluorene-based derivatives; amine-based derivatives; triphenylamine-based derivatives, such as N,N'-bis(3-methylphenyl)-N,N'-diphenyl-[1,1-biphenyl]-4,4'-diamine (TPD) and 4,4',4"-tris(N-carbazolyl)triphenylamine (TCTA); N,N'-di(1-naphthyl)-N,N'-diphenylbenzidine (NPB), 4,4'-cyclohexylidene bis[N,N-bis(4-methylphenyl)benzenamine] (TAPC), and the like, which may be used alone or in combination of two or more thereof.

The hole transport region 310 may be formed through a commonly used method known in the art. Examples thereof include vacuum deposition, spin coating, casting, Langmuir-Blodgett (LB) method, inkjet printing, laser printing, laser induced thermal imaging (LITI), and the like, but are not limited thereto.

### 2) Emissive layer

In the organic electroluminescent element of the present invention, the emissive layer 320 is a portion of the organic layers 300 interposed between the anode 100 and the cathode 200, and specifically disposed on the hole transport region 320. As shown in FIG. 1, the emissive layer 320 may be disposed on the hole transport layer 312.

The emissive layer 320 is a layer where holes and electrons injected from the anode and the cathode, respectively, are combined to form excitons, and the color of light emitted by the organic electroluminescent element may vary depending on the material forming the emissive layer 320.

The emissive layer 320 according to the present invention contains the above-described composition containing the first host represented by Chemical Formula 1 and the second host represented by Chemical Formula 2. Optionally, the composition may further contain a phosphorescent emissive dopant. The organic electroluminescent element of the present invention can exhibit excellent phosphorescent emissive properties while having low driving voltage, high efficiency, and long lifespan characteristics, by containing the above-described composition as a material for the emissive layer 320.

The emissive layer 320 according to the present invention may be a red emissive layer containing a red phosphorescent material, a green emissive layer containing a green phosphorescent material, or a blue emissive layer containing a blue phosphorescent material. According to an example, the emissive layer may contain a green phosphorescent material.

The above-described emissive layer 320 may be formed as a single layer composed of one type of material, a single layer composed of multiple different materials, or multiple layers of two or more layers, which are composed of different materials. Particularly, when there are multiple emissive layers (320), the organic electroluminescent element can exhibit light of various colors. Specifically, the present invention can provide an organic electroluminescent element exhibiting a mixed color by including multiple emissive layers composed of different types of materials in series. In addition, when the organic electroluminescent element includes multiple emissive layers, the driving voltage of the element may increase but the current value in the organic electroluminescent element becomes constant, and thus can provide an organic electroluminescent element with improved luminous efficiency by the number of emissive layers.

Although not shown in the drawing, the organic electroluminescent element of the present invention may include multiple emissive stacks (not shown) including at least one emissive layer.

The multiple emissive layers included in the emissive stacks may exhibit lights of different colors, respectively, or exhibit light of the same color. That is, the color of light emission may vary depending on the material constituting the emissive layer. For example, multiple emissive stacks may contain materials emitting the lights of blue, green, red, yellow, white, and the like, and may be formed using phosphorescent or fluorescent materials. Particularly, the colors exhibited by the respective emissive layers may be in a complementary relationship with each other. Additionally, the color may be selected as a combination of colors that can emit white light. The respective emissive layers may contain phosphorescent dopants or fluorescent dopants corresponding to the selected colors.

Although not shown in the drawing, the organic electroluminescent element of the present invention may further include a charge generation layer (CGL) (not shown) disposed between adjacent stacks among the multiple emissive layers to connect the stacks.

The charge generation layer (CGL) refers to a layer that separates adjacently disposed emissive stacks without directly contacting both electrodes (e.g., an anode and a cathode) in an organic electroluminescent element. Such a charge generation layer is disposed between two adjacent emissive stacks to generate electrons, thereby serving as a cathode for one emissive stack, and to generate holes, thereby serving as an anode for the other emissive stack. The charge generation layer may employ any material known as a material for a charge generation layer in the art, without limitation. In addition, a conventional n-type and/or p-type material known in the art may be doped to the material for a charge generation layer.

The above-described emissive layer 320 may be formed through a commonly used method known in the art. Examples thereof include vacuum deposition, spin coating, casting, Langmuir-Blodgett (LB) method, inkjet printing, laser printing, laser induced thermal imaging (LITI), and the like, but are not limited thereto. For example, the emissive layer may be formed by co-deposition of the first host represented by Chemical Formula 1 and the second host represented by Chemical Formula 2. In such a case, dopants may also be co-deposited.

### 3) Electron transport region

In the organic electroluminescent element according to the present invention, the electron transport region 330 is an organic layer disposed on the emissive layer 320 and allows electrons injected from the cathode 200 to migrate to the emissive layer 320.

The electron transport region 330 may include at least one selected from the group consisting of the electron transport layer 331 and the electron injection layer 332.

For example, as shown in FIG. 1, the electron transport region 330 may include the electron transport layer 331 and the electron injection layer 332 sequentially stacked on the emissive layer 320.

In the electron transport region 330 according to the present invention, the electron transport layer 331 may employ any electron transport material that facilitates electron injection and has high electron mobility, without limitation. Non-limiting examples of the electron transport material may include an oxazole-based compound, an isoxazole-based compound, a triazole-based compound, an isothiazole-based compound, an oxadiazole-based compound, a thiadiazole-based compound, a perylene-based compound, an aluminum complex [e.g., tris(8-quinolinolato)-aluminium (Alq₃), BAlq, SAlq, Alph₃, Almq₃], a gallium complex (e.g., Gaq'2OPiv, Gaq'2OAc, 2(Gaq'2)), and the like, which may be used alone or in a mixture of two or more thereof.

The electron transport layer 332 may employ any electron injection material that facilitates electron injection and has high electron mobility, without limitation. Non-limiting examples of the electron injection material may include LiF, Li₂O, BaO, NaCl, and CsF; lanthanide metals, such as Yb; metal halides, such as RbCl and RbI, and the like, which may be used alone or in a mixture of two or more thereof.

The electron transport region 330, specifically, the electron transport layer 331 and/or the electron injection layer 332 according to the present invention may be co-deposited with an n-type dopant to facilitate the injection of electrons from the cathode 200. In such a case, as the n-type dopant, any alkali metal complex compound known in the art may be used without limitation, and examples thereof may include alkali metals, alkaline earth metals, or rare earth metals.

The electron transport region 330 may be formed through a commonly used method known in the art. Examples thereof include vacuum deposition, spin coating, casting, Langmuir-Blodgett (LB) method, inkjet printing, laser printing, laser induced thermal imaging (LITI), and the like, but are not limited thereto.

### 4) Emissive auxiliary layer

Although not shown, the organic electroluminescent element of the present invention may further include an emissive auxiliary layer disposed between the hole transport region 310 and the emissive layer 320.

The emissive auxiliary layer serves to adjust the thickness of the organic layer 300, while transporting the holes migrating from the hole transport region 310 to the emissive layer 320 or blocking the migration of electrons and/or excitons. Particularly, the emissive auxiliary layer has a high LUMO value to prevent electrons from migrating to the hole transport layer 312 and has a high triplet energy to prevent excitons of the emissive layer 320 from being diffused to the hole transport layer 312.

The emissive auxiliary layer may contain a hole transport material and may be formed of a material that is the same as a material for the hole transport region. In addition, emissive auxiliary layers of red, green, and blue organic electroluminescent elements may be formed of the same material.

A material for the emissive auxiliary layer is not particularly limited, and examples thereof may include carbazole derivatives and arylamine derivatives. Specifically, examples of the emissive auxiliary layer may include N,N-dinaphthyl-N,N'-diphenylbenzidine (NPD), N,N'-bis-(3-methylphenyl)-N,N'-bis(phenyl)-benzidine (TPD), s-TAD, 4,4',4"-Tris(N-3-methylphenyl-N-phenyl-amino)-triphenylamine (MTDATA), and the like, but are not limited thereto. These may be used alone or in a mixture of two or more thereof.

The emissive auxiliary layer may further include a p-type dopant in addition to the above-described material. As the p-type dopant usable in the present invention, any known p-type dopant that is generally used in the art may be used without particular limitation. In such a case, the content of the p-type dopant may be appropriately adjusted within a range known in the art, for example, the content of the p-type dopant may be about 0.5 to 50 parts by weight relative to 100 parts by weight of the hole transport material.

As known in the art, the emissive auxiliary layer may be formed by vacuum deposition, spin coating, casting, Langmuir-Blodgett (LB) method, inkjet printing, laser printing, laser induced thermal imaging (LITI), and the like, but are not limited thereto.

### 5) Hole blocking layer

Although not shown, the organic electroluminescent device 100 of the present invention may further include a hole blocking layer between the emissive layer 320 and the electron transport region 330.

The hole blocking layer 333 can block the diffusion (migration) of excitons or holes generated in the emissive layer 320 into the electron transport layer 331, thereby improving the lifespan of the organic electroluminescent element.

A material for the hole blocking layer may employ any material that has common electron transport properties known in the art, without any limitation, and examples thereof may include 2,9-dimethyl-4,7-diphenyl-1,10-phenanthroline (BCP), bis(2-methyl-8-quinolinolato) (4-phenyl-phenolato) aluminum (III) (BAlq), and the like.

As known in the art, the hole blocking layer may be formed by vacuum deposition, spin coating, casting, Langmuir-Blodgett (LB) method, inkjet printing, laser printing, laser induced thermal imaging (LITI), and the like, but are not limited thereto.

### (4) Capping layer

Optionally, the organic electroluminescent element 100 of the present invention may further include a capping layer (not shown) disposed on the cathode 200.

The capping layer serves to help the light generated in the organic layer to be efficiently emitted to the outside, while protecting the organic electroluminescent element.

The capping layer may contain at least one selected from the group consisting of tris-8-hydroxyquinoline aluminum (Alq₃), ZnSe, 2,5-bis(6'-(2',2"-bipyridyl))-1,1-dimethyl-3,4-diphenylsilole, 4'-bis[N-(1-naphthyl)-N-phenylamino]biphenyl (α-NPD), N,N'-diphenyl-N,N'-bis(3-methylphenyl)-1,1'-biphenyl-4,4'-diamine (TPD), and 1,1'-bis(di-4-tolylaminophenyl)cyclohexane (TAPC). Such a material for forming the capping layer is inexpensive compared with materials for the other layers in the organic electroluminescent element.

The capping layer may be a single layer, but may include two or more layers having different refractive indexes so that the light undergoes a gradual change in refractive index while passing through the two or more layers.

The capping layer may be formed by a commonly used method known in the art, and for example, various methods, such as vacuum deposition, spin coating, casting, or Langmuir-Blodgett (LB) method may be used.

As such, the organic electroluminescent element according to the present invention has a structure where the anode 100, the organic layer 300, and the cathode 200 are sequentially stacked. In some cases, an insulating layer (not shown) or an adhesive layer (not shown) may be further included between the anode 100 and the organic layer 300 or between the cathode 200 and the organic layer 300. The organic electroluminescent element of the present invention can have excellent lifespan characteristics since the half-life time of initial brightness is increased while the maximum luminous efficiency is maintained upon the application of voltage and current.

The above-described organic electroluminescent element of the present invention may be manufactured according to a commonly used method known in the art. For example, an organic electroluminescent element may be manufactured by vacuum-depositing an anode material on a substrate and then sequentially vacuum-depositing a hole transport region material, a light-emitting layer material, an electron transport region material, and a cathode material on the anode.

Hereinafter, the present invention will be described in detail with reference to examples. However, the following examples are merely for illustrating the present disclosure and are not intended to limit the scope of the present disclosure.

### <Preparation Example 1-1> Synthesis of Cz-D1

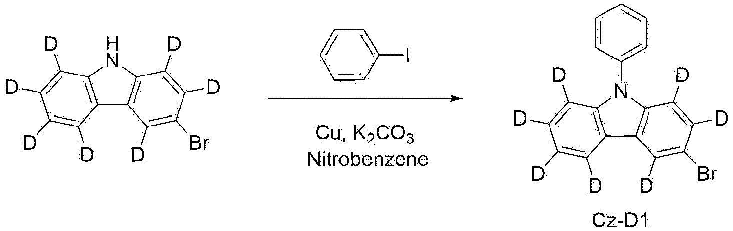

Under a nitrogen atmosphere, 3-bromo-9H-carbazole-1,2,4,5,6,7,8-d7 (134.3 g, 530.6 mmol), iodobenzene (130.0 g, 636.7 mmol), Cu (16.8 g, 265.3 mmol), K₂CO₃ (146.7 g, 1,061.3 mmol), and toluene (1000 ml) were mixed, and stirred at 110°C for 12 hours.

After the reaction was completed, extraction was conducted with ethyl acetate, moisture was removed over MgSO₄, and then purification was performed by column chromatography (hexane:EA=5:1 (v/v)), thereby obtaining Cz-D1 (125.7 g, yield: 72%).
Mass (calcd.: 329.25, found: 329 g/mol)

### <Preparation Example 1-2> Synthesis of Cz-D2

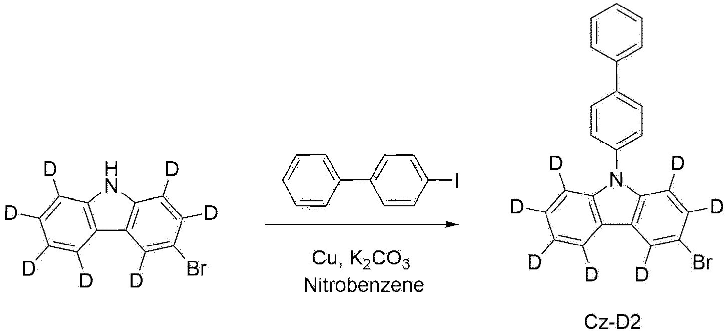

The same procedure as in Preparation Example 1-1 was performed except that 4-iodo-1,1'-biphenyl (178.3 g, 636.7 mmol) was used instead of iodobenzene used in Preparation Example 1-1, thereby obtaining Cz-D2 (135.5 g, yield: 63%).
Mass (calcd.: 405.35, found: 405 g/mol)

### <Preparation Example 1-3> Synthesis of Cz-D3

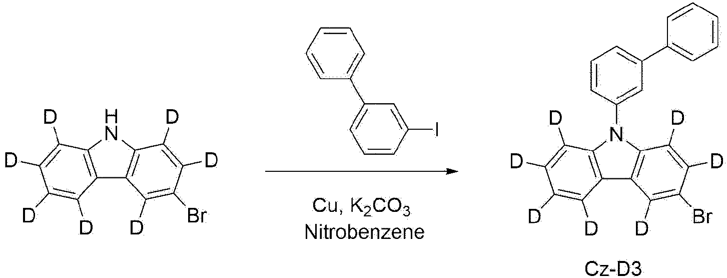

The same procedure as in Preparation Example 1-1 was performed except that 3-iodo-1,1'-biphenyl (178.3 g, 636.7 mmol) was used instead of iodobenzene used in Preparation Example 1-1, thereby obtaining Cz-D3 (148.4 g, yield: 69%).
Mass (calcd.: 405.35, found: 405 g/mol)

### <Preparation Example 1-4> Synthesis of Cz-D4

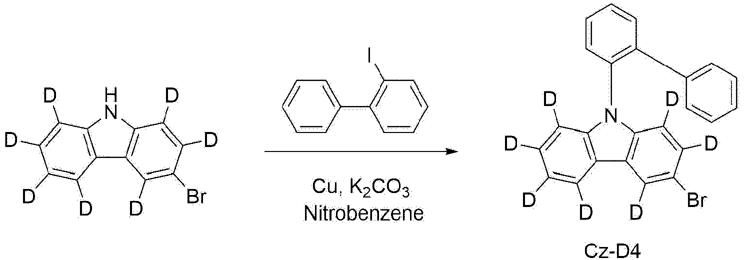

The same procedure as in Preparation Example 1-1 was performed except that 2-iodo-1,1'-biphenyl (178.3 g, 636.7 mmol) was used instead of iodobenzene used in Preparation Example 1-1, thereby obtaining Cz-D4 (96.8 g, yield: 45%).
Mass (calcd.: 405.35, found: 405 g/mol)

### <Preparation Example 2-1> Synthesis of Cz-D5

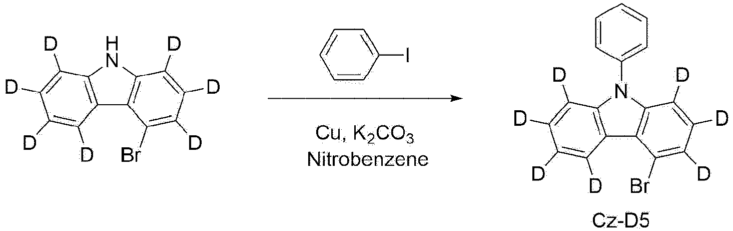

The same procedure as in Preparation Example 1-1 was performed except that 4-bromo-9H-carbazole-1,2,3,5,6,7,8-d7 (134.3 g, 530.6 mmol) was used instead of 3-bromo-9H-carbazole-1,2,4,5,6,7,8-d7 used in Preparation Example 1-1, thereby obtaining Cz-D5 (117.1 g, yield: 67%).
Mass (calcd.: 329.25, found: 329 g/mol)

### <Preparation Example 2-2> Synthesis of Cz-D6

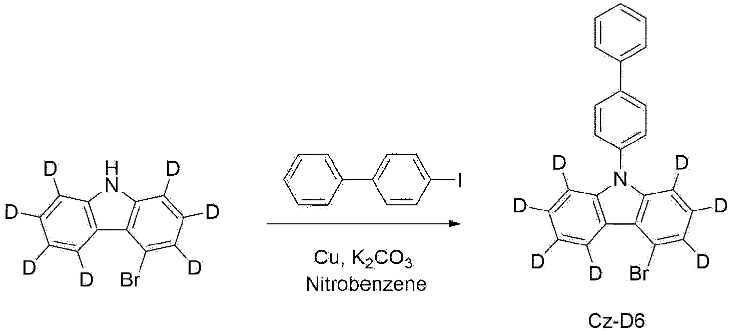

The same procedure as in Preparation Example 2-1 was performed except that 4-iodo-1,1'-biphenyl (178.3 g, 636.7 mmol) was used instead of iodobenzene used in Preparation Example 2-1, thereby obtaining Cz-D6 (139.8 g, yield: 65%).
Mass (calcd.: 405.35, found: 405 g/mol)

### <Preparation Example 2-3> Synthesis of Cz-D7

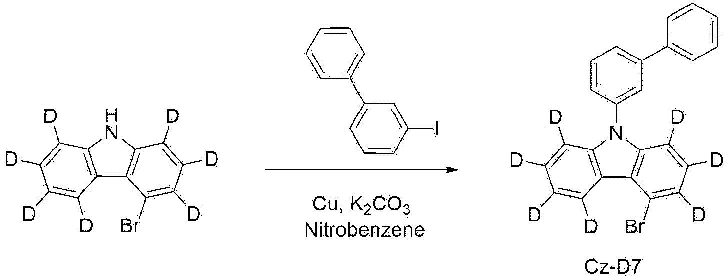

The same procedure as in Preparation Example 2-1 was performed except that 3-iodo-1,1'-biphenyl (178.3 g, 636.7 mmol) was used instead of iodobenzene used in Preparation Example 2-1, thereby obtaining Cz-D7 (152.7 g, yield: 71%).
Mass (calcd.: 405.35, found: 405 g/mol)

### <Preparation Example 2-4> Synthesis of Cz-D8

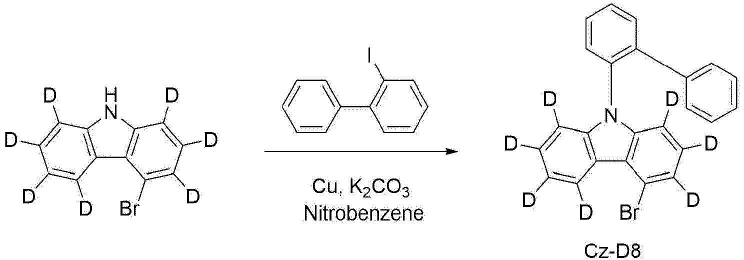

The same procedure as in Preparation Example 2-1 was performed except that 2-iodo-1,1'-biphenyl (178.3 g, 636.7 mmol) was used instead of iodobenzene used in Preparation Example 2-1, thereby obtaining Cz-D8 (75.2 g, yield: 35%).
Mass (calcd.: 405.35, found: 405 g/mol)

### <Preparation Example 3-1> Synthesis of Cz-D9

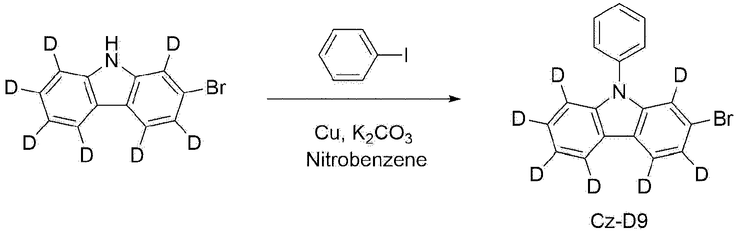

The same procedure as in Preparation Example 1-1 was performed except that 2-bromo-9H-carbazole-1,3,4,5,6,7,8-d7 (134.3 g, 530.6 mmol) was used instead of 3-bromo-9H-carbazole-1,2,4,5,6,7,8-d7 used in Preparation Example 1-1, thereby obtaining Cz-D9 (134.5 g, yield: 77%).
Mass (calcd.: 329.25, found: 329 g/mol)

### <Preparation Example 3-2> Synthesis of Cz-D10

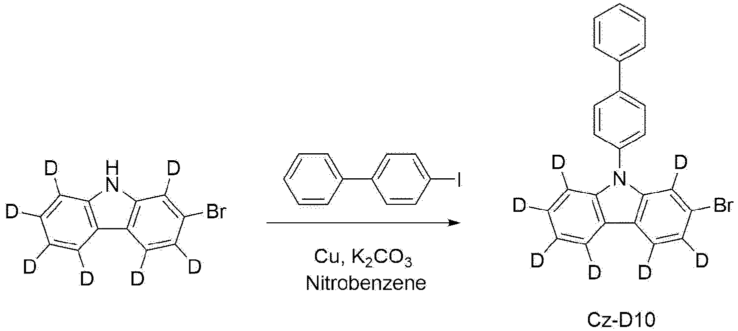

The same procedure as in Preparation Example 3-1 was performed except that 4-iodo-1,1'-biphenyl (178.3 g, 636.7 mmol) was used instead of iodobenzene used in Preparation Example 3-1, thereby obtaining Cz-D10 (159.1 g, yield: 74%).
Mass (calcd.: 405.35, found: 405 g/mol)

### <Preparation Example 3-3> Synthesis of Cz-D11

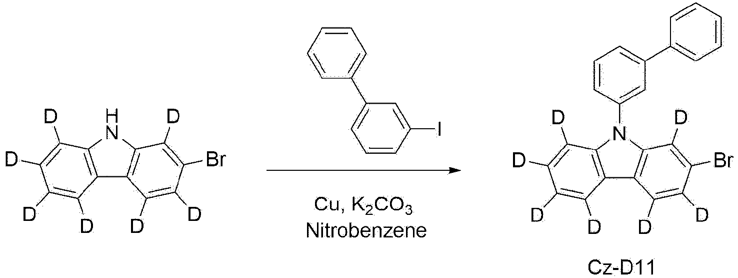

The same procedure as in Preparation Example 3-1 was performed except that 3-iodo-1,1'-biphenyl (178.3 g, 636.7 mmol) was used instead of iodobenzene used in Preparation Example 3-1, thereby obtaining Cz-D11 (163.4 g, yield: 76%).
Mass (calcd.: 405.35, found: 405 g/mol)

### <Preparation Example 3-4> Synthesis of Cz-D12

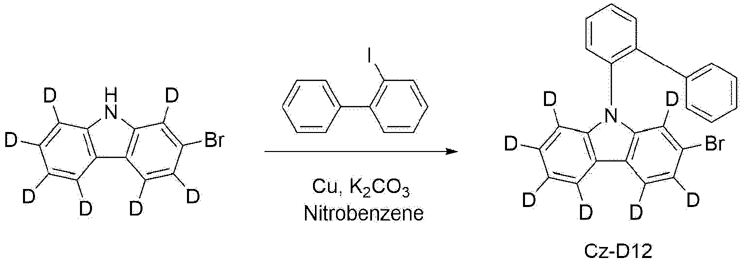

The same procedure as in Preparation Example 3-1 was performed except that 2-iodo-1,1'-biphenyl (178.3 g, 636.7 mmol) was used instead of iodobenzene used in Preparation Example 3-1, thereby obtaining Cz-D12 (92.4 g, yield: 43%).
Mass (calcd.: 405.35, found: 405 g/mol)

### <Preparation Example 4-1> Synthesis of Cz-D13

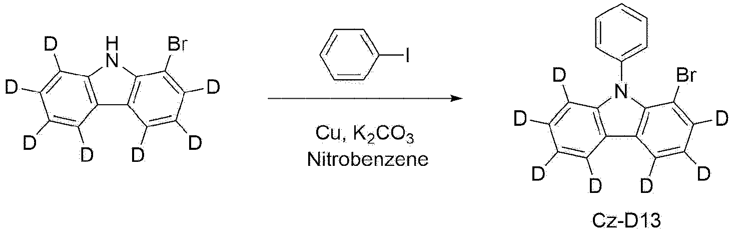

The same procedure as in Preparation Example 1-1 was performed except that 1-bromo-9H-carbazole-2,3,4,5,6,7,8-d7 (134.3 g, 530.6 mmol) was used instead of 3-bromo-9H-carbazole-1,2,4,5,6,7,8-d7 used in Preparation Example 1-1, thereby obtaining Cz-D13 (94.3 g, yield: 54%).
Mass (calcd.: 329.25, found: 329 g/mol)

### <Preparation Example 4-2> Synthesis of Cz-D14

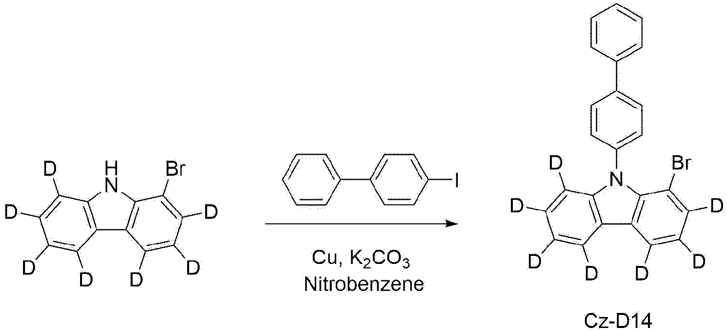

The same procedure as in Preparation Example 4-1 was performed except that 4-iodo-1,1'-biphenyl (178.3 g, 636.7 mmol) was used instead of iodobenzene used in Preparation Example 4-1, thereby obtaining Cz-D14 (122.6 g, yield: 57%).
Mass (calcd.: 405.35, found: 405 g/mol)

### <Preparation Example 4-3> Synthesis of Cz-D15

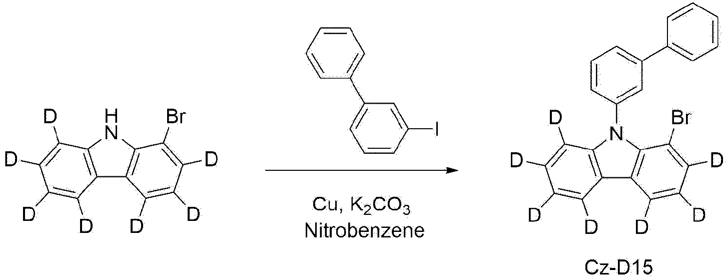

The same procedure as in Preparation Example 4-1 was performed except that 3-iodo-1,1'-biphenyl (178.3 g, 636.7 mmol) was used instead of iodobenzene used in Preparation Example 4-1, thereby obtaining Cz-D15 (111.8 g, yield: 52%).
Mass (calcd.: 405.35, found: 405 g/mol)

### <Preparation Example 4-4> Synthesis of Cz-D16

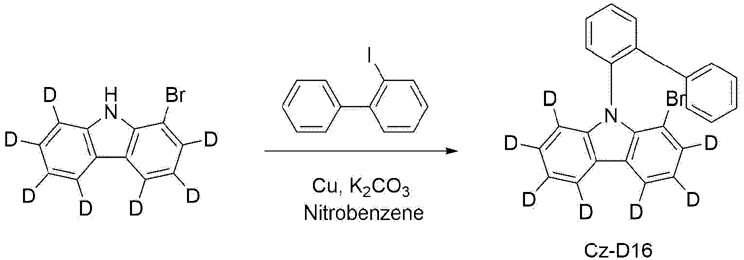

The same procedure as in Preparation Example 4-1 was performed except that 2-iodo-1,1'-biphenyl (178.3 g, 636.7 mmol) was used instead of iodobenzene used in Preparation Example 4-1, thereby obtaining Cz-D16 (68.8 g, yield: 32%).
Mass (calcd.: 405.35, found: 405 g/mol)

### <Preparation Example 5-1> Synthesis of BCz-D1

### <Step 1> Synthesis of 9-phenyl-3-(4,4,5,5-tetramethyl-1,3,2-dioxaborolan-2-yl)-9H-carbazole-1,2,4,5,6,7,8-d7

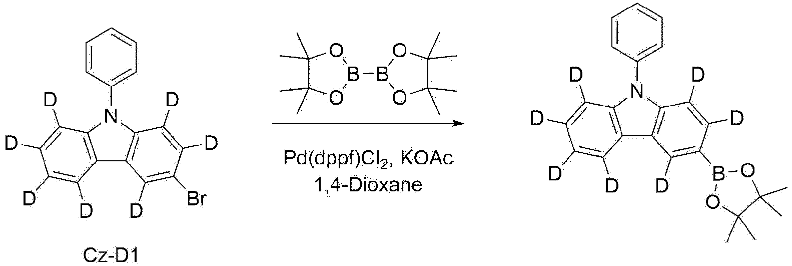

Under a nitrogen atmosphere, Cz-D1 (100.0 g, 303.7 mmol), 4,4,4',4',5,5, 5',5'-octamethyl-2,2'-bi(1,3,2-dioxaborolane) (84.8 g, 334.1 mmol), Pd(dppf)Cl₂ (26.6 g, 30.3 mmol), KOAc (85.8 g, 911.1 mmol), and 1,4-Dioxane (1000 ml) were mixed, and stirred at 130°C for 12 hours.

After the reaction was completed, extraction was conducted with ethyl acetate, moisture was removed over MgSO₄, and then purification was performed by column chromatography (hexane:EA=8:1 (v/v)), thereby obtaining 9-phenyl-3-(4,4,5,5-tetramethyl-1,3,2-dioxaborolan-2-yl)-9H-carbazole-1,2,4,5,6,7,8-d7 (96.0 g, yield: 84%).

Mass (calcd.: 376.3, found: 376 g/mol)

### <Step 2> Synthesis of BCz-D1

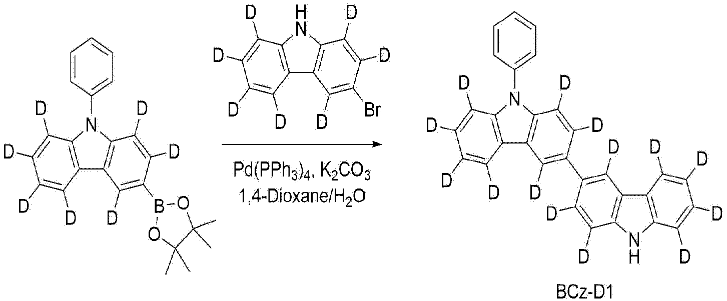

Under a nitrogen atmosphere, 9-phenyl-3-(4,4,5,5-tetramethyl-1,3,2-dioxaborolan-2-yl)-9H-carbazole-1,2,4,5,6,7,8-d7 (96.0 g, 255.1 mmol), 3-bromo-9H-carbazole-1,2,4,5,6,7,8-d7 (77.5 g, 306.1 mmol), Pd(PPh₃)₄ (14.7 g, 12.7 mmol), K₂CO₃ (88.1 g, 637.8 mmol), and 1,4-dioxane/H₂O (1000 ml/250 ml) were mixed, and stirred at 120°C for 4 hours.

After the reaction was completed, extraction was conducted with methylene chloride, and filtration was conducted with MgSO₄. The obtained organic layer was subjected to solvent removal, and then purification was performed by column chromatography (hexane:EA = 7:1 (v/v)), thereby obtaining BCz-D1 (71.1 g, yield: 66%).
Mass (calcd.: 422.59, found: 422 g/mol)

### <Preparation Example 5-2> Synthesis of BCz-D2

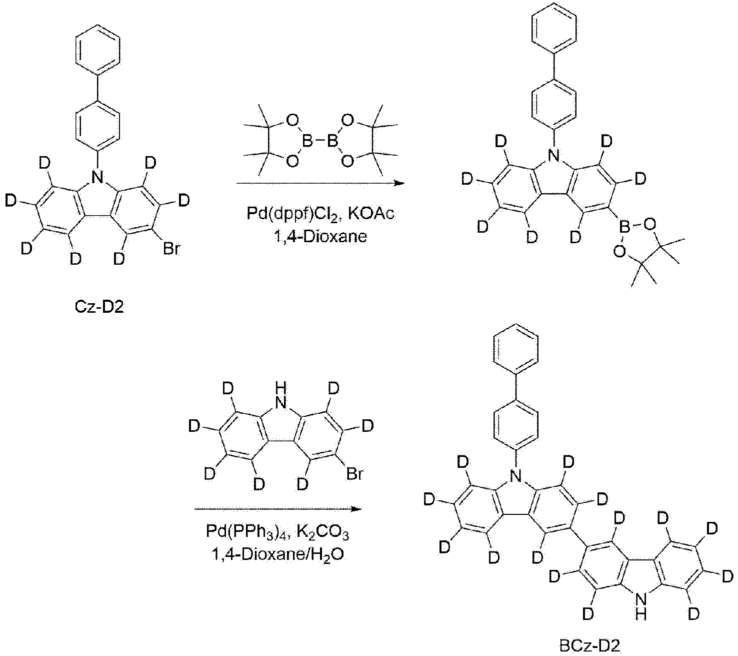

The same procedure as in Preparation Example 5-1 was performed except that Cz-D2 (100 g, 246.7 mmol) obtained in Preparation Example 1-2 was used instead of Cz-D1 used in Preparation Example 5-1, thereby obtaining the target compound BCz-D2 (66.4 g, final yield: 54.0%).
Mass (calcd.: 498.69, found: 498 g/mol)

### <Preparation Example 5-3> Synthesis of BCz-D3

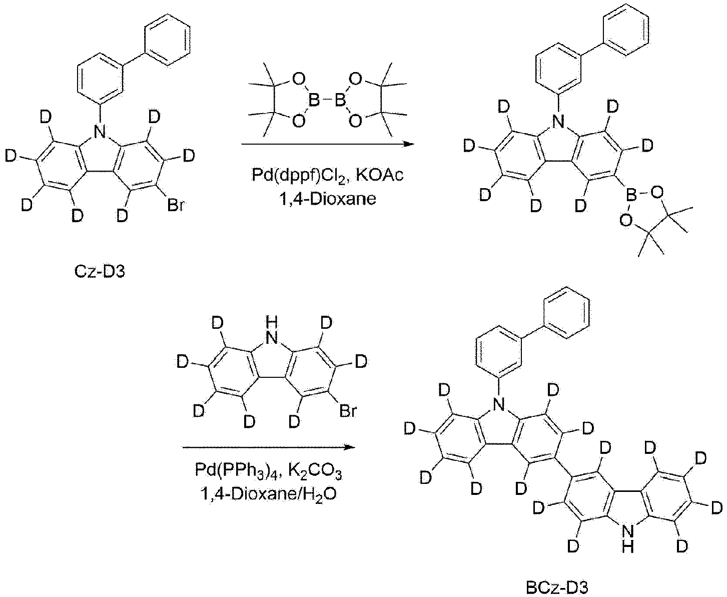

The same procedure as in Preparation Example 5-1 was performed except that Cz-D3 (100 g, 246.7 mmol) obtained in Preparation Example 1-3 was used instead of Cz-D1 used in Preparation Example 5-1, thereby obtaining the target compound BCz-D3 (59.7 g, final yield: 48.5%).
Mass (calcd.: 498.69, found: 498 g/mol)

### <Preparation Example 5-4> Synthesis of BCz-D4

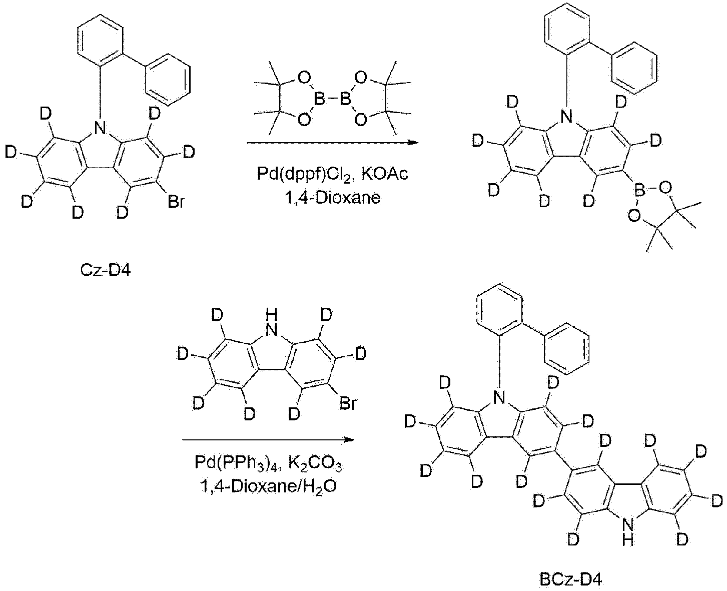

The same procedure as in Preparation Example 5-1 was performed except that Cz-D4 (100 g, 246.7 mmol) obtained in Preparation Example 1-4 was used instead of Cz-D1 used in Preparation Example 5-1, thereby obtaining the target compound BCz-D4 (59.4 g, final yield: 48.3%).
Mass (calcd.: 498.69, found: 498 g/mol)

### [Synthesis Example 1] Synthesis of A-1

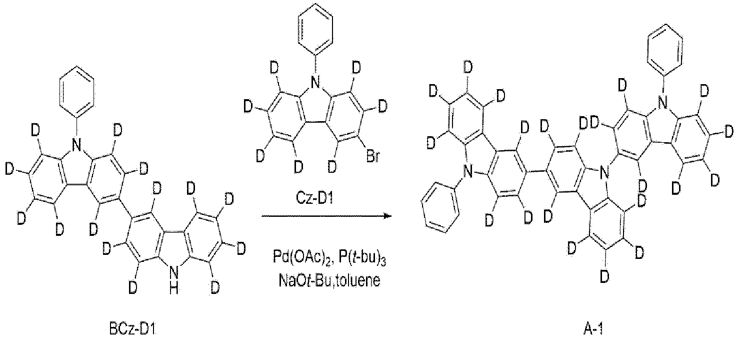

Under a nitrogen atmosphere, BCz-D1 (10.0 g, 23.6 mmol) obtained in Preparation Example 5-1, Cz-D1 (9.3 g, 28.3 mmol) obtained in Preparation Example 1-1, Pd(OAc)₂ (1.36 g, 1.18 mmol), P(t-Bu)₃ (0.57 ml, 2.36 mmol), NaO(t-Bu) (4.55 g, 47.3 mmol), and toluene (100 ml) were mixed, and stirred at 110°C for 5 hours. After the reaction was completed, toluene was concentrated, and the solid salt was filtered and then purified by recrystallization, thereby obtaining the target compound A-1 (13.0 g, yield: 82%).
Mass (calcd.: 670.93, found: 670 g/mol)

### [Synthesis Example 2] Synthesis of A-2

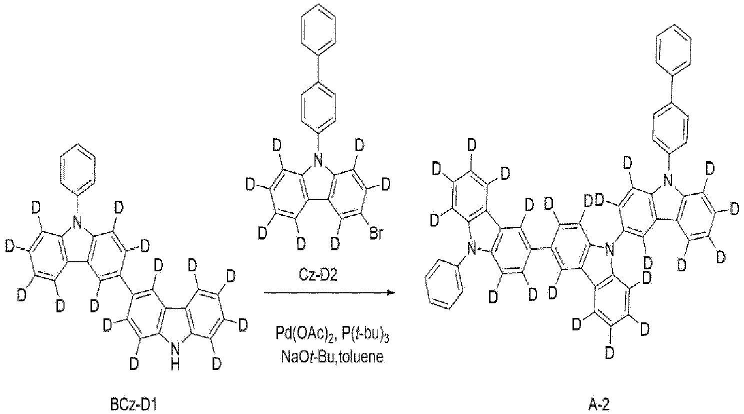

The same procedure as in Synthesis Example 1 was performed except that Cz-D2 (10.0 g, 23.6 mmol) obtained in Preparation Example 1-2 was used instead of Cz-D1 used in Synthesis Example 1, thereby obtaining the target compound A-2 (13.8 g, yield: 78%).
Mass (calcd.: 747.02, found: 747 g/mol)

### [Synthesis Example 3] Synthesis of A-3

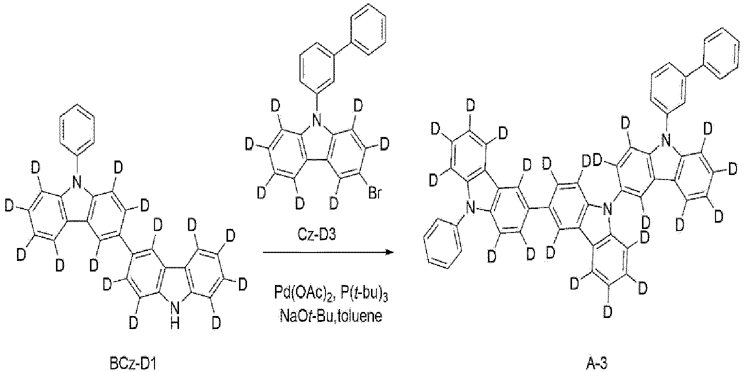

The same procedure as in Synthesis Example 1 was performed except that Cz-D3 (10.0 g, 23.6 mmol) obtained in Preparation Example 1-3 was used instead of Cz-D1 used in Synthesis Example 1, thereby obtaining the target compound A-3 (13.2 g, yield: 75%).
Mass (calcd.: 747.02, found: 747 g/mol)

### [Synthesis Example 4] Synthesis of A-4

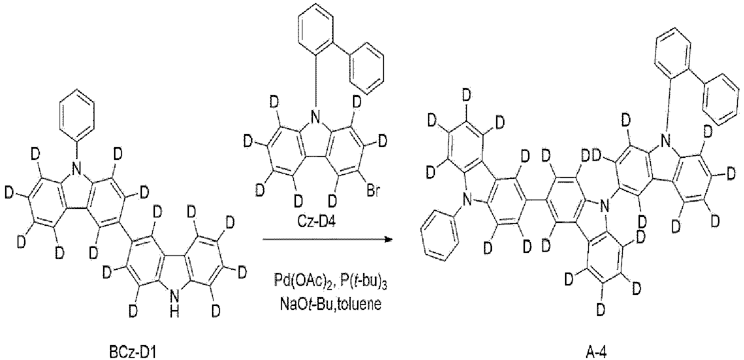

The same procedure as in Synthesis Example 1 was performed except that Cz-D4 (10.0 g, 23.6 mmol) obtained in Preparation Example 1-4 was used instead of Cz-D1 used in Synthesis Example 1, thereby obtaining the target compound A-4 (12.2 g, yield: 69%).
Mass (calcd.: 747.02, found: 747 g/mol)

### [Synthesis Example 5] Synthesis of A-5

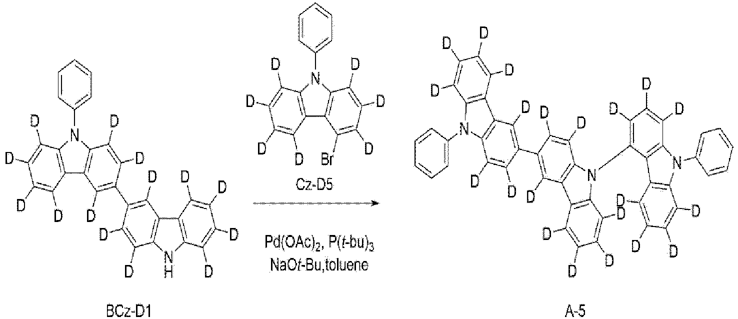

The same procedure as in Synthesis Example 1 was performed except that Cz-D5 (9.3 g, 23.6 mmol) obtained in Preparation Example 2-1 was used instead of Cz-D1 used in Synthesis Example 1, thereby obtaining the target compound A-5 (8.73 g, yield: 55%).
Mass (calcd.: 670.93, found: 670 g/mol)

### [Synthesis Example 6] Synthesis of A-6

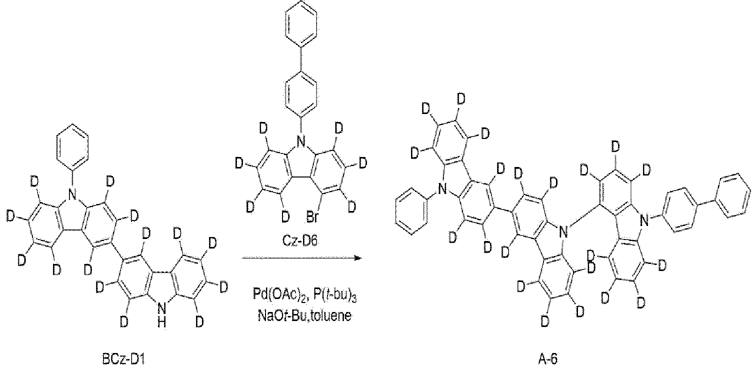

The same procedure as in Synthesis Example 1 was performed except that Cz-D6 (10.0 g, 23.6 mmol) obtained in Preparation Example 2-2 was used instead of Cz-D1 used in Synthesis Example 1, thereby obtaining the target compound A-6 (7.42 g, yield: 42%).
Mass (calcd.: 747.02, found: 747 g/mol)

### [Synthesis Example 7] Synthesis of A-7

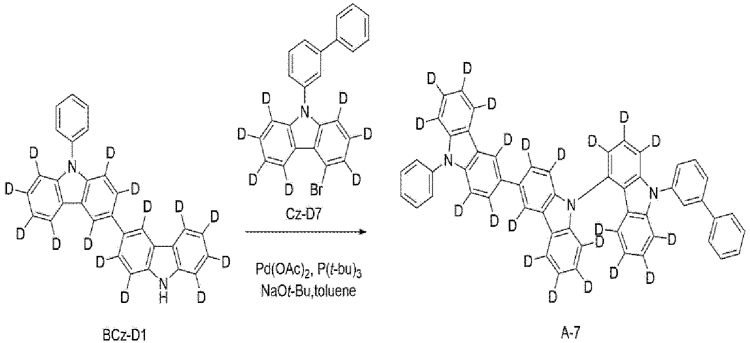

The same procedure as in Synthesis Example 1 was performed except that Cz-D7 (10.0 g, 23.6 mmol) obtained in Preparation Example 2-3 was used instead of Cz-D1 used in Synthesis Example 1, thereby obtaining the target compound A-7 (8.83 g, yield: 50%).
Mass (calcd.: 747.02, found: 747 g/mol)

### [Synthesis Example 8] Synthesis of A-8

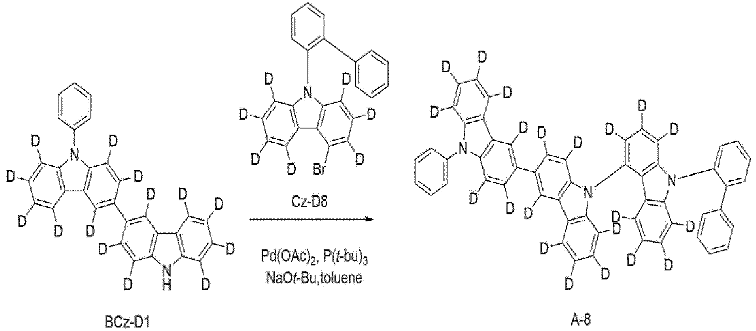

The same procedure as in Synthesis Example 1 was performed except that Cz-D8 (10.0 g, 23.6 mmol) obtained in Preparation Example 2-4 was used instead of Cz-D1 used in Synthesis Example 1, thereby obtaining the target compound A-8 (9.89 g, yield: 56%).
Mass (calcd.: 747.02, found: 747 g/mol)

### [Synthesis Example 9] Synthesis of A-9

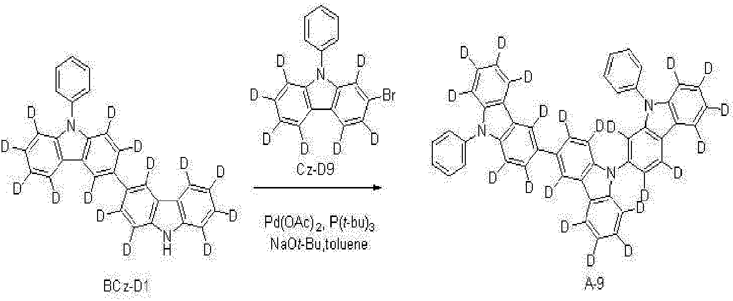

The same procedure as in Synthesis Example 1 was performed except that Cz-D9 (9.3 g, 23.6 mmol) obtained in Preparation Example 3-1 was used instead of Cz-D1 used in Synthesis Example 1, thereby obtaining the target compound A-9 (8.41 g, yield: 53%).
Mass (calcd.: 670.93, found: 670 g/mol)

### [Synthesis Example 10] Synthesis of A-10

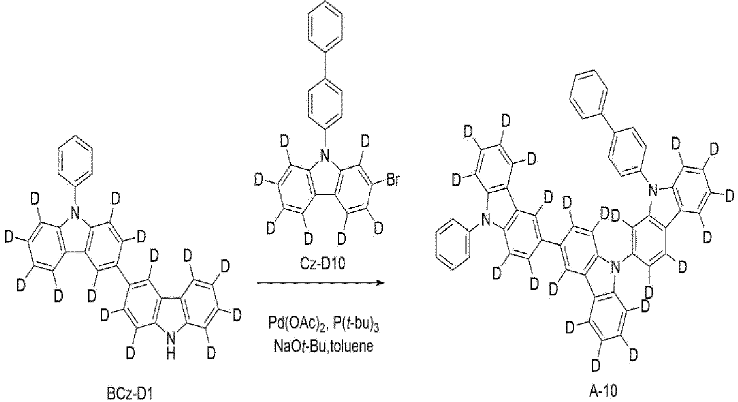

The same procedure as in Synthesis Example 1 was performed except that Cz-D10 (10.0 g, 23.6 mmol) obtained in Preparation Example 3-2 was used instead of Cz-D1 used in Synthesis Example 1, thereby obtaining the target compound A-10 (8.66 g, yield: 49%).
Mass (calcd.: 747.02, found: 747 g/mol)

### [Synthesis Example 11] Synthesis of A-11

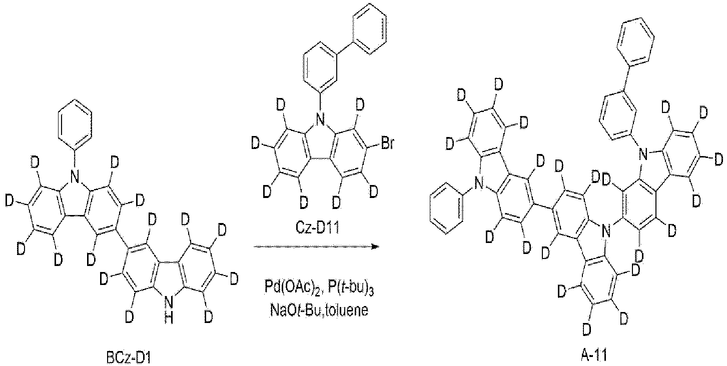

The same procedure as in Synthesis Example 1 was performed except that Cz-D11 (10.0 g, 23.6 mmol) obtained in Preparation Example 3-3 was used instead of Cz-D1 used in Synthesis Example 1, thereby obtaining the target compound A-11 (9.01 g, yield: 51%).
Mass (calcd.: 747.02, found: 747 g/mol)

### [Synthesis Example 12] Synthesis of A-12

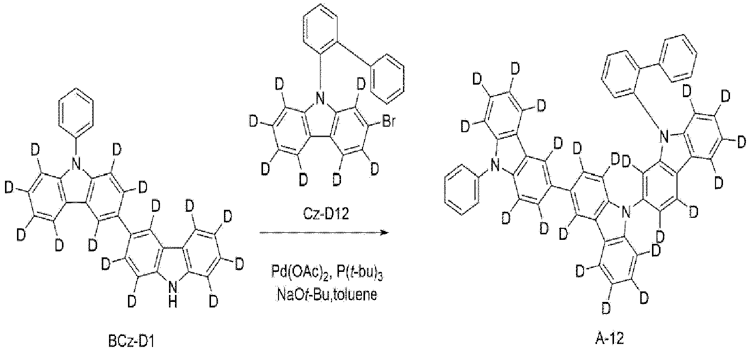

The same procedure as in Synthesis Example 1 was performed except that Cz-D12 (10.0 g, 23.6 mmol) obtained in Preparation Example 3-4 was used instead of Cz-D1 used in Synthesis Example 1, thereby obtaining the target compound A-12 (9.19 g, yield: 52%).
Mass (calcd.: 747.02, found: 747 g/mol)

### [Synthesis Example 13] Synthesis of A-13

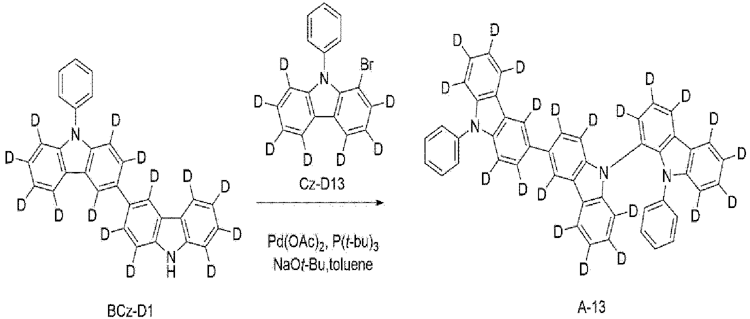

The same procedure as in Synthesis Example 1 was performed except that Cz-D13 (9.3 g, 23.6 mmol) obtained in Preparation Example 4-1 was used instead of Cz-D1 used in Synthesis Example 1, thereby obtaining the target compound A-13 (9.52 g, yield: 60%).
Mass (calcd.: 670.93, found: 670 g/mol)

### [Synthesis Example 14] Synthesis of A-14

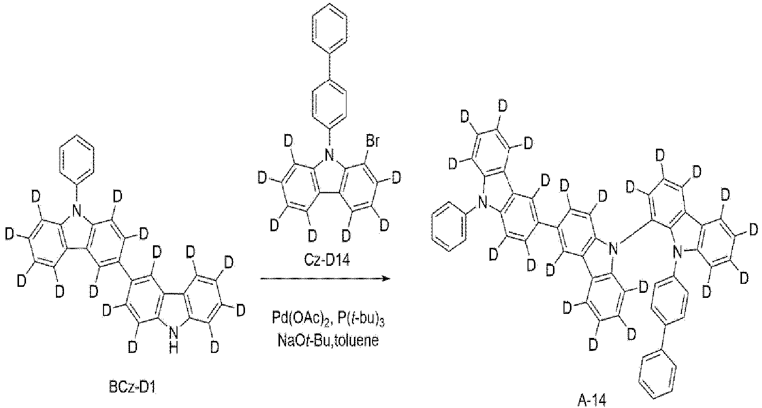

The same procedure as in Synthesis Example 1 was performed except that Cz-D14 (10.0 g, 23.6 mmol) obtained in Preparation Example 4-2 was used instead of Cz-D1 used in Synthesis Example 1, thereby obtaining the target compound A-14 (10.78 g, yield: 61%).
Mass (calcd.: 747.02, found: 747 g/mol)

### [Synthesis Example 15] Synthesis of A-15

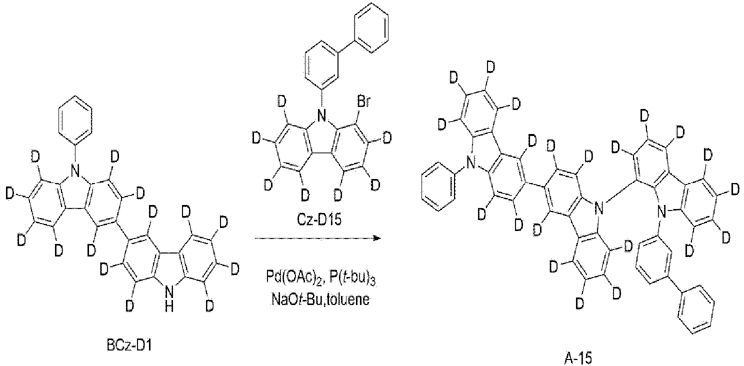

The same procedure as in Synthesis Example 1 was performed except that Cz-D15 (10.0 g, 23.6 mmol) obtained in Preparation Example 4-3 was used instead of Cz-D1 used in Synthesis Example 1, thereby obtaining the target compound A-15 (11.13 g, yield: 63%).
Mass (calcd.: 747.02, found: 747 g/mol)

### [Synthesis Example 16] Synthesis of A-16

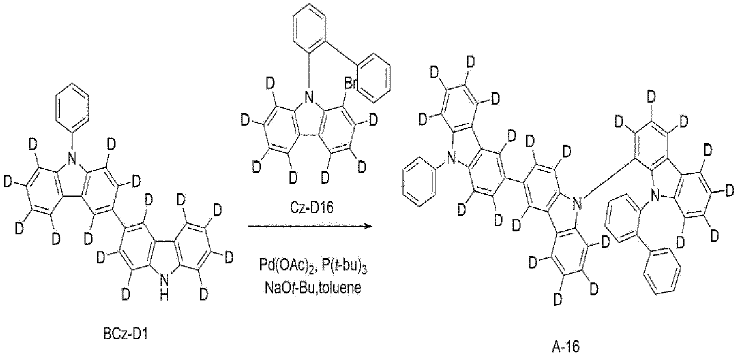

The same procedure as in Synthesis Example 1 was performed except that Cz-D16 (10.0 g, 23.6 mmol) obtained in Preparation Example 4-4 was used instead of Cz-D1 used in Synthesis Example 1, thereby obtaining the target compound A-16 (9.02 g, yield: 51%).
Mass (calcd.: 747.02, found: 747 g/mol)

### [Synthesis Example 17] Synthesis of B-1

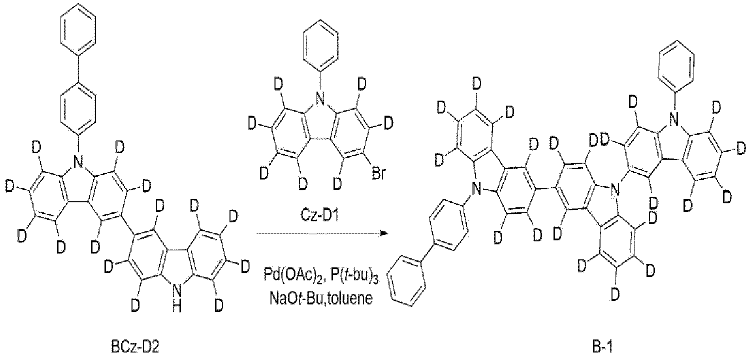

Under a nitrogen atmosphere, BCz-D2 (10.0 g, 20.1 mmol) obtained in Preparation Example 5-2, Cz-D1 (7.9 g, 24.1 mmol) obtained in Preparation Example 1-1, Pd(OAc)₂ (1.15 g, 1.0 mmol), P(t-Bu)₃ (0.49 ml, 2.0 mmol), NaO(t-Bu) (3.85 g, 40.1 mmol), and toluene (100 ml) were mixed, and stirred at 110°C for 5 hours. After the reaction was completed, toluene was concentrated, and the solid salt was filtered and then purified by recrystallization, thereby obtaining the target compound B-1 (10.2 g, yield: 62%) .
Mass (calcd.: 747.02, found: 747 g/mol)

### [Synthesis Example 18] Synthesis of B-2

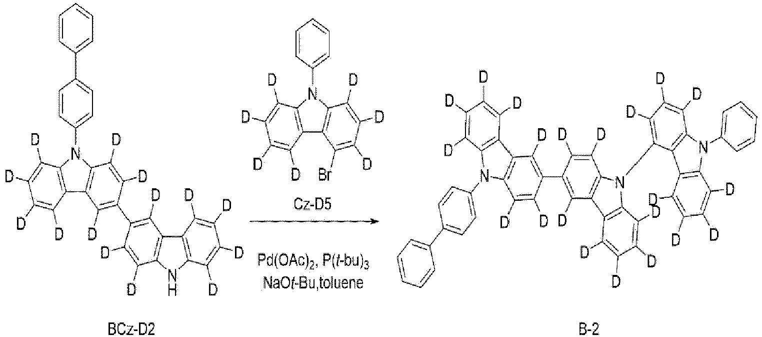

The same procedure as in Synthesis Example 17 was performed except that Cz-D5 (7.9 g, 24.1 mmol) obtained in Preparation Example 2-1 was used instead of Cz-D1 used in Synthesis Example 17, thereby obtaining the target compound B-2 (8.5 g, yield: 48%).
Mass (calcd.: 747.02, found: 747 g/mol)

### [Synthesis Example 19] Synthesis of B-3

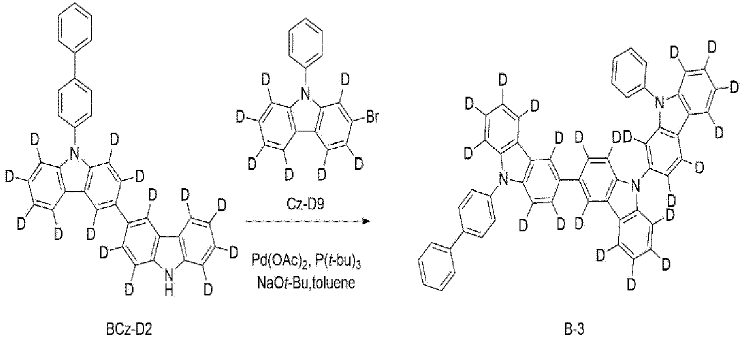

The same procedure as in Synthesis Example 17 was performed except that Cz-D9 (7.9 g, 24.1 mmol) obtained in Preparation Example 3-1 was used instead of Cz-D1 used in Synthesis Example 17, thereby obtaining the target compound B-3 (11.1 g, yield: 63%).
Mass (calcd.: 747.02, found: 747 g/mol)

### [Synthesis Example 20] Synthesis of B-4

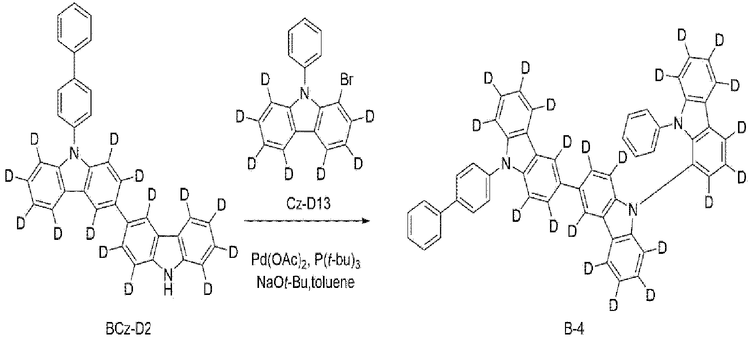

The same procedure as in Synthesis Example 17 was performed except that Cz-D13 (7.9 g, 24.1 mmol) obtained in Preparation Example 4-1 was used instead of Cz-D1 used in Synthesis Example 17, thereby obtaining the target compound B-4 (7.42 g, yield: 42%).
Mass (calcd.: 747.02, found: 747 g/mol)

### [Synthesis Example 21] Synthesis of C-1

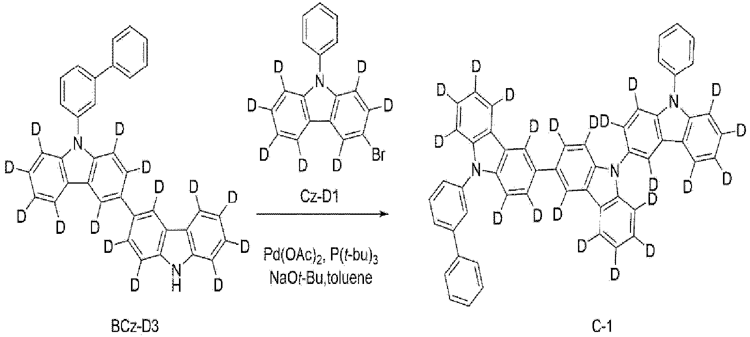

Under a nitrogen atmosphere, BCz-D3 (10.0 g, 20.1 mmol) obtained in Preparation Example 5-3, Cz-D1 (7.9 g, 24.1 mmol) obtained in Preparation Example 1-1, Pd(OAc)₂ (1.15 g, 1.0 mmol), P(t-Bu)₃ (0.49 ml, 2.0 mmol), NaO(t-Bu) (3.85 g, 40.1 mmol), and toluene (100 ml) were mixed, and stirred at 110°C for 5 hours. After the reaction was completed, toluene was concentrated, and the solid salt was filtered and then purified by recrystallization, thereby obtaining the target compound C-1 (9.4 g, yield: 63%).
Mass (calcd.: 747.02, found: 747 g/mol)

### [Synthesis Example 22] Synthesis of C-2

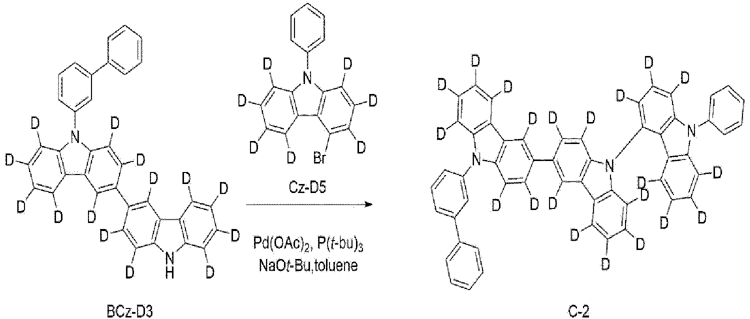

The same procedure as in Synthesis Example 21 was performed except that Cz-D5 (7.9 g, 24.1 mmol) obtained in Preparation Example 2-1 was used instead of Cz-D1 used in Synthesis Example 21, thereby obtaining the target compound C-2 (7.78 g, yield: 44%).
Mass (calcd.: 747.02, found: 747 g/mol)

### [Synthesis Example 23] Synthesis of C-3

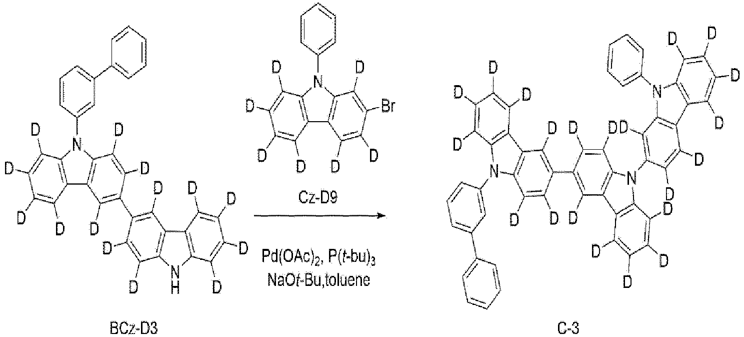

The same procedure as in Synthesis Example 21 was performed except that Cz-D9 (7.9 g, 24.1 mmol) obtained in Preparation Example 3-1 was used instead of Cz-D1 used in Synthesis Example 21, thereby obtaining the target compound C-3 (11.67 g, yield: 66%).
Mass (calcd.: 747.02, found: 747 g/mol)

### [Synthesis Example 24] Synthesis of C-4

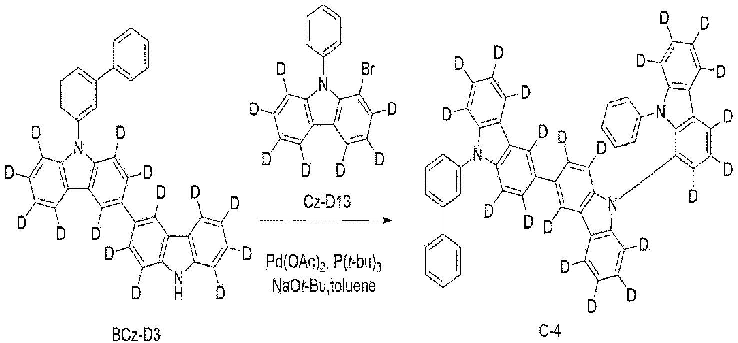

The same procedure as in Synthesis Example 21 was performed except that Cz-D13 (7.9 g, 24.1 mmol) obtained in Preparation Example 4-1 was used instead of Cz-D1 used in Synthesis Example 21, thereby obtaining the target compound C-4 (6.89 g, yield: 39%).
Mass (calcd.: 747.02, found: 747 g/mol)

### [Synthesis Example 25] Synthesis of D-1

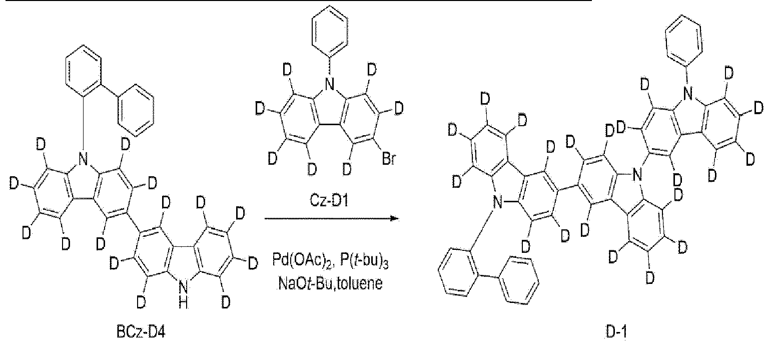

Under a nitrogen atmosphere, BCz-D4 (10.0 g, 20.1 mmol) obtained in Preparation Example 5-4, Cz-D1 (7.9 g, 24.1 mmol) obtained in Preparation Example 1-1, Pd(OAc)₂ (1.15 g, 1.0 mmol), P(t-Bu)₃ (0.49 ml, 2.0 mmol), NaO(t-Bu) (3.85 g, 40.1 mmol), and toluene (100 ml) were mixed, and stirred at 110°C for 5 hours. After the reaction was completed, toluene was concentrated, and the solid salt was filtered and then purified by recrystallization, thereby obtaining the target compound D-1 (8.1 g, yield: 54%).
Mass (calcd.: 747.02, found: 747 g/mol)

### [Synthesis Example 26] Synthesis of D-2

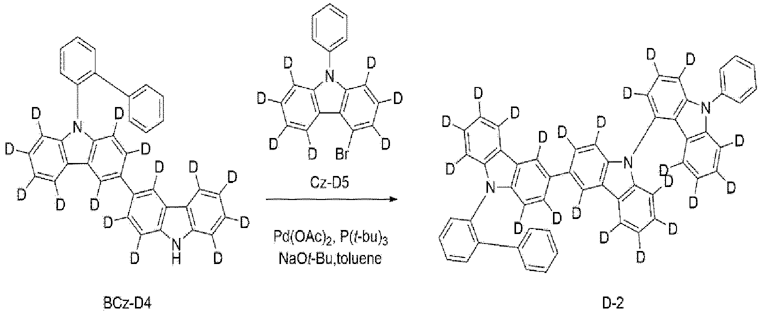

The same procedure as in Synthesis Example 25 was performed except that Cz-D5 (7.9 g, 24.1 mmol) obtained in Preparation Example 2-1 was used instead of Cz-D1 used in Synthesis Example 25, thereby obtaining the target compound D-2 (7.24 g, yield: 41%).
Mass (calcd.: 747.02, found: 747 g/mol)

### [Synthesis Example 27] Synthesis of D-3

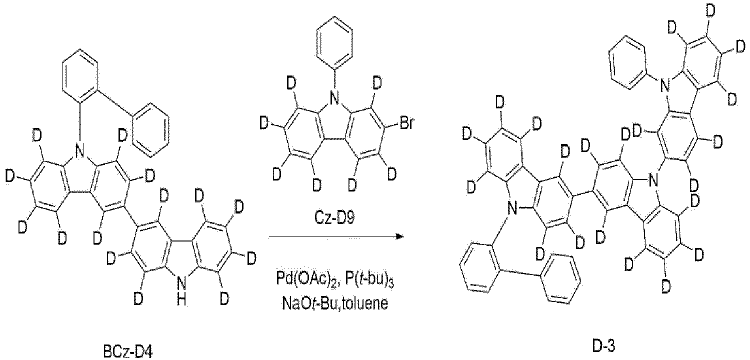

The same procedure as in Synthesis Example 25 was performed except that Cz-D9 (7.9 g, 24.1 mmol) obtained in Preparation Example 3-1 was used instead of Cz-D1 used in Synthesis Example 25, thereby obtaining the target compound D-3 (8.41 g, yield: 51%).
Mass (calcd.: 747.02, found: 747 g/mol)

### [Synthesis Example 28] Synthesis of D-4

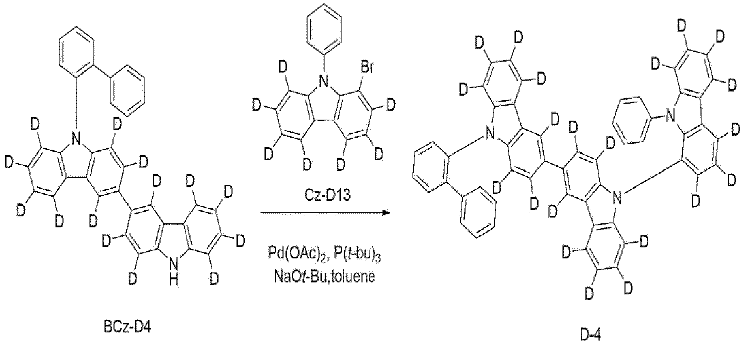

The same procedure as in Synthesis Example 25 was performed except that Cz-D13 (7.9 g, 24.1 mmol) obtained in Preparation Example 4-1 was used instead of Cz-D1 used in Synthesis Example 25, thereby obtaining the target compound D-4 (5.47 g, yield: 31%).
Mass (calcd.: 747.02, found: 747 g/mol)

### [Preparation Example 6] Synethesis of DBF-1

### <Step 1> Synthesis of 4-(3-chlorophenyl)-6-phenyldibenzo[b,d]furan

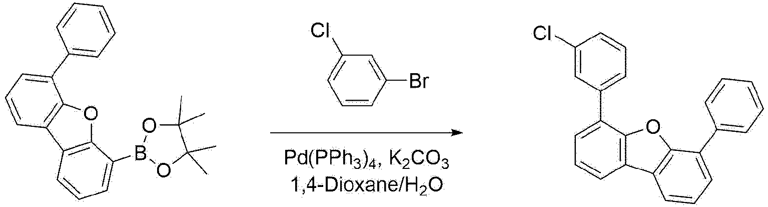

Under a nitrogen atmosphere, 4,4,5,5-tetramethyl-2-(6-phenyldibenzo[b,d]furan-4-yl)-1,3,2-dioxaborolane (100.0 g, 270.0 mmol), 1-bromo-3-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed, and stirred at 120°C for 4 hours.

After the reaction was completed, extraction was conducted with methylene chloride, and filtration was conducted with MgSO₄. Thereafter, the obtained organic layer was subjected to solvent removal, and then purification was performed by column chromatography (hexane:DCM = 9:1 (v/v)), thereby obtaining 4-(3-chlorophenyl)-6-phenyldibenzo[b,d]furan (48.9 g, yield: 51%).
Mass (calcd.: 354.83, found: 354 g/mol)

### <Step 2> Synthesis of DBF-1

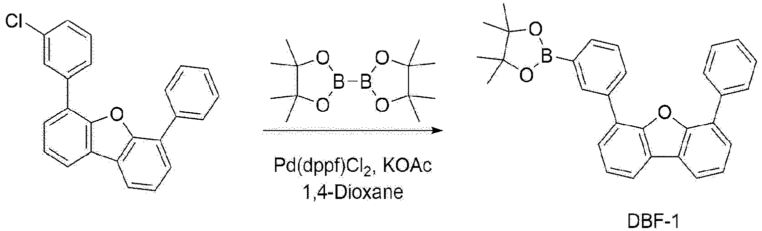

Under a nitrogen atmosphere, 4-(3-chlorophenyl)-6-phenyldibenzo[b,d]furan (48.9 g, 137.7 mmol) obtained in <Step 1>, 4,4,4',4',5,5, 5',5'-octamethyl-2,2'-bi(1,3,2-dioxaborolane) (38.5 g, 151.5 mmol), Pd(dppf)Cl₂ (12.1 g, 13.8 mmol), KOAc (38.9 g, 413.2 mmol), and 1,4-dioxane (1000 ml) were mixed, and stirred at 130°C for 12 hours.

After the reaction was completed, extraction was conducted with ethyl acetate, moisture was removed over MgSO₄, and then purification was performed by column chromatography (hexane:DCM=4:1 (v/v)), thereby obtaining DBF-1 (26.4 g, yield: 43%).
Mass (calcd.: 446.35, found: 446 g/mol)

### [Preparation Example 7] Synthesis of DBF-2

### <Step 1> Synthesis of 4-(4-chlorophenyl)-6-phenyldibenzo[b,d]furan

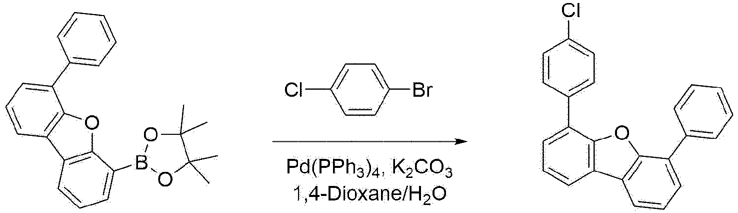

Under a nitrogen atmosphere, 4,4,5,5-tetramethyl-2-(6-phenyldibenzo[b,d]furan-4-yl)-1,3,2-dioxaborolane (100.0 g, 270.0 mmol), 1-bromo-4-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed, and stirred at 120°C for 4 hours.

After the reaction was completed, extraction was conducted with methylene chloride, and filtration was conducted with MgSO₄. Thereafter, the obtained organic layer was subjected to solvent removal, and then purification was performed by column chromatography (hexane:DCM = 9:1 (v/v)), thereby obtaining 4-(4-chlorophenyl)-6-phenyldibenzo[b,d]furan (60.4 g, yield: 63%) .

Mass (calcd.: 354.83, found: 354 g/mol)

### <Step 2> Synthesis of DBF-2

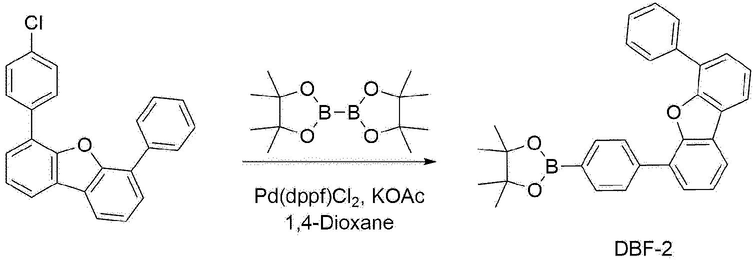

Under a nitrogen atmosphere, 4-(4-chlorophenyl)-6-phenyldibenzo[b,d]furan (60.4 g, 170.2 mmol) obtained in <Step 1>, 4,4,4',4',5,5, 5',5'-octamethyl-2,2'-bi(1,3,2-dioxaborolane) (47.5 g, 187.2 mmol), Pd(dppf)Cl₂ (14.9 g, 17.0 mmol), KOAc (48.1 g, 510.4 mmol), and 1,4-dioxane (1000 ml) were mixed, and stirred at 130°C for 12 hours.

After the reaction was completed, extraction was conducted with ethyl acetate, moisture was removed over MgSO₄, and then purification was performed by column chromatography (hexane:DCM=4:1 (v/v)), thereby obtaining DBF-2 (36.5 g, yield: 48%).
Mass (calcd.: 446.35, found: 446 g/mol)

### [Preparation Example 8] Synthesis of DBF-3

### <Step 1> Synthesis of 3-(3-chlorophenyl)-6-phenyldibenzo[b,d]furan

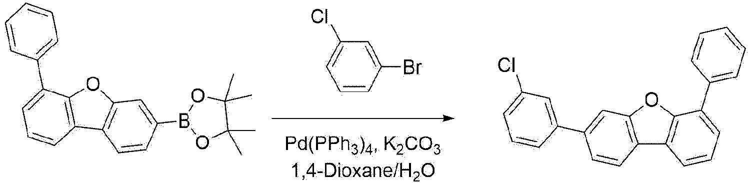

Under a nitrogen atmosphere, 4,4,5,5-tetramethyl-2-(6-phenyldibenzo[b,d]furan-3-yl)-1,3,2-dioxaborolane (100.0 g, 270.0 mmol), 1-bromo-3-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed, and stirred at 120°C for 4 hours.

After the reaction was completed, extraction was conducted with methylene chloride, and filtration was conducted with MgSO₄. Thereafter, the obtained organic layer was subjected to solvent removal, and then purification was performed by column chromatography (hexane:DCM = 9:1 (v/v)), thereby obtaining 3-(3-chlorophenyl)-6-phenyldibenzo[b,d]furan (68.0 g, yield: 71%).

Mass (calcd.: 354.83, found: 354 g/mol)

### <Step 2> Synthesis of DBF-3

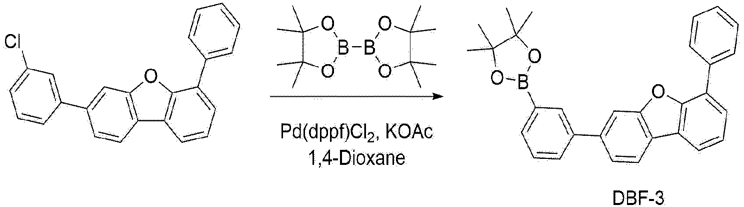

Under a nitrogen atmosphere, 3-(3-chlorophenyl)-6-phenyldibenzo[b,d]furan (68.0 g, 191.8 mmol) obtained in <Step 1>, 4,4,4',4',5,5, 5',5'-octamethyl-2,2'-bi(1,3,2-dioxaborolane) (53.6 g, 210.9 mmol), Pd(dppf)Cl₂ (16.8 g, 19.2 mmol), KOAc (54.2 g, 575.3 mmol), and 1,4-dioxane (1000 ml) were mixed, and stirred at 130°C for 12 hours.

After the reaction was completed, extraction was conducted with ethyl acetate, moisture was removed over MgSO₄, and then purification was performed by column chromatography (hexane:DCM=4:1 (v/v)), thereby obtaining DBF-3 (54.8 g, yield: 64%).
Mass (calcd.: 446.35, found: 446 g/mol)

### [Preparation Example 9] Synthesis of DBF-4

### <Step 1> Synthesis of 1-(3-chlorophenyl)-6-phenyldibenzo[b,d]furan

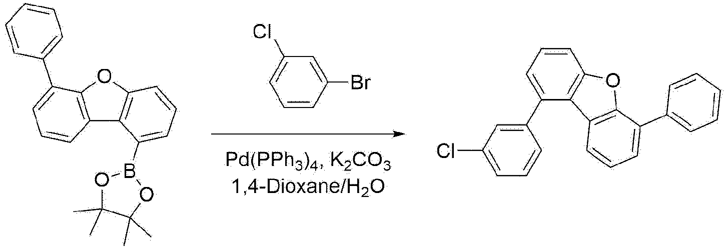

Under a nitrogen atmosphere, 4,4,5,5-tetramethyl-2-(6-phenyldibenzo[b,d]furan-1-yl)-1,3,2-dioxaborolane (100.0 g, 270.0 mmol), 1-bromo-3-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed, and stirred at 120°C for 4 hours.

After the reaction was completed, extraction was conducted with methylene chloride, and filtration was conducted with MgSO₄. Thereafter, the obtained organic layer was subjected to solvent removal, and then purification was performed by column chromatography (hexane:DCM = 9:1 (v/v)), thereby obtaining 1-(3-chlorophenyl)-6-phenyldibenzo[b,d]furan (62.3 g, yield: 65%) .

Mass (calcd.: 354.83, found: 354 g/mol)

### <Step 2> Synthesis of DBF-4

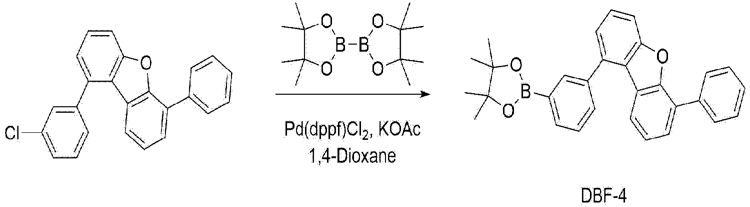

Under a nitrogen atmosphere, 1-(3-chlorophenyl)-6-phenyldibenzo[b,d]furan (62.3 g, 175.6 mmol) obtained in <Step 1>, 4,4,4',4',5,5, 5',5'-octamethyl-2,2'-bi(1,3,2-dioxaborolane) (49.0 g, 193.1 mmol), Pd(dppf)Cl₂ (15.4 g, 17.6 mmol), KOAc (49.6 g, 526.7 mmol), and 1,4-dioxane (1000 ml) were mixed, and stirred at 130°C for 12 hours.

After the reaction was completed, extraction was conducted with ethyl acetate, moisture was removed over MgSO₄, and then purification was performed by column chromatography (hexane:DCM=4:1 (v/v)), thereby obtaining DBF-4 (45.4 g, yield: 58%).
Mass (calcd.: 446.35, found: 446 g/mol)

### [Preparation Example 10] Synthesis of DBF-5

### <Step 1> Synthesis of 1-(3-chlorophenyl)-9-phenyldibenzo[b,d]furan

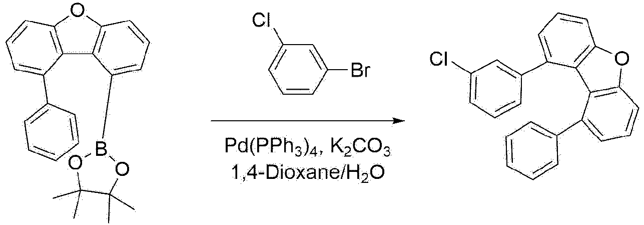

Under a nitrogen atmosphere, 4,4,5,5-tetramethyl-2-(9-phenyldibenzo[b,d]furan-1-yl)-1,3,2-dioxaborolane (100.0 g, 270.0 mmol), 1-bromo-3-chlorobenzene (62.0 g, 324.1 mmol), Pd(PPh₃)₄ (15.6 g, 13.5 mmol), K₂CO₃ (93.3 g, 675.2 mmol), and 1,4-dioxane/H₂O (1000 ml/250 ml) were mixed, and stirred at 120°C for 4 hours.

After the reaction was completed, extraction was conducted with methylene chloride, and filtration was conducted with MgSO₄. Thereafter, the obtained organic layer was subjected to solvent removal, and then purification was performed by column chromatography (hexane:DCM = 9:1 (v/v)), thereby obtaining 1-(3-chlorophenyl)-9-phenyldibenzo[b,d]furan (68.0 g, yield: 71%).

Mass (calcd.: 354.83, found: 354 g/mol)

### <Step 2> Synthesis of DBF-5

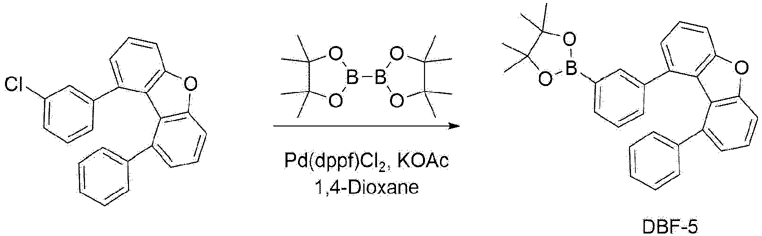

Under a nitrogen atmosphere, 1-(3-chlorophenyl)-9-phenyldibenzo[b,d]furan (68.0 g, 191.8 mmol) obtained in <Step 1>, 4,4,4',4',5,5, 5',5'-octamethyl-2,2'-bi(1,3,2-dioxaborolane) (53.6 g, 210.9 mmol), Pd(dppf)Cl₂ (16.8 g, 19.2 mmol), KOAc (54.2 g, 575.3 mmol), and 1,4-dioxane (1000 ml) were mixed, and stirred at 130°C for 12 hours.

After the reaction was completed, extraction was conducted with ethyl acetate, moisture was removed over MgSO₄, and then purification was performed by column chromatography (hexane:DCM=4:1 (v/v)), thereby obtaining DBF-5 (41.9 g, yield: 49%).
Mass (calcd.: 446.35, found: 446 g/mol)

### [Synthesis Example 29] Synthesis of E-1

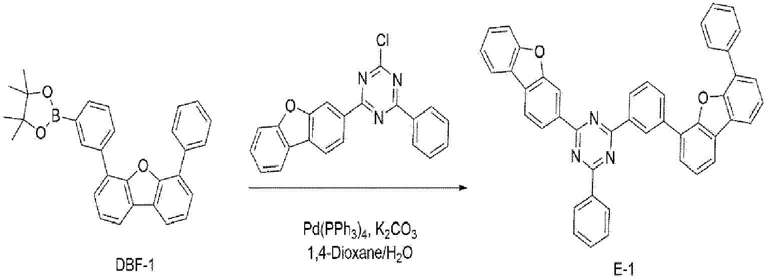

Under a nitrogen atmosphere, DBF-1 (10.0 g, 22.4 mmol) obtained in Preparation Example 6, 2-chloro-4-(dibenzo[b,d]furan-3-yl)-6-phenyl-1,3,5-triazine (9.6 g, 26.9 mmol), Pd(PPh₃)₄ (1.3 g, 1.1 mmol), K₂CO₃ (7.7 g, 56.0 mmol), and 1,4-dioxane/H₂O (1000 ml/250 ml) were mixed, and stirred at 120°C for 4 hours.

After the reaction was completed, extraction was conducted with methylene chloride, and filtration was conducted with MgSO₄. Thereafter, the obtained organic layer was subjected to solvent removal, and then purification was performed by column chromatography (hexane:EA = 4:1 (v/v)), thereby obtaining the target compound E-1 (11.8 g, yield: 82%).
Mass (calcd.: 641.73, found: 641 g/mol)

### [Synthesis Example 30] Synthesis of E-2

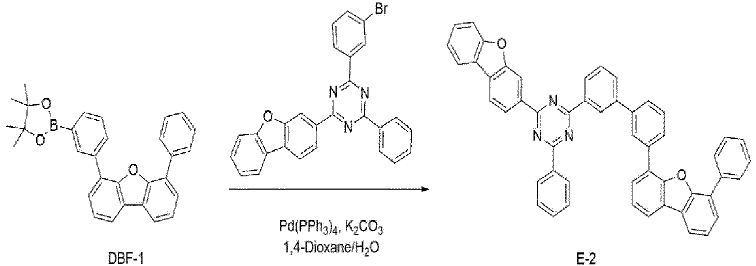

The same procedure as in Synthesis Example 29 was performed except that 2-(3-bromophenyl)-4-(dibenzo[b,d]furan-3-yl)-6-phenyl-1,3,5-triazine (12.9 g, 26.9 mmol) was used instead of 2-chloro-4-(dibenzo[b,d]furan-3-yl)-6-phenyl-1,3,5-triazine used in Synthesis Example 29, thereby obtaining the target compound E-2 (11.9 g, yield: 74%).
Mass (calcd.: 717.83, found: 717 g/mol)

### [Synthesis Example 31] Synthesis of E-3

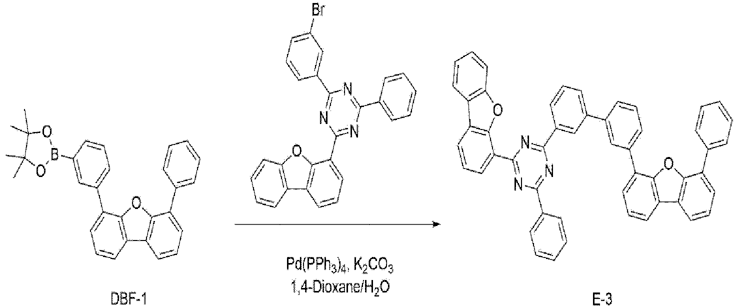

The same procedure as in Synthesis Example 29 was performed except that 2-(3-bromophenyl)-4-(dibenzo[b,d]furan-4-yl)-6-phenyl-1,3,5-triazine (12.9 g, 26.9 mmol) was used instead of 2-chloro-4-(dibenzo[b,d]furan-3-yl)-6-phenyl-1,3,5-triazine used in Synthesis Example 29, thereby obtaining the target compound E-3 (11.4 g, yield: 71%).
Mass (calcd.: 717.83, found: 717 g/mol)

### [Synthesis Example 32] Synthesis of E-4

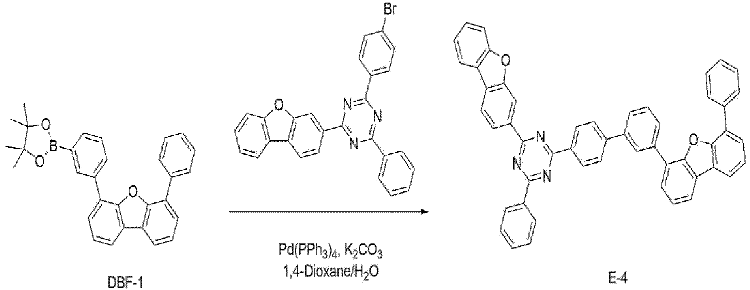

The same procedure as in Synthesis Example 29 was performed except that 2-(4-bromophenyl)-4-(dibenzo[b,d]furan-3-yl)-6-phenyl-1,3,5-triazine (12.9 g, 26.9 mmol) was used instead of 2-chloro-4-(dibenzo[b,d]furan-3-yl)-6-phenyl-1,3,5-triazine used in Synthesis Example 29, thereby obtaining the target compound E-4 (12.7 g, yield: 79%).
Mass (calcd.: 717.83, found: 717 g/mol)

### [Synthesis Example 33] Synthesis of E-5

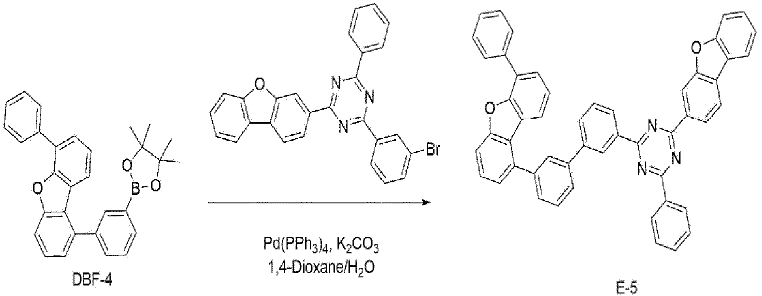

The same procedure as in Synthesis Example 29 was performed except that DBF-4 (10.0 g, 22.4 mmol) obtained in Preparation Example 9 was used instead of DBF-1 (10.0 g, 22.4 mmol) used in Synthesis Example 29 and 2-(3-bromophenyl)-4-(dibenzo[b,d]furan-3-yl)-6-phenyl-1,3,5-triazine (12.9 g, 26.9 mmol) was used instead of 2-chloro-4-(dibenzo[b,d]furan-3-yl)-6-phenyl-1,3,5-triazine, thereby obtaining the target compound E-5 (9.8 g, yield: 61%).
Mass (calcd.: 717.83, found: 717 g/mol)

### [Synthesis Example 34] Synthesis of E-6

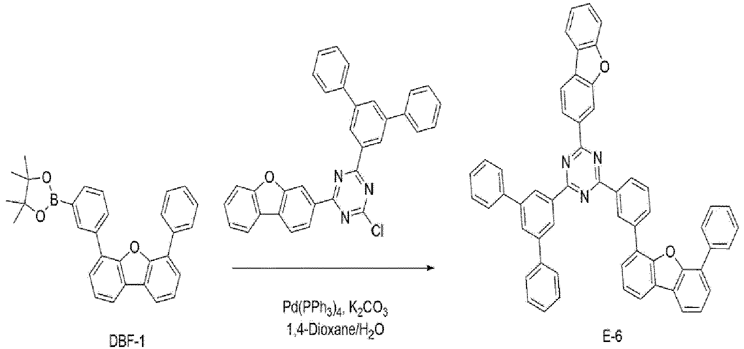

The same procedure as in Synthesis Example 29 was performed except that 2-([1,1':3',1"-terphenyl]-5'-yl)-4-chloro-6-(dibenzo[b,d]furan-3-yl)-1,3,5-triazine (13.7 g, 26.9 mmol) was used instead of 2-chloro-4-(dibenzo[b,d]furan-3-yl)-6-phenyl-1,3,5-triazine used in Synthesis Example 29, thereby obtaining the target compound E-6 (9.6 g, yield: 54%).
Mass (calcd.: 793.93, found: 793 g/mol)

### [Synthesis Example 35] Synthesis of E-7

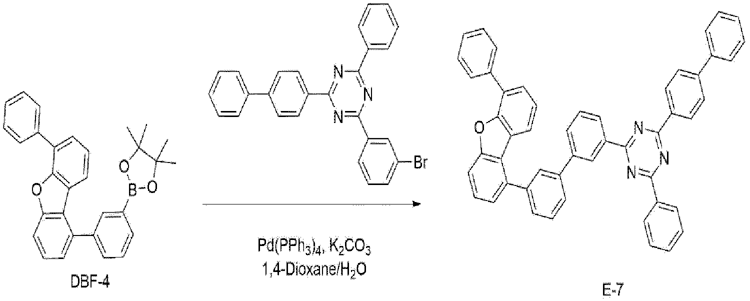

The same procedure as in Synthesis Example 29 was performed except that DBF-4 (10.0 g, 22.4 mmol) obtained in Preparation Example 9 was used instead of DBF-1 (10.0 g, 22.4 mmol) used in Synthesis Example 29 and 2-([1,1'-biphenyl]-4-yl)-4-(3-bromophenyl)-6-phenyl-1,3,5-triazine (12.5 g, 26.9 mmol) was used instead of 2-chloro-4-(dibenzo[b,d]furan-3-yl)-6-phenyl-1,3,5-triazine, thereby obtaining the target compound E-7 (9.8 g, yield: 62%) .
Mass (calcd.: 703.85, found: 703 g/mol)

### [Synthesis Example 36] Synthesis of E-8

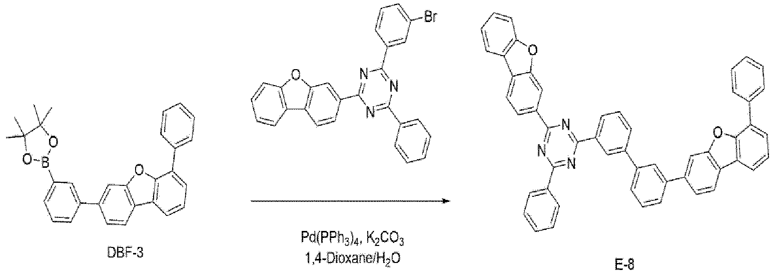

The same procedure as in Synthesis Example 29 was performed except that DBF-3 (10.0 g, 22.4 mmol) obtained in Preparation Example 8 was used instead of DBF-1 (10.0 g, 22.4 mmol) used in Synthesis Example 29 and 2-(3-bromophenyl)-4-(dibenzo[b,d]furan-3-yl)-6-phenyl-1,3,5-triazine (12.9 g, 26.9 mmol) was used instead of 2-chloro-4-(dibenzo[b,d]furan-3-yl)-6-phenyl-1,3,5-triazine, thereby obtaining the target compound E-8 (10.8 g, yield: 67%) .
Mass (calcd.: 717.83, found: 717 g/mol)

### [Synthesis Example 37] Synthesis of E-9

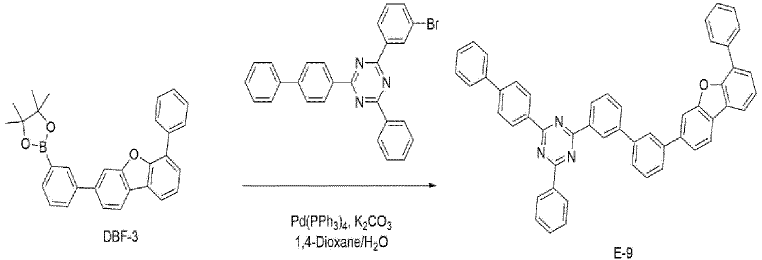

The same procedure as in Synthesis Example 29 was performed except that DBF-3 (10.0 g, 22.4 mmol) obtained in Preparation Example 8 was used instead of DBF-1 (10.0 g, 22.4 mmol) used in Synthesis Example 29 and 2-([1,1'-biphenyl]-4-yl)-4-(3-bromophenyl)-6-phenyl-1,3,5-triazine (12.5 g, 26.9 mmol) was used instead of 2-chloro-4-(dibenzo[b,d]furan-3-yl)-6-phenyl-1,3,5-triazine, thereby obtaining the target compound E-9 (11.4 g, yield: 72%).
Mass (calcd.: 703.85, found: 703 g/mol)

### [Synthesis Example 38] Synthesis of E-10

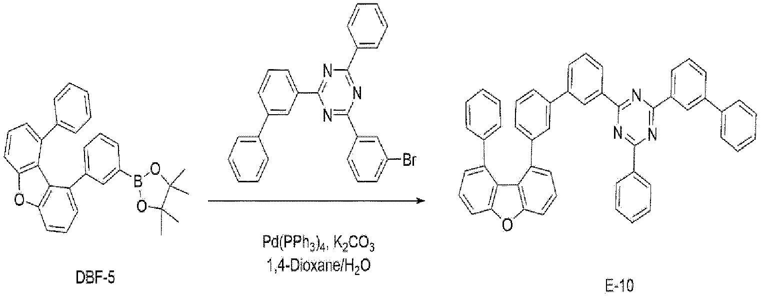

The same procedure as in Synthesis Example 29 was performed except that DBF-5 (10.0 g, 22.4 mmol) obtained in Preparation Example 10 was used instead of DBF-1 (10.0 g, 22.4 mmol) used in Synthesis Example 29 and 2-([1,1'-biphenyl]-3-yl)-4-(3-bromophenyl)-6-phenyl-1,3,5-triazine (12.5 g, 26.9 mmol) was used instead of 2-chloro-4-(dibenzo[b,d]furan-3-yl)-6-phenyl-1,3,5-triazine, thereby obtaining the target compound E-10 (10.4 g, yield: 66%) .
Mass (calcd.: 703.85, found: 703 g/mol)

### [Preparation Example 11] Synthesis of DBF-6

### <Step 1> Synthesis of 4-(3'-chloro-[1,1'-biphenyl]-3-yl-2,2',4,4',5,5',6,6'-d8)-6-(phenyl-d5)dibenzo[b,d]furan-1,2,3,7,8,9-d6

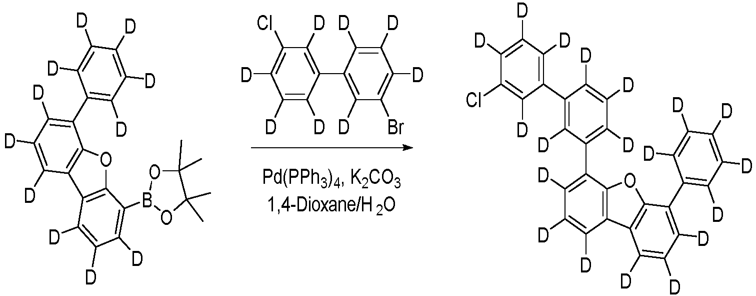

Under a nitrogen atmosphere, 4,4,5,5-tetramethyl-2-(6-(phenyl-d5)dibenzo[b,d]furan-4-yl-1,2,3,7,8,9-d6)-1,3,2-dioxaborolane (100.0 g, 262.2 mmol), 3-bromo-3'-chloro-1,1'-biphenyl-2,2',4,4',5,5',6,6'-d8 (86.7 g, 314.7 mmol), Pd(PPh₃)₄ (15.2 g, 13.1 mmol), K₂CO₃ (90.6 g, 655.6 mmol), and 1,4-dioxane/H₂O (1000 ml/250 ml) were mixed, and stirred at 120°C for 4 hours.

After the reaction was completed, extraction was conducted with methylene chloride, and filtration was conducted with MgSO₄. The obtained organic layer was subjected to solvent removal, and then purification was performed by column chromatography (hexane:DCM = 9:1 (v/v)), thereby obtaining 4-(3'-chloro-[1,1'-biphenyl]-3-yl-2,2',4,4',5,5',6,6'-d8)-6-(phenyl-d5)dibenzo[b,d]furan-1,2,3,7,8,9-d6 (83.8 g, yield: 71%).

Mass (calcd.: 450.05, found: 450 g/mol)

### <Step 2> Synthesis of DBF-6

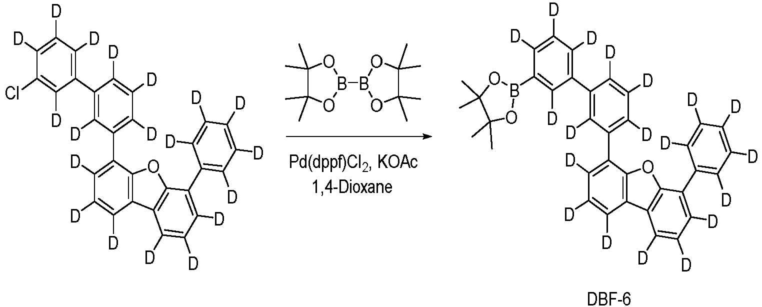

Under a nitrogen atmosphere, 4-(3'-chloro-[1,1'-biphenyl]-3-yl-2,2',4,4',5,5',6,6'-d8)-6-(phenyl-d5)dibenzo[b,d]furan-1,2,3,7,8,9-d6 (83.8 g, 186.2 mmol), 4,4,4',4',5,5, 5',5'-octamethyl-2,2'-bi(1,3,2-dioxaborolane) (52.0 g, 204.8 mmol), Pd(dppf)Cl₂ (16.3 g, 18.6 mmol), KOAc (52.6 g, 558.6 mmol), and 1,4-dioxane (1000 ml) were mixed, and stirred at 130°C for 12 hours.

After the reaction was completed, extraction was conducted with ethyl acetate, moisture was removed over MgSO₄, and then purification was performed by column chromatography (hexane:DCM=4:1 (v/v)), thereby obtaining DBF-6 (64.5 g, yield: 64%).
Mass (calcd.: 541.57, found: 541 g/mol)

### [Synthesis Example 39] Synthesis of E-11

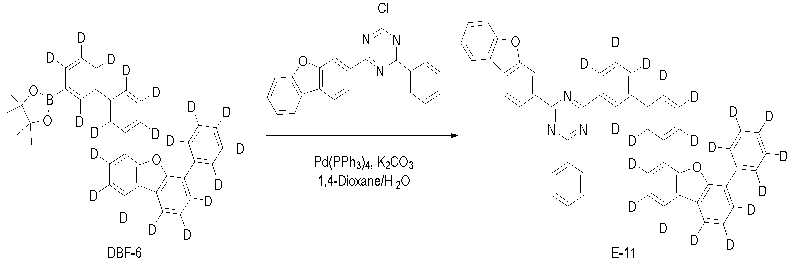

Under a nitrogen atmosphere, DBF-6 (10.0 g, 18.5 mmol) in Preparation Example 11, 2-chloro-4-(dibenzo[b,d]furan-3-yl)-6-phenyl-1,3,5-triazine (7.9 g, 22.2 mmol), Pd(PPh₃)₄ (1.1 g, 0.9 mmol), K₂CO₃ (6.4 g, 46.2 mmol), and 1,4-dioxane/H₂O (1000 ml/250 ml) were mixed, and stirred at 120°C for 4 hours.

After the reaction was completed, extraction was conducted with methylene chloride, and filtration was conducted with MgSO₄. The obtained organic layer was subjected to solvent removal, and then purification was performed by column chromatography (hexane:EA = 4:1 (v/v)), thereby obtaining the target compound E-11 (9.9 g, yield: 73%).
Mass (calcd.: 736.94, found: 736 g/mol)

### [Synthesis Example 40] Synthesis of E-12

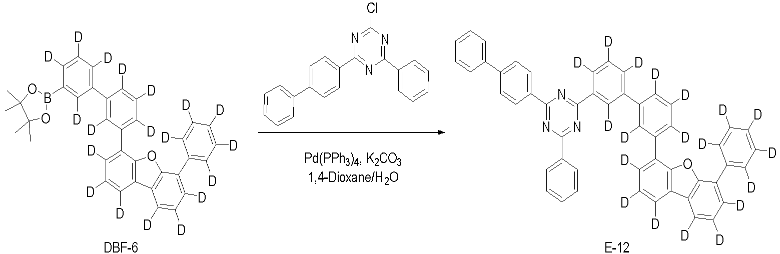

The same procedure as in Synthesis Example 39 was performed except that 2-([1,1'-biphenyl]-4-yl)-4-chloro-6-phenyl-1,3,5-triazine (7.6 g, 22.2 mmol) was used instead of 2-chloro-4-(dibenzo[b,d]furan-3-yl)-6-phenyl-1,3,5-triazine, thereby obtaining the target compound E-12 (10.0 g, yield: 75%).
Mass (calcd.: 722.96, found: 722 g/mol)

### [Synthesis Example 41] Synthesis of E-13

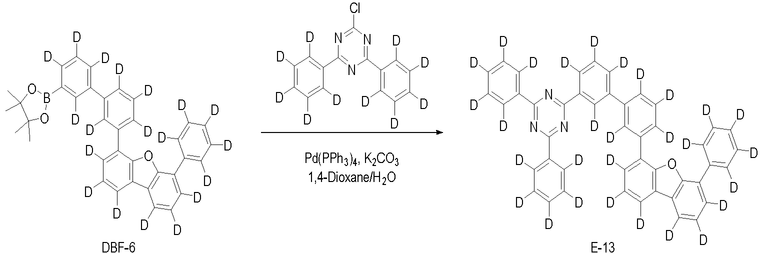

The same procedure as in Synthesis Example 39 was performed except that 2-chloro-4,6-bis(phenyl-d5)-1,3,5-triazine (6.2 g, 22.2 mmol) was used instead of 2-chloro-4-(dibenzo[b,d]furan-3-yl)-6-phenyl-1,3,5-triazine, thereby obtaining the target compound E-13 (9.3 g, yield: 77%).
Mass (calcd.: 656.92, found: 656 g/mol)

### [Example 1] Fabrication of green organic EL element

Compound A-1 synthesized in Synthesis Example 1 and Compound E-1 synthesized in Synthesis Example 29 were subjected to high-purity sublimation purification by a commonly known method, and then a green organic EL element was fabricated as follows.

First, a glass substrate thin-film-coated with indium tin oxide (ITO) to a thickness of 1500 Å was ultrasonically washed with distilled water. After having washed with distilled water, the glass substrate was ultrasonically washed with a solvent, such as isopropyl alcohol, acetone, or methanol, dried, and then transferred to a UV OZONE cleaner (Power sonic 405, Hwashin Tech), and subsequently, the substrate was cleaned for 5 minutes using UV and transferred to a vacuum evaporator.

On the ITO transparent electrode thus prepared, 98 wt% of HT + 2 wt% of PA (100 Å) / HT (1200 Å) / HA (300 Å) / 60 wt% of Compound A-1 + 30 wt% of Compound E-1 + 10 wt% of Ir(ppy)₃ (400 Å) / EA (50 Å) / ET + LiQ (300 Å; a molar ratio of 1:1) / LiF (10 Å) / Al (1000 Å) were laminated in that order, thereby fabricating an organic EL element.

Particularly, the structures of the used HT, PA, HA, EA, ET, and Ir(ppy)₃ are as follows.

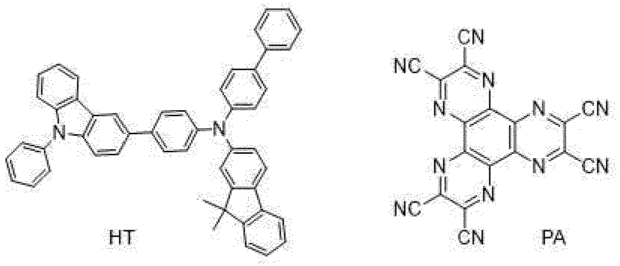

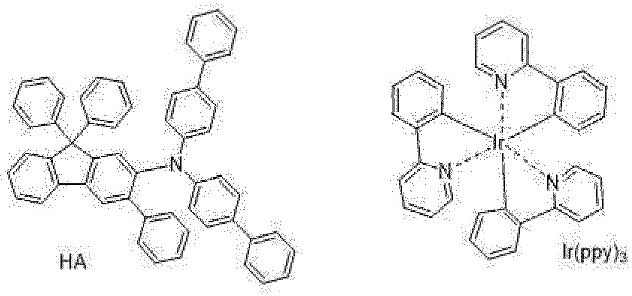

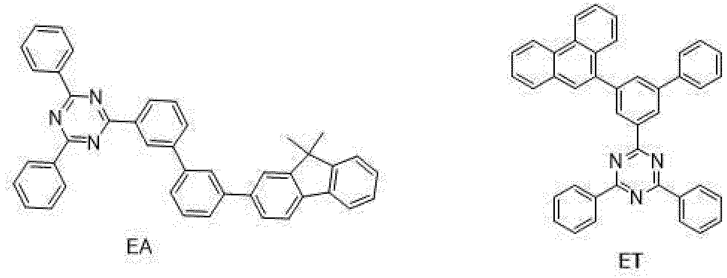

### [Example 2] to [Example 292] Fabrication of green organic EL elements

Green organic EL elements were fabricated by the same method as in Example 1 except that, as for the emissive host materials during the formation of the emissive layer in Example 1, Compounds A-2 to D-4 listed on Table 1 were each used instead of Compound A-1 used as host 1, and Compounds E-2 to E-13 listed on Table 1 were each used instead of Compound E-1 used as host 2.

### [Comparative Example 1] to [Comparative Example 12] Fabrication of green organic EL elements

Green organic EL elements were fabricated by the same method as in Example 1 except that, as for the emissive host materials during the formation of the emissive layer in Example 1, Compounds HT-1 to HT-4 were each used instead of Compound A-1 used as host 1, and Compounds ET-1 to ET-7 were each used instead of Compound E-1 used as host 2. Particularly, the structures of the used Compounds HT-1 to HT-4, and ET-1 to ET-7 are as follows.

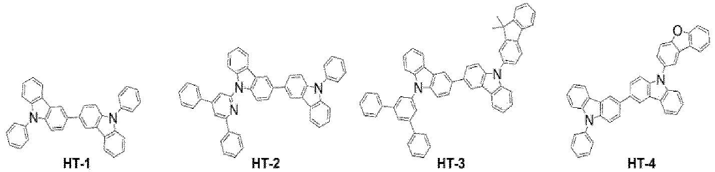

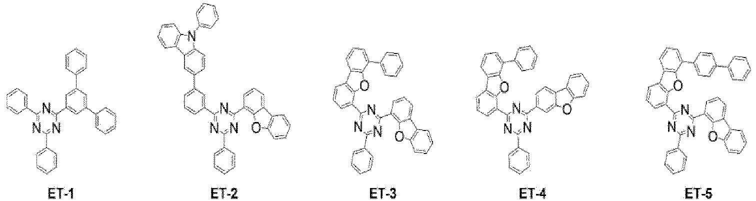

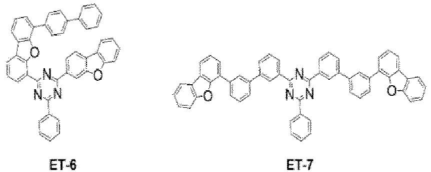

### [Evaluation Example 1]

The green organic EL elements fabricated in Examples 1 to 292 and Comparative Examples 1 to 12 were measured for a driving voltage, a light emission peak, a current efficiency, and lifespan at a current density of 10 mA/cm², and the results are shown in Table 1 below.

**TABLE 1**

| Sample | Host 1 | Host 2 | Driving voltage (V) | EL peak (nm) | Current efficiency (cd/A) | Lifespan (hr, T₉₇) |
|---|---|---|---|---|---|---|
| Example 1 | A-1 | E-1 | 4.56 | 518 | 62.4 | 341 |
| Example 2 | A-1 | E-2 | 4.58 | 518 | 66.2 | 332 |
| Example 3 | A-1 | E-3 | 4.89 | 517 | 63.1 | 322 |
| Example 4 | A-1 | E-4 | 4.56 | 515 | 66.5 | 329 |
| Example 5 | A-1 | E-5 | 4.52 | 516 | 61.8 | 300 |
| Example 6 | A-1 | E-6 | 4.74 | 515 | 60.7 | 310 |
| Example 7 | A-1 | E-7 | 4.48 | 516 | 64.3 | 304 |
| Example 8 | A-1 | E-8 | 4.56 | 516 | 62.3 | 324 |
| Example 9 | A-1 | E-9 | 4.84 | 518 | 64.1 | 315 |
| Example 10 | A-1 | E-10 | 4.45 | 518 | 64.3 | 342 |
| Example 11 | A-2 | E-1 | 4.56 | 515 | 66.5 | 329 |
| Example 12 | A-2 | E-2 | 4.52 | 516 | 61.8 | 300 |
| Example 13 | A-2 | E-3 | 4.74 | 515 | 60.7 | 310 |
| Example 14 | A-2 | E-4 | 4.48 | 516 | 64.3 | 304 |
| Example 15 | A-2 | E-5 | 4.56 | 516 | 62.3 | 324 |
| Example 16 | A-2 | E-6 | 4.84 | 518 | 64.1 | 315 |
| Example 17 | A-2 | E-7 | 4.45 | 518 | 64.3 | 342 |
| Example 18 | A-2 | E-8 | 4.54 | 518 | 62.3 | 321 |
| Example 19 | A-2 | E-9 | 4.65 | 517 | 65.4 | 333 |
| Example 20 | A-2 | E-10 | 4.55 | 515 | 64.2 | 342 |
| Example 21 | A-3 | E-1 | 4.67 | 518 | 66.1 | 351 |
| Example 22 | A-3 | E-2 | 4.54 | 518 | 64.3 | 321 |
| Example 23 | A-3 | E-3 | 4.56 | 517 | 65.1 | 334 |
| Example 24 | A-3 | E-4 | 4.45 | 515 | 61.4 | 331 |
| Example 25 | A-3 | E-5 | 4.52 | 516 | 64.3 | 300 |
| Example 26 | A-3 | E-6 | 4.74 | 516 | 62.3 | 310 |
| Example 27 | A-3 | E-7 | 4.48 | 518 | 64.1 | 304 |
| Example 28 | A-3 | E-8 | 4.56 | 518 | 64.3 | 324 |
| Example 29 | A-3 | E-9 | 4.84 | 518 | 62.3 | 315 |
| Example 30 | A-3 | E-10 | 4.45 | 517 | 65.4 | 342 |
| Example 31 | A-4 | E-1 | 4.54 | 515 | 64.2 | 321 |
| Example 32 | A-4 | E-2 | 4.65 | 518 | 66.1 | 333 |
| Example 33 | A-4 | E-3 | 4.55 | 518 | 64.3 | 342 |
| Example 34 | A-4 | E-4 | 4.67 | 517 | 65.1 | 351 |
| Example 35 | A-4 | E-5 | 4.54 | 515 | 61.4 | 321 |
| Example 36 | A-4 | E-6 | 4.56 | 518 | 62.4 | 334 |
| Example 37 | A-4 | E-7 | 4.45 | 515 | 61.4 | 331 |
| Example 38 | A-4 | E-8 | 4.56 | 518 | 62.4 | 341 |
| Example 39 | A-4 | E-9 | 4.48 | 516 | 64.3 | 304 |
| Example 40 | A-4 | E-10 | 4.81 | 516 | 61.2 | 320 |
| Example 41 | A-5 | E-1 | 4.54 | 515 | 64.2 | 321 |
| Example 42 | A-5 | E-2 | 4.65 | 518 | 66.1 | 333 |
| Example 43 | A-5 | E-3 | 4.55 | 518 | 64.3 | 342 |
| Example 44 | A-5 | E-4 | 4.67 | 517 | 65.1 | 351 |
| Example 45 | A-5 | E-5 | 4.54 | 515 | 61.4 | 321 |
| Example 46 | A-5 | E-6 | 4.56 | 518 | 62.4 | 334 |
| Example 47 | A-5 | E-7 | 4.45 | 515 | 61.4 | 331 |
| Example 48 | A-5 | E-8 | 4.54 | 515 | 61.4 | 321 |
| Example 49 | A-5 | E-9 | 4.56 | 518 | 62.4 | 334 |
| Example 50 | A-5 | E-10 | 4.45 | 515 | 61.4 | 331 |
| Example 51 | A-6 | E-1 | 4.56 | 518 | 62.4 | 341 |
| Example 52 | A-6 | E-2 | 4.48 | 516 | 64.3 | 304 |
| Example 53 | A-6 | E-3 | 4.48 | 516 | 65.1 | 334 |
| Example 54 | A-6 | E-4 | 4.81 | 516 | 61.4 | 331 |
| Example 55 | A-6 | E-5 | 4.54 | 515 | 64.3 | 300 |
| Example 56 | A-6 | E-6 | 4.65 | 518 | 62.3 | 310 |
| Example 57 | A-6 | E-7 | 4.55 | 518 | 64.1 | 304 |
| Example 58 | A-6 | E-8 | 4.67 | 517 | 64.3 | 324 |
| Example 59 | A-6 | E-9 | 4.54 | 515 | 62.3 | 315 |
| Example 60 | A-6 | E-10 | 4.45 | 517 | 65.4 | 342 |
| Example 61 | A-7 | E-1 | 4.54 | 518 | 62.4 | 341 |
| Example 62 | A-7 | E-2 | 4.65 | 516 | 64.3 | 304 |
| Example 63 | A-7 | E-3 | 4.55 | 516 | 61.2 | 320 |
| Example 64 | A-7 | E-4 | 4.67 | 515 | 64.2 | 321 |
| Example 65 | A-7 | E-5 | 4.54 | 518 | 66.1 | 333 |
| Example 66 | A-7 | E-6 | 4.56 | 518 | 64.3 | 342 |
| Example 67 | A-7 | E-7 | 4.54 | 515 | 64.2 | 321 |
| Example 68 | A-7 | E-8 | 4.65 | 518 | 66.1 | 333 |
| Example 69 | A-7 | E-9 | 4.55 | 518 | 64.3 | 342 |
| Example 70 | A-7 | E-10 | 4.67 | 517 | 65.1 | 351 |
| Example 71 | A-8 | E-1 | 4.54 | 515 | 61.4 | 321 |
| Example 72 | A-8 | E-2 | 4.56 | 518 | 62.4 | 334 |
| Example 73 | A-8 | E-3 | 4.45 | 515 | 61.4 | 331 |
| Example 74 | A-8 | E-4 | 4.56 | 518 | 62.4 | 341 |
| Example 75 | A-8 | E-5 | 4.48 | 516 | 64.3 | 304 |
| Example 76 | A-8 | E-6 | 4.81 | 516 | 61.2 | 320 |
| Example 77 | A-8 | E-7 | 4.54 | 515 | 64.2 | 321 |
| Example 78 | A-8 | E-8 | 4.65 | 518 | 66.1 | 333 |
| Example 79 | A-8 | E-9 | 4.55 | 518 | 64.3 | 342 |
| Example 80 | A-8 | E-10 | 4.81 | 516 | 61.2 | 320 |
| Example 81 | A-9 | E-1 | 4.56 | 518 | 62.4 | 341 |
| Example 82 | A-9 | E-2 | 4.58 | 518 | 66.2 | 332 |
| Example 83 | A-9 | E-3 | 4.89 | 517 | 63.1 | 322 |
| Example 84 | A-9 | E-4 | 4.56 | 515 | 66.5 | 329 |
| Example 85 | A-9 | E-5 | 4.52 | 516 | 61.8 | 300 |
| Example 86 | A-9 | E-6 | 4.74 | 515 | 60.7 | 310 |
| Example 87 | A-9 | E-7 | 4.48 | 516 | 64.3 | 304 |
| Example 88 | A-9 | E-8 | 4.56 | 516 | 62.3 | 324 |
| Example 89 | A-9 | E-9 | 4.84 | 518 | 64.1 | 315 |
| Example 90 | A-9 | E-10 | 4.45 | 518 | 64.3 | 342 |
| Example 91 | A-10 | E-1 | 4.56 | 515 | 66.5 | 329 |
| Example 92 | A-10 | E-2 | 4.52 | 516 | 61.8 | 300 |
| Example 93 | A-10 | E-3 | 4.74 | 515 | 60.7 | 310 |
| Example 94 | A-10 | E-4 | 4.48 | 516 | 64.3 | 304 |
| Example 95 | A-10 | E-5 | 4.56 | 516 | 62.3 | 324 |
| Example 96 | A-10 | E-6 | 4.84 | 518 | 64.1 | 315 |
| Example 97 | A-10 | E-7 | 4.45 | 518 | 64.3 | 342 |
| Example 98 | A-10 | E-8 | 4.54 | 518 | 62.3 | 321 |
| Example 99 | A-10 | E-9 | 4.65 | 517 | 65.4 | 333 |
| Example 100 | A-10 | E-10 | 4.55 | 515 | 64.2 | 342 |
| Example 101 | A-11 | E-1 | 4.67 | 518 | 66.1 | 351 |
| Example 102 | A-11 | E-2 | 4.54 | 518 | 64.3 | 321 |
| Example 103 | A-11 | E-3 | 4.56 | 517 | 65.1 | 334 |
| Example 104 | A-11 | E-4 | 4.45 | 515 | 61.4 | 331 |
| Example 105 | A-11 | E-5 | 4.52 | 516 | 64.3 | 300 |
| Example 106 | A-11 | E-6 | 4.74 | 516 | 62.3 | 310 |
| Example 107 | A-11 | E-7 | 4.48 | 518 | 64.1 | 304 |
| Example 108 | A-11 | E-8 | 4.56 | 518 | 64.3 | 324 |
| Example 109 | A-11 | E-9 | 4.84 | 518 | 62.3 | 315 |
| Example 110 | A-11 | E-10 | 4.45 | 517 | 65.4 | 342 |
| Example 111 | A-12 | E-1 | 4.54 | 515 | 64.2 | 321 |
| Example 112 | A-12 | E-2 | 4.65 | 518 | 66.1 | 333 |
| Example 113 | A-12 | E-3 | 4.55 | 518 | 64.3 | 342 |
| Example 114 | A-12 | E-4 | 4.67 | 517 | 65.1 | 351 |
| Example 115 | A-12 | E-5 | 4.54 | 515 | 61.4 | 321 |
| Example 116 | A-12 | E-6 | 4.56 | 518 | 62.4 | 334 |
| Example 117 | A-12 | E-7 | 4.45 | 515 | 61.4 | 331 |
| Example 118 | A-12 | E-8 | 4.56 | 518 | 62.4 | 341 |
| Example 119 | A-12 | E-9 | 4.48 | 516 | 64.3 | 304 |
| Example 120 | A-12 | E-10 | 4.81 | 516 | 61.2 | 320 |
| Example 121 | A-13 | E-1 | 4.54 | 515 | 64.2 | 321 |
| Example 122 | A-13 | E-2 | 4.65 | 518 | 66.1 | 333 |
| Example 123 | A-13 | E-3 | 4.55 | 518 | 64.3 | 342 |
| Example 124 | A-13 | E-4 | 4.67 | 517 | 65.1 | 351 |
| Example 125 | A-13 | E-5 | 4.54 | 515 | 61.4 | 321 |
| Example 126 | A-13 | E-6 | 4.56 | 518 | 62.4 | 334 |
| Example 127 | A-13 | E-7 | 4.45 | 516 | 64.3 | 304 |
| Example 128 | A-13 | E-8 | 4.54 | 516 | 61.2 | 320 |
| Example 129 | A-13 | E-9 | 4.56 | 515 | 64.2 | 321 |
| Example 130 | A-13 | E-10 | 4.45 | 518 | 66.1 | 333 |
| Example 131 | A-14 | E-1 | 4.56 | 518 | 64.3 | 342 |
| Example 132 | A-14 | E-2 | 4.48 | 515 | 64.2 | 321 |
| Example 133 | A-14 | E-3 | 4.48 | 518 | 66.1 | 333 |
| Example 134 | A-14 | E-4 | 4.81 | 518 | 64.3 | 342 |
| Example 135 | A-14 | E-5 | 4.54 | 517 | 65.1 | 351 |
| Example 136 | A-14 | E-6 | 4.65 | 515 | 61.4 | 321 |
| Example 137 | A-14 | E-7 | 4.55 | 518 | 62.4 | 334 |
| Example 138 | A-14 | E-8 | 4.67 | 515 | 61.4 | 331 |
| Example 139 | A-14 | E-9 | 4.54 | 518 | 62.4 | 341 |
| Example 140 | A-14 | E-10 | 4.45 | 516 | 64.3 | 304 |
| Example 141 | A-15 | E-1 | 4.54 | 516 | 61.2 | 320 |
| Example 142 | A-15 | E-2 | 4.65 | 515 | 64.2 | 321 |
| Example 143 | A-15 | E-3 | 4.55 | 518 | 66.1 | 333 |
| Example 144 | A-15 | E-4 | 4.67 | 518 | 64.3 | 342 |
| Example 145 | A-15 | E-5 | 4.54 | 516 | 61.2 | 320 |
| Example 146 | A-15 | E-6 | 4.56 | 518 | 62.4 | 341 |
| Example 147 | A-15 | E-7 | 4.54 | 518 | 66.2 | 332 |
| Example 148 | A-15 | E-8 | 4.65 | 517 | 63.1 | 322 |
| Example 149 | A-15 | E-9 | 4.55 | 515 | 66.5 | 329 |
| Example 150 | A-15 | E-10 | 4.67 | 516 | 61.8 | 300 |
| Example 151 | A-16 | E-1 | 4.54 | 515 | 60.7 | 310 |
| Example 152 | A-16 | E-2 | 4.56 | 516 | 64.3 | 304 |
| Example 153 | A-16 | E-3 | 4.45 | 516 | 62.3 | 324 |
| Example 154 | A-16 | E-4 | 4.56 | 518 | 62.4 | 341 |
| Example 155 | A-16 | E-5 | 4.48 | 516 | 64.3 | 304 |
| Example 156 | A-16 | E-6 | 4.81 | 516 | 61.2 | 320 |
| Example 157 | A-16 | E-7 | 4.54 | 515 | 64.2 | 321 |
| Example 158 | A-16 | E-8 | 4.65 | 518 | 66.1 | 333 |
| Example 159 | A-16 | E-9 | 4.55 | 518 | 64.3 | 342 |
| Example 160 | A-16 | E-10 | 4.67 | 517 | 65.1 | 351 |
| Example 161 | B-1 | E-1 | 4.54 | 515 | 64.2 | 321 |
| Example 162 | B-1 | E-2 | 4.65 | 518 | 66.1 | 333 |
| Example 163 | B-1 | E-3 | 4.55 | 518 | 64.3 | 342 |
| Example 164 | B-1 | E-4 | 4.67 | 517 | 65.1 | 351 |
| Example 165 | B-1 | E-5 | 4.54 | 515 | 61.4 | 321 |
| Example 166 | B-1 | E-6 | 4.56 | 518 | 62.4 | 334 |
| Example 167 | B-1 | E-7 | 4.45 | 516 | 64.3 | 304 |
| Example 168 | B-1 | E-8 | 4.54 | 516 | 61.2 | 320 |
| Example 169 | B-1 | E-9 | 4.56 | 515 | 64.2 | 321 |
| Example 170 | B-1 | E-10 | 4.45 | 518 | 66.1 | 333 |
| Example 171 | B-2 | E-1 | 4.55 | 518 | 64.3 | 342 |
| Example 172 | B-2 | E-2 | 4.67 | 517 | 65.1 | 351 |
| Example 173 | B-2 | E-3 | 4.54 | 515 | 61.4 | 321 |
| Example 174 | B-2 | E-4 | 4.56 | 518 | 62.4 | 334 |
| Example 175 | B-2 | E-5 | 4.45 | 516 | 64.3 | 304 |
| Example 176 | B-2 | E-6 | 4.54 | 516 | 61.2 | 320 |
| Example 177 | B-2 | E-7 | 4.56 | 515 | 64.2 | 321 |
| Example 178 | B-2 | E-8 | 4.45 | 518 | 66.1 | 333 |
| Example 179 | B-2 | E-9 | 4.56 | 518 | 64.3 | 342 |
| Example 180 | B-2 | E-10 | 4.48 | 515 | 64.2 | 321 |
| Example 181 | B-3 | E-1 | 4.48 | 518 | 66.1 | 333 |
| Example 182 | B-3 | E-2 | 4.81 | 518 | 64.3 | 342 |
| Example 183 | B-3 | E-3 | 4.54 | 517 | 65.1 | 351 |
| Example 184 | B-3 | E-4 | 4.65 | 515 | 61.4 | 321 |
| Example 185 | B-3 | E-5 | 4.55 | 518 | 62.4 | 334 |
| Example 186 | B-3 | E-6 | 4.67 | 515 | 61.4 | 331 |
| Example 187 | B-3 | E-7 | 4.54 | 518 | 62.4 | 341 |
| Example 188 | B-3 | E-8 | 4.45 | 516 | 64.3 | 304 |
| Example 189 | B-3 | E-9 | 4.54 | 516 | 61.2 | 320 |
| Example 190 | B-3 | E-10 | 4.65 | 515 | 64.2 | 321 |
| Example 191 | B-4 | E-1 | 4.55 | 518 | 66.1 | 333 |
| Example 192 | B-4 | E-2 | 4.67 | 518 | 64.3 | 342 |
| Example 193 | B-4 | E-3 | 4.54 | 516 | 61.2 | 320 |
| Example 194 | B-4 | E-4 | 4.56 | 518 | 62.4 | 341 |
| Example 195 | B-4 | E-5 | 4.54 | 518 | 66.2 | 332 |
| Example 196 | B-4 | E-6 | 4.65 | 517 | 63.1 | 322 |
| Example 197 | B-4 | E-7 | 4.55 | 515 | 66.5 | 329 |
| Example 198 | B-4 | E-8 | 4.67 | 516 | 61.8 | 300 |
| Example 199 | B-4 | E-9 | 4.54 | 515 | 60.7 | 310 |
| Example 200 | B-4 | E-10 | 4.67 | 517 | 65.1 | 351 |
| Example 201 | C-1 | E-1 | 4.54 | 515 | 64.2 | 321 |
| Example 202 | C-1 | E-2 | 4.65 | 518 | 66.1 | 333 |
| Example 203 | C-1 | E-3 | 4.55 | 518 | 64.3 | 342 |
| Example 204 | C-1 | E-4 | 4.67 | 517 | 65.1 | 351 |
| Example 205 | C-1 | E-5 | 4.54 | 515 | 61.4 | 321 |
| Example 206 | C-1 | E-6 | 4.56 | 518 | 62.4 | 334 |
| Example 207 | C-1 | E-7 | 4.45 | 516 | 64.3 | 304 |
| Example 208 | C-1 | E-8 | 4.54 | 516 | 61.2 | 320 |
| Example 209 | C-1 | E-9 | 4.56 | 515 | 64.2 | 321 |
| Example 210 | C-1 | E-10 | 4.45 | 518 | 66.1 | 333 |
| Example 211 | C-2 | E-1 | 4.55 | 518 | 64.3 | 342 |
| Example 212 | C-2 | E-2 | 4.67 | 517 | 65.1 | 351 |
| Example 213 | C-2 | E-3 | 4.54 | 515 | 61.4 | 321 |
| Example 214 | C-2 | E-4 | 4.56 | 518 | 62.4 | 334 |
| Example 215 | C-2 | E-5 | 4.45 | 516 | 64.3 | 304 |
| Example 216 | C-2 | E-6 | 4.54 | 516 | 61.2 | 320 |
| Example 217 | C-2 | E-7 | 4.56 | 515 | 64.2 | 321 |
| Example 218 | C-2 | E-8 | 4.45 | 518 | 66.1 | 333 |
| Example 219 | C-2 | E-9 | 4.56 | 518 | 64.3 | 342 |
| Example 220 | C-2 | E-10 | 4.48 | 515 | 64.2 | 321 |
| Example 221 | C-3 | E-1 | 4.48 | 518 | 66.1 | 333 |
| Example 222 | C-3 | E-2 | 4.81 | 518 | 64.3 | 342 |
| Example 223 | C-3 | E-3 | 4.54 | 517 | 65.1 | 351 |
| Example 224 | C-3 | E-4 | 4.65 | 515 | 61.4 | 321 |
| Example 225 | C-3 | E-5 | 4.55 | 518 | 62.4 | 334 |
| Example 226 | C-3 | E-6 | 4.67 | 515 | 61.4 | 331 |
| Example 227 | C-3 | E-7 | 4.54 | 518 | 62.4 | 341 |
| Example 228 | C-3 | E-8 | 4.45 | 516 | 64.3 | 304 |
| Example 229 | C-3 | E-9 | 4.54 | 516 | 61.2 | 320 |
| Example 230 | C-3 | E-10 | 4.65 | 515 | 64.2 | 321 |
| Example 231 | C-4 | E-1 | 4.55 | 518 | 66.1 | 333 |
| Example 232 | C-4 | E-2 | 4.67 | 518 | 64.3 | 342 |
| Example 233 | C-4 | E-3 | 4.54 | 516 | 61.2 | 320 |
| Example 234 | C-4 | E-4 | 4.56 | 518 | 62.4 | 341 |
| Example 235 | C-4 | E-5 | 4.54 | 518 | 66.2 | 332 |
| Example 236 | C-4 | E-6 | 4.65 | 517 | 63.1 | 322 |
| Example 237 | C-4 | E-7 | 4.55 | 515 | 66.5 | 329 |
| Example 238 | C-4 | E-8 | 4.67 | 516 | 61.8 | 300 |
| Example 239 | C-4 | E-9 | 4.54 | 515 | 60.7 | 310 |
| Example 240 | C-4 | E-10 | 4.67 | 517 | 65.1 | 351 |
| Example 241 | D-1 | E-1 | 4.54 | 515 | 64.2 | 321 |
| Example 242 | D-1 | E-2 | 4.65 | 518 | 66.1 | 333 |
| Example 243 | D-1 | E-3 | 4.55 | 518 | 64.3 | 342 |
| Example 244 | D-1 | E-4 | 4.67 | 517 | 65.1 | 351 |
| Example 245 | D-1 | E-5 | 4.54 | 515 | 61.4 | 321 |
| Example 246 | D-1 | E-6 | 4.56 | 518 | 62.4 | 334 |
| Example 247 | D-1 | E-7 | 4.45 | 516 | 64.3 | 304 |
| Example 248 | D-1 | E-8 | 4.54 | 516 | 61.2 | 320 |
| Example 249 | D-1 | E-9 | 4.56 | 515 | 61.4 | 321 |
| Example 250 | D-1 | E-10 | 4.45 | 518 | 62.4 | 334 |
| Example 251 | D-2 | E-1 | 4.55 | 516 | 64.3 | 304 |
| Example 252 | D-2 | E-2 | 4.67 | 516 | 61.2 | 320 |
| Example 253 | D-2 | E-3 | 4.54 | 515 | 64.2 | 321 |
| Example 254 | D-2 | E-4 | 4.56 | 518 | 66.1 | 333 |
| Example 255 | D-2 | E-5 | 4.45 | 518 | 64.3 | 342 |
| Example 256 | D-2 | E-6 | 4.54 | 517 | 65.1 | 351 |
| Example 257 | D-2 | E-7 | 4.56 | 515 | 61.4 | 321 |
| Example 258 | D-2 | E-8 | 4.45 | 518 | 62.4 | 334 |
| Example 259 | D-2 | E-9 | 4.54 | 515 | 64.3 | 304 |
| Example 260 | D-2 | E-10 | 4.65 | 518 | 61.2 | 320 |
| Example 261 | D-3 | E-1 | 4.55 | 518 | 64.2 | 321 |
| Example 262 | D-3 | E-2 | 4.67 | 517 | 66.1 | 333 |
| Example 263 | D-3 | E-3 | 4.54 | 515 | 64.3 | 342 |
| Example 264 | D-3 | E-4 | 4.56 | 518 | 64.2 | 321 |
| Example 265 | D-3 | E-5 | 4.45 | 516 | 66.1 | 333 |
| Example 266 | D-3 | E-6 | 4.54 | 516 | 64.3 | 342 |
| Example 267 | D-3 | E-7 | 4.56 | 515 | 65.1 | 351 |
| Example 268 | D-3 | E-8 | 4.45 | 518 | 61.4 | 321 |
| Example 269 | D-3 | E-9 | 4.55 | 518 | 62.4 | 334 |
| Example 270 | D-3 | E-10 | 4.67 | 517 | 61.4 | 331 |
| Example 271 | D-4 | E-1 | 4.54 | 515 | 62.4 | 341 |
| Example 272 | D-4 | E-2 | 4.56 | 518 | 64.3 | 304 |
| Example 273 | D-4 | E-3 | 4.45 | 516 | 61.2 | 320 |
| Example 274 | D-4 | E-4 | 4.54 | 516 | 64.2 | 321 |
| Example 275 | D-4 | E-5 | 4.56 | 515 | 66.1 | 333 |
| Example 276 | D-4 | E-6 | 4.45 | 518 | 64.3 | 342 |
| Example 277 | D-4 | E-7 | 4.56 | 518 | 61.2 | 320 |
| Example 278 | D-4 | E-8 | 4.48 | 515 | 62.4 | 341 |
| Example 279 | D-4 | E-9 | 4.54 | 518 | 66.2 | 332 |
| Example 280 | D-4 | E-10 | 4.67 | 517 | 63.1 | 322 |
| Example 281 | A-1 | E-11 | 4.32 | 515 | 70.1 | 420 |
| Example 282 | A-2 | E-11 | 4.38 | 516 | 69.8 | 410 |
| Example 283 | A-3 | E-11 | 4.37 | 515 | 68.2 | 411 |
| Example 284 | A-4 | E-11 | 4.33 | 517 | 67.4 | 413 |
| Example 285 | A-1 | E-12 | 4.39 | 517 | 67.5 | 404 |
| Example 286 | A-2 | E-12 | 4.41 | 515 | 68.2 | 402 |
| Example 287 | A-3 | E-12 | 4.33 | 516 | 68.4 | 409 |
| Example 288 | A-4 | E-12 | 4.35 | 516 | 68.3 | 411 |
| Example 289 | A-1 | E-13 | 4.38 | 516 | 68. 9 | 411 |
| Example 290 | A-2 | E-13 | 4.33 | 515 | 68.8 | 413 |
| Example 291 | A-3 | E-13 | 4.35 | 515 | 68.4 | 403 |
| Example 292 | A-4 | E-13 | 4.34 | 516 | 69.4 | 415 |
| Comparative Example 1 | HT-1 | ET-1 | 6.01 | 517 | 45.3 | 250 |
| Comparative Example 2 | HT-1 | E-2 | 6.11 | 515 | 53.2 | 180 |
| Comparative Example 3 | HT-2 | E-3 | 6.52 | 512 | 54.1 | 187 |
| Comparative Example 4 | HT-3 | E-8 | 6.03 | 516 | 52.1 | 189 |
| Comparative Example 5 | HT-4 | E-9 | 6.41 | 517 | 53.3 | 191 |
| Comparative Example 6 | A-2 | ET-1 | 5.23 | 515 | 45.6 | 230 |
| Comparative Example 7 | A-5 | ET-2 | 5.02 | 517 | 48.3 | 223 |
| Comparative Example 8 | A-8 | ET-3 | 5.55 | 516 | 48.8 | 251 |
| Comparative Example 9 | B-1 | ET-4 | 5.21 | 518 | 43.2 | 233 |
| Comparative Example 10 | B-2 | ET-5 | 5.34 | 520 | 42.3 | 233 |
| Comparative Example 11 | C-2 | ET-6 | 5.42 | 516 | 46.4 | 221 |
| Comparative Example 12 | D-3 | ET-7 | 5.31 | 513 | 45.8 | 235 |

As shown in Table 1, the green organic EL elements of Examples 1 to 292 containing, as host materials of the emissive layer, both the compounds (A-1 to D-4) of Chemical Formula 1, corresponding host 1 (P-type host) and the compounds (E-1 to E-13) of Chemical Formula 2, corresponding host 2 (N-type host) according to the present disclosure, exhibited superb performance in view of current efficiency, driving voltage, lifespan characteristics, as compared to the green organic EL elements of Comparative Examples 1 to 12 using both HT-1 to HT-4 and ET-1 to ET-7, corresponding to conventional host materials.

Additionally, the green organic EL elements of Examples 281 to 292 containing the deuterium-substituted compounds (E-11 to E-13) as host 2 (N-type host) exhibited superb performance in view of current efficiency, driving voltage, lifespan characteristics, as compared to the green organic EL elements of Examples 1 to 280 containing the deuterium-unsubstituted compounds (E-1 to E-10) as host 2 (N-type host). The reason is that the stability of a single molecule itself was further improved by applying the C-D bond having a higher dissociation energy than the C-H bond in the form of deuterium substitution to N-type host, corresponding a material having electron properties in the element. That is, it was confirmed that under the same structure, the deuterium-substituted compounds (e.g., E-11 to E-13) can form relatively more excitons than the deuterium-unsubstituted compounds (e.g., E-1 to E-10), leading to a reduction in thermal denaturation caused by the formation of excitons.

## Claims

1. A composition for an organic electroluminescent element, the composition comprising a first host represented by Chemical Formula 1 below and a second host represented by Chemical Formula 2 below: 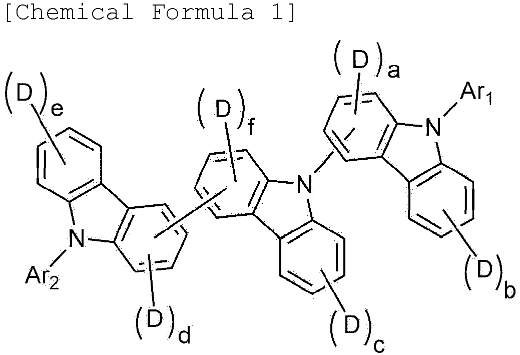 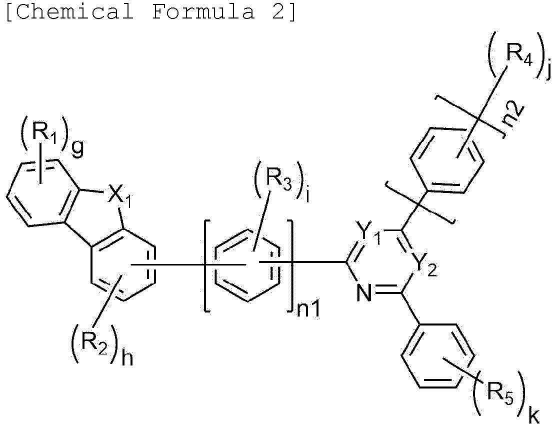 (where, in Chemical Formulas 1 and 2,
D is deuterium;
a, d, f, and h are each an integer of 0 to 3;
b, c, e, g, and i are each an integer of 0 to 4;
j and k are each an integer of 0 to 5;
n1 is an integer of 1 to 5;
n2 is an integer of 0 or 1;
X₁ is selected from the group consisting of O, S, Se, N(Ar₃), C (Ar₄)(Ar₅), and Si(Ar₆)(Ar₇) ;
Y₁ and Y₂ are the same or different from each other and are each independently N or C(Ar₈), provided that at least one of Y₁ and Y₂ is N;
Ar₁ to Ar₈ and R₁ to R₅ are the same or different from each other and are each independently selected from the group consisting of hydrogen, deuterium (D), a halogen group, a cyano group, a nitro group, an amino group, a C₁ to C₄₀ alkyl group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a phosphine oxide group, a C₁ to C₄₀ alkylphosphine oxide group, a C₆ to C₆₀ arylphosphine group, a C₆ to C₆₀ arylphosphine oxide group, and a C₆ to C₆₀ arylamine group, or these groups may form a condensed ring together with an adjacent group; and
the alkyl group, alkenyl group, alkynyl group, cycloalkyl group, heterocycloalkyl group, aryl group, heteroaryl group, alkyloxy group, aryloxy group, alkylsilyl group, arylsilyl group, alkylboron group, arylboron group, alkylphosphine oxide group, arylphosphine group, arylphosphine oxide group, arylamine group, and condensed ring of Ar₁ to Ar₈ and R₁ to R₅ are each independently substituted or unsubstituted with at least one substituent selected from the group consisting of deuterium, a halogen, a cyano group, a nitro group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₁ to C₄₀ alkyl group, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a C₆ to C₆₀ arylphosphine group, a C₆ to C₆₀ arylphosphine oxide group, and a C₆ to C₆₀ arylamine group, and when there are multiple substituents, the substituents are the same or different from each other).

2. The composition of claim 1, wherein the number of deuterium (D) atoms included in the first host is at least 13.

3. The composition of claim 1, wherein Ar₁ and Ar₂ are the same or different from each other and are each independently selected from the group consisting of Substituents S1 to S4:

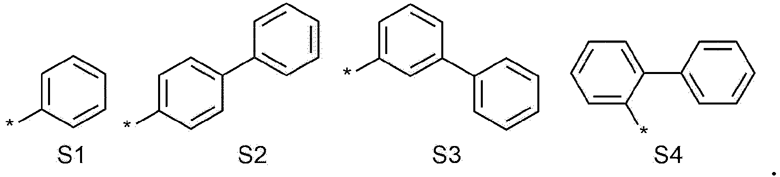

4. The composition of claim 1, wherein the first host represented by Chemical Formula 1 is a compound represented by Chemical Formula 3 below: 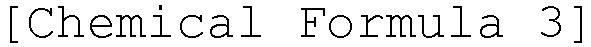 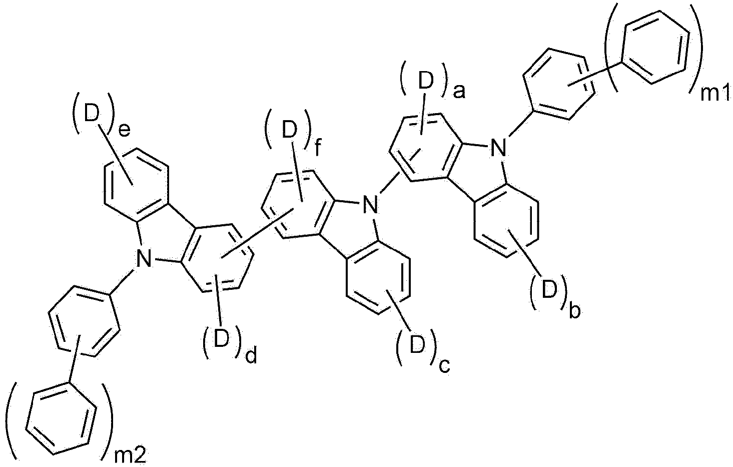 (where, in Chemical Formula 3,
a, b, c, d, e, and f are each as defined in claim 1, and
m1 and m2 are each 0 or 1).

5. The composition of claim 1, wherein the first host represented by Chemical Formula 1 is a compound represented by Chemical Formula 4 below: 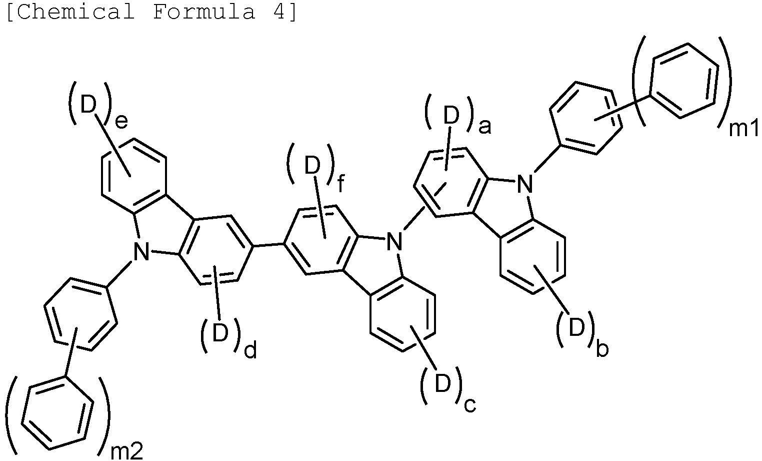 (where, in Chemical Formula 4,
a, b, c, d, e, and f are each as defined in claim 1; and
m1 and m2 are each 0 or 1).

6. The composition of claim 1, wherein the first host represented by Chemical Formula 1 is a compound represented by Chemical Formula 5 below: 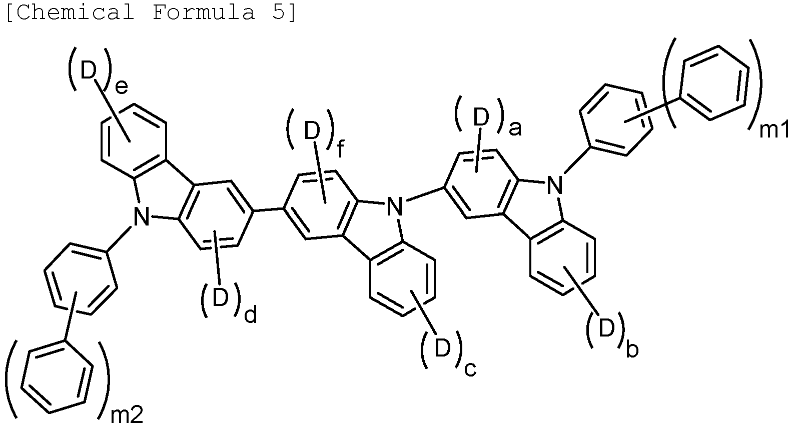 (where, in Chemical Formula 5,
a, b, c, d, e, and f are each as defined in claim 1; and
m1 and m2 are each 0 or 1).

7. The composition of claim 1, wherein the first host represented by Chemical Formula 1 is selected from the group consisting of Compounds A-1 to D-4 below:

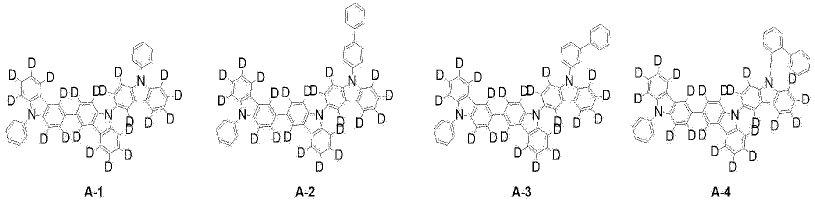

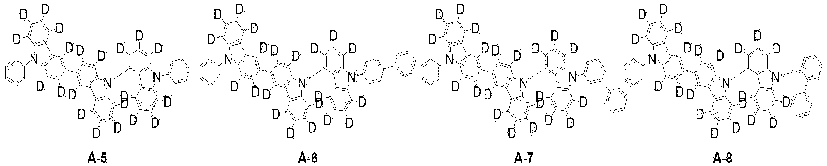

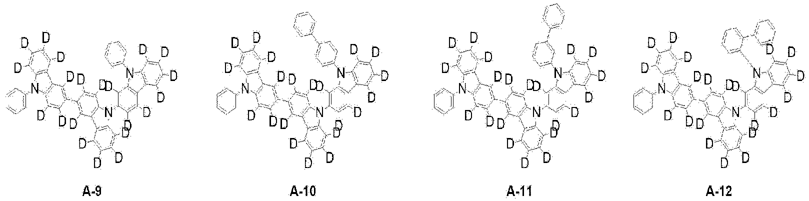

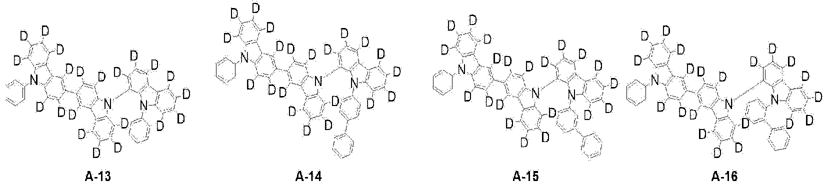

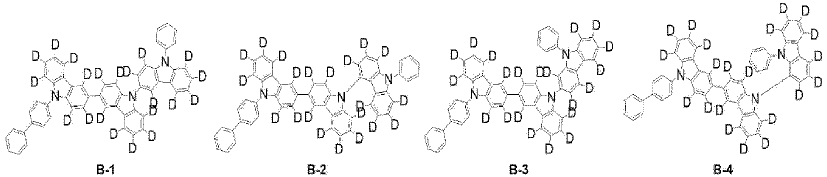

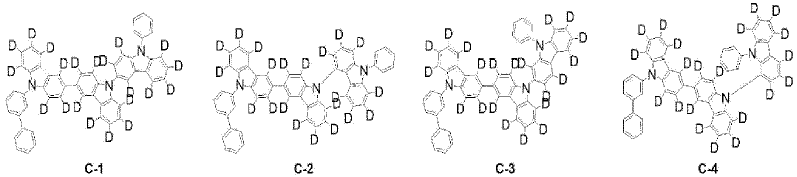

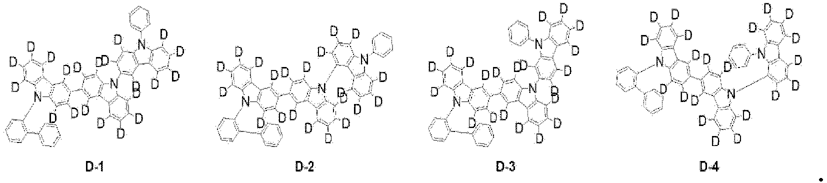

8. The composition of claim 1, wherein in the second host represented by Chemical Formula 2, the 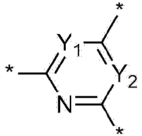 moiety is selected from the group consisting of Moieties Mo-1 to Mo-3 below: 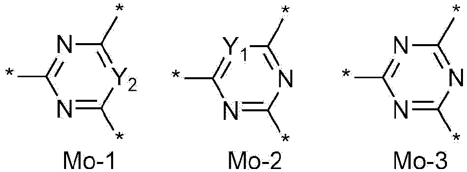 (where, in Moieties Mo-1 to Mo-3;
the mark * is a site linked to Chemical Formula 2;
Y₁ and Y₂ are each independently C(Ar₈); and
Ar₈ is as defined in claim 1).

9. The composition of claim 1, wherein in Chemical Formula 2, the 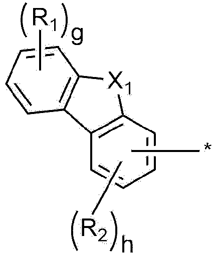 moiety is selected from the group consisting of Moieties Dz-1 to Dz-32 below: 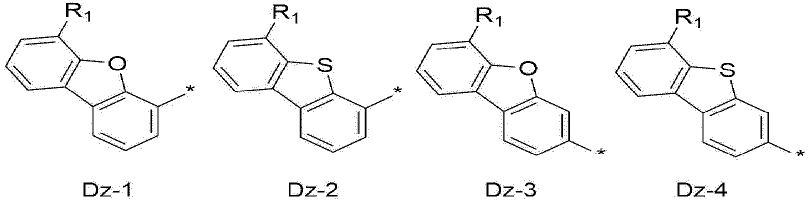 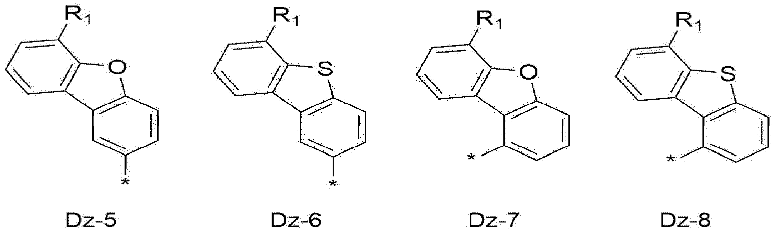 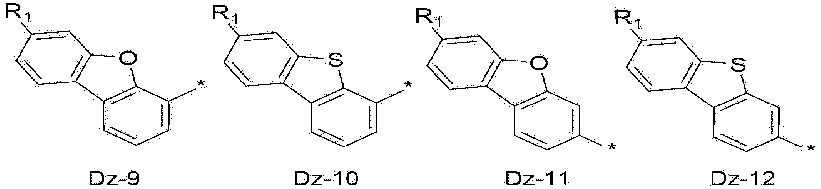 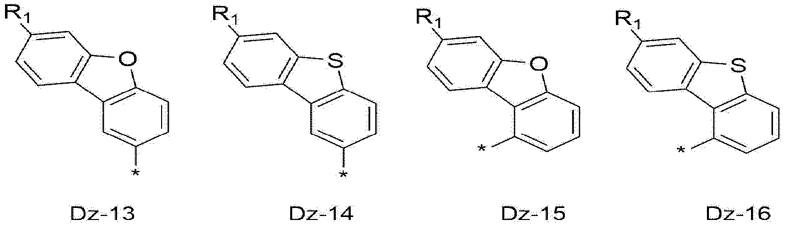 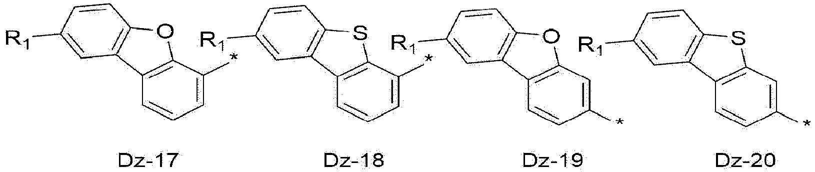 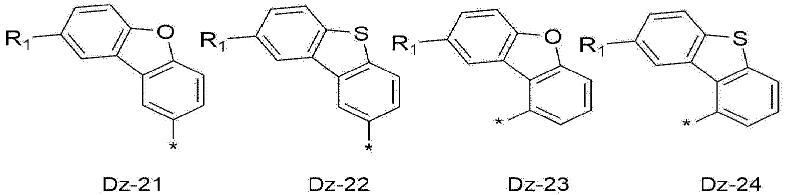 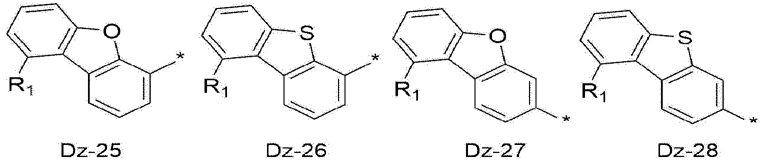 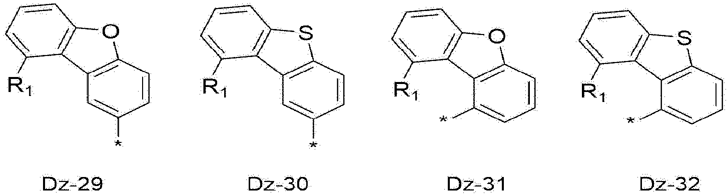 (where, in Dz-1 to Dz-32,
R₁ is a C₆ to C₆₀ aryl group).

10. The composition of claim 1, wherein the second host represented by Chemical Formula 2 is a compound represented by Chemical Formula 6 below: 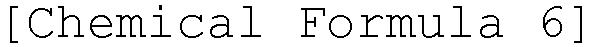 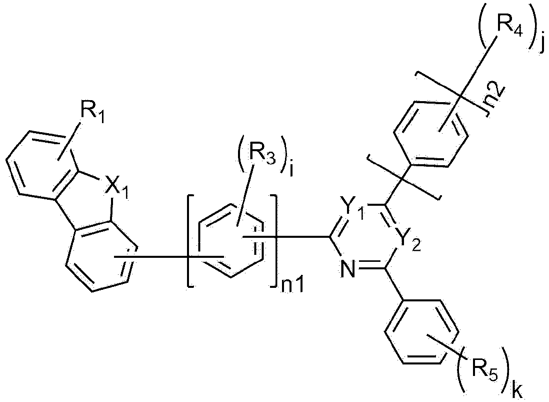 (where, in Chemical Formula 6,
i, j, k, R₁, R₃ to R₅, n1, n2, X₁, Y₁, and Y₂ are each as defined in claim 1).

11. The composition of claim 1, wherein the second host represented by Chemical Formula 2 is a compound represented by Chemical Formula 7 or 8 below: 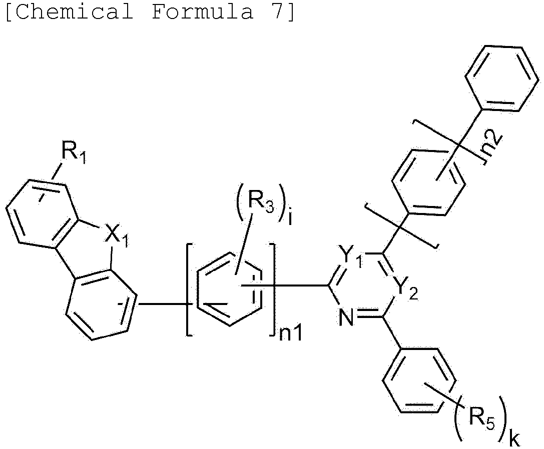 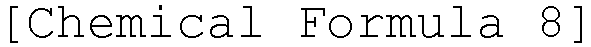 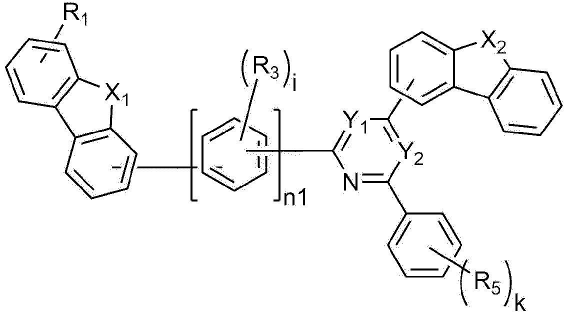 (where, in Chemical Formulas 7 and 8,
i, k, R₁, R₃, R₅, n1, n2, Y₁, and Y₂ are each independently as defined in claim 1, and
X₁ and X₂ are each O or S).

12. The composition of claim 1, wherein the second host represented by Chemical Formula 2 is a compound represented by Chemical Formula 9 or 10 below: 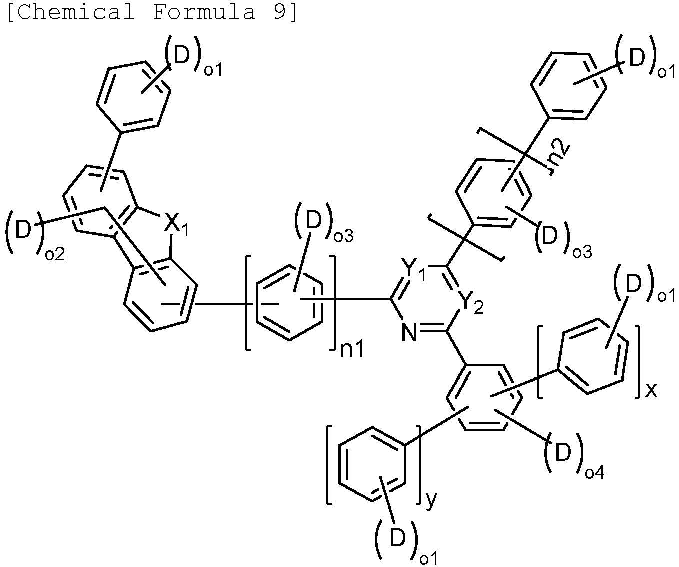 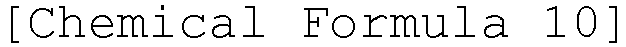 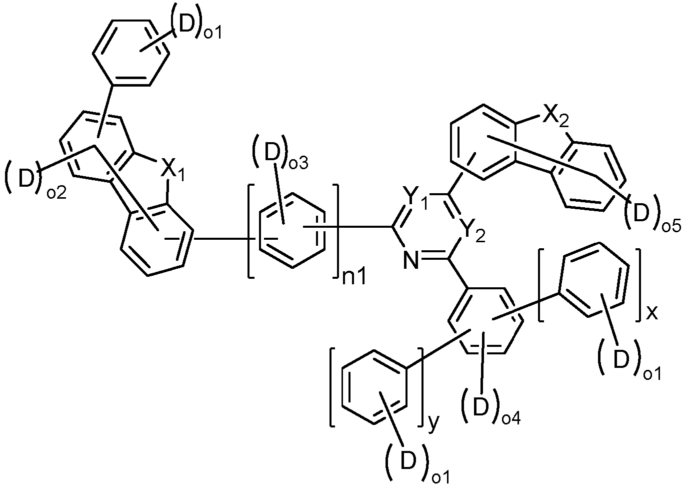 (where, in Chemical Formulas 9 and 10,
n1, n2, Y₁, and Y₂ are each as defined in claim 1;
x and y are each 0 or 1;
X₁ and X₂ are each O or S;
D is deuterium;
o1 is an integer of 0 to 5;
o2 is an integer of 0 to 6;
o3 is an integer of 0 to 4;
o4 is an integer of 0 to 3; and
o5 is an integer of 0 to 7).

13. The composition of claim 1, wherein the second host represented by Chemical Formula 2 is selected from the group consisting of Compounds E-1 to E-13 below:

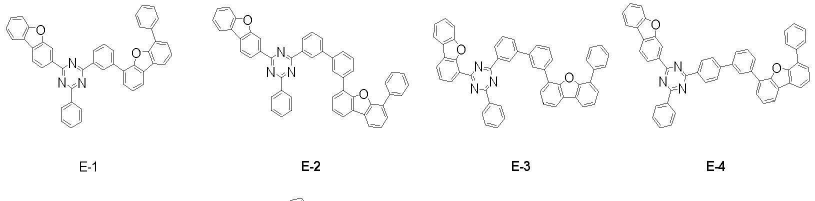

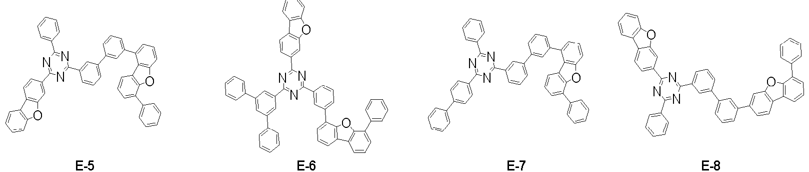

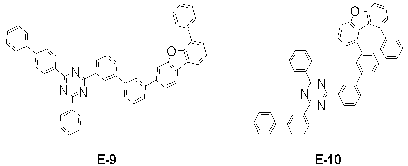

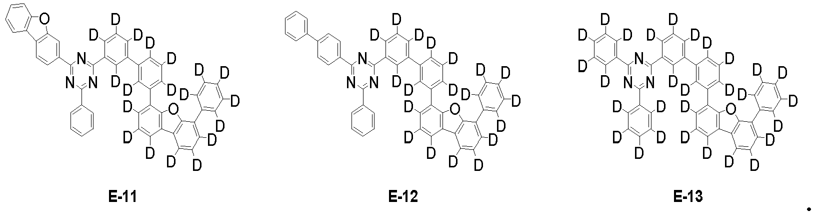

14. The composition of claim 1, wherein the first host and the second host are contained at a weight ratio of 99:1 to 1:99.

15. The composition of claim 1, further comprising a phosphorescent emissive dopant.

16. The composition of claim 15, wherein the phosphorescent emissive dopant is a metal complex compound containing iridium (Ir) or platinum (Pt).

17. An organic electroluminescent element, comprising: an anode; a cathode; and one or more organic layers interposed between the anode and the cathode,
wherein the one or more organic layers contains the compound of any one of claims 1 to 16.

18. The organic electroluminescent element of claim 17, wherein the one or more organic layers include an emissive layer; and
the composition is contained in the emissive layer.
